(19)

**Europäisches Patentamt**
**European Patent Office**
**Office européen des brevets**

(11) **EP 4 586 781 A1**

(12) **EUROPEAN PATENT APPLICATION**
published in accordance with Art. 153(4) EPC

(43) Date of publication:
16.07.2025 Bulletin 2025/29

(21) Application number: 23948827.3

(22) Date of filing: 15.08.2023

(51) International Patent Classification (IPC):
*H10K 59/121* (2023.01)

(52) Cooperative Patent Classification (CPC):
H10K 59/121

(86) International application number:
PCT/CN2023/113177

(87) International publication number:
WO 2025/035396 (20.02.2025 Gazette 2025/08)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicants:
• Boe Technology Group Co., Ltd.
Beijing 100015 (CN)
• Chengdu BOE Optoelectronics Technology Co.,
Ltd.
Chengdu, Sichuan 611731 (CN)

(72) Inventors:
• FANG, Fei
Beijing 100176 (CN)

• SHI, Ling
Beijing 100176 (CN)
• ZHAO, Zhongman
Beijing 100176 (CN)
• LI, Shuo
Beijing 100176 (CN)
• LI, Zhen
Beijing 100176 (CN)
• LI, Qian
Beijing 100176 (CN)
• ZHANG, Yuxin
Beijing 100176 (CN)

(74) Representative: Durán-Corretjer, S.L.P.
Còrsega, 329
(Paseo de Gracia/Diagonal)
08037 Barcelona (ES)

(54) **DISPLAY SUBSTRATE AND DISPLAY APPARATUS**

(57) A display substrate, comprising: a base substrate, and a plurality of first pixel circuits (11) and a plurality of first light-emitting elements (13) which are located in a first display area (A1). At least one first pixel circuit (11) is electrically connected to at least two first light-emitting elements (13). The at least one first pixel circuit (11) comprises: at least one reset transistor (T1, T7, T8). The orthographic projection of at least one first light-emitting element (13) on the base substrate at least partially overlaps with the orthographic projection of the reset transistor (T1, T7, T8) of the at least one first pixel circuit (11) on the base substrate.

FIG. 4A

EP 4 586 781 A1

**Description**

Technical Field

The present disclosure relates to, but is not limited to, the field of display technologies, in particular to a display substrate and a display apparatus.

Background

An Organic Light Emitting Diode (OLED) and a Quantum dot Light Emitting Diode (QLED) are active light emitting display devices and have advantages of self-illumination, a wide viewing angle, a high contrast ratio, low power consumption, an extremely high reaction speed, lightness and thinness, bendability, and a low cost, etc.

Summary

The following is a summary of subject matters described herein in detail. The summary is not intended to limit the protection scope of claims.

Embodiments of the present disclosure provide a display substrate and a display apparatus.

In one aspect, an embodiment provides a display substrate including a base substrate, and multiple first pixel circuits and multiple first light emitting elements located in a first display region. At least one first pixel circuit is electrically connected with at least two first light emitting elements. At least one first pixel circuit includes at least one reset transistor. An orthographic projection of at least one first light emitting element on the base substrate is at least partially overlapped with an orthographic projection of a reset transistor of the at least one first pixel circuit on the base substrate.

In some exemplary implementation modes, the multiple first light emitting elements include: multiple first light emitting elements emitting light of different colors. Orthographic projections of multiple first light emitting elements emitting light of a same color on the base substrate are at least partially overlapped with orthographic projections of reset transistors of multiple first pixel circuits on the base substrate.

In some exemplary implementation modes, an orthographic projection of an anode of the at least one first light emitting element on the base substrate contains an orthographic projection of an active layer of the at least one reset transistor on the base substrate.

In some exemplary implementation modes, the at least one first pixel circuit includes: a first reset transistor and a second reset transistor; an orthographic projection of the first reset transistor of the at least one first pixel circuit on the base substrate is at least partially overlapped with an orthographic projection of one first light emitting element on the base substrate, and an orthographic projection of the second reset transistor of the at least one first pixel circuit on the base substrate is at least partially overlapped with an orthographic projection of another first light emitting element emitting light of a same color on the base substrate.

In some exemplary implementation modes, an orthographic projection of a first light emitting element overlapped with the second reset transistor on the base substrate is not overlapped with an orthographic projection of a first pixel circuit connected with the first light emitting element on the base substrate.

In some exemplary implementation modes, the multiple first light emitting elements are divided into multiple light emitting units, each of which includes: a first light emitting element emitting light of a first color, a first light emitting element emitting light of a second color, and two first light emitting elements emitting light of a third color; the first light emitting element emitting light of the first color is electrically connected with a first pixel circuit; the first light emitting element emitting light of the second color is electrically connected with a first pixel circuit; and the two first light emitting elements emitting light of the third color are electrically connected with a same first pixel circuit.

In some exemplary implementation modes, the first light emitting element emitting light of the first color and the first light emitting element emitting light of the second color in the light emitting unit are arranged in a same row, the two first light emitting elements emitting light of the third color are arranged in a same row, and four first light emitting elements in the light emitting unit are arranged in different columns; and the light of the first color is red light, the light of the second color is blue light, and the light of the third color is green light.

In some exemplary implementation modes, the first display region includes: multiple circuit island regions spaced apart from each other and arranged in an array, each circuit island region includes: three first pixel circuits disposed in sequence along a first direction; two adjacent rows of circuit island regions are dislocated; and three first pixel circuits of the circuit island region are electrically connected with four first light emitting elements in a light emitting unit.

In some exemplary implementation modes, any two adjacent first pixel circuits in the circuit island region are symmetrically disposed with respect to a centerline of the two adjacent first pixel circuits along the first direction.

In some exemplary implementation modes, a data line connected with a first pixel circuit connected with a first light emitting element emitting light of the third color is configured to provide data signals to multiple first pixel circuits disposed every other row.

In some exemplary implementation modes, the first pixel circuit connected with the two first light emitting elements emitting light of the third color in the light emitting unit is located between the first pixel circuit connected with the first light emitting element emitting light of the first color and the first pixel circuit connected with the first light emitting element emitting light of the second color.

In some exemplary implementation modes, each first pixel circuit of the circuit island region includes: a drive transistor, a first reset transistor, a second reset transistor, and a third reset transistor, wherein the first reset transistor is configured to reset a second electrode of the drive transistor, the second reset transistor is configured to reset an anode of a first light emitting element connected with the first pixel circuit, and the third reset transistor is configured to reset a first electrode of the drive transistor. Active layers of first reset transistors of three first pixel circuits of the circuit island region are of an interconnected integrated structure, active layers of second reset transistors of the three first pixel circuits are of an interconnected integrated structure, and active layers of third reset transistors of the three first pixel circuits are of an interconnected integrated structure.

In some exemplary implementation modes, orthographic projections of the integrated structure of the active layers of the first reset transistors of the three first pixel circuits, the integrated structure of the active layers of the second reset transistors of the three first pixel circuits, and the integrated structure of the active layers of the third reset transistors of the three first pixel circuits of the circuit island region on the base substrate are at least partially overlapped with orthographic projections of different first light emitting elements emitting light of the third color on the base substrate.

In some exemplary implementation modes, orthographic projections of an integrated structure of active layers of three second reset transistors of one circuit island region and an integrated structure of active layers of three first reset transistors of an adjacent circuit island region in a second direction on the base substrate are at least partially overlapped with an orthographic projection of a same first light emitting element emitting light of the third color on the base substrate; the first light emitting element emitting light of the third color is connected with a first pixel circuit of the circuit island region and orthographic projections of the first light emitting element emitting light of the third color and a transistor of the first pixel circuit other than the second reset transistor on the base substrate are not overlapped; the second direction intersects with the first direction.

In some exemplary implementation modes, each first pixel circuit of the circuit island region at least includes: a drive transistor, a first reset transistor, and a second reset transistor, wherein the first reset transistor is configured to reset a second electrode of the drive transistor, and the second reset transistor is configured to reset an anode of a first light emitting element connected with the first pixel circuit; an active layer of a first reset transistor and an active layer of a second reset transistor of a third first pixel circuit along the first direction within the circuit island region are aligned in a second direction, wherein the second direction intersects with the first direction; an orthographic projection of the active layer of the first reset transistor of the third first pixel circuit on the base substrate is at least partially overlapped with an orthographic projection of one first light emitting element emitting light of the third color on the base substrate, and an orthographic projection of the active layer of the second reset transistor of the third first pixel circuit on the base substrate is at least partially overlapped with an orthographic projection of the other first light emitting element emitting light of the third color on the base substrate.

In some exemplary implementation modes, an orthographic projection of an anode of the one first light emitting element emitting light of the third color on the base substrate contains an orthographic projection of the active layer of the first reset transistor of the third first pixel circuit on the base substrate, and an orthographic projection of an anode of the other first light emitting element emitting light of the third color on the base substrate contains an orthographic projection of the active layer of the second reset transistor of the third first pixel circuit on the base substrate.

In some exemplary implementation modes, in a direction perpendicular to the display substrate, the display substrate includes: a first semiconductor layer, a first conductive layer, a second conductive layer, a second semiconductor layer, a third conductive layer, a fourth conductive layer, a fifth conductive layer, and a sixth conductive layer disposed on the base substrate; the sixth conductive layer at least includes multiple auxiliary electrodes; and orthographic projections of the auxiliary electrodes on the base substrate contain an orthographic projection of a light emitting region of the first light emitting element on the base substrate.

In some exemplary implementation modes, the multiple auxiliary electrodes are connected through multiple auxiliary connection strips to form a mesh structure, and the mesh structure is connected with a first voltage signal.

In another aspect, an embodiment provides a display apparatus, including the display substrate described above, and a sensor located on a non-display side of the display substrate, and an orthographic projection of the sensor on the display substrate is at least partially overlapped with a first display region of the display substrate.

In another aspect, an embodiment provides a display substrate including a base substrate, and multiple first pixel circuits and multiple first light emitting elements located in a first display region. At least one first pixel circuit among the multiple first pixel circuits is electrically connected with a first light emitting element, and at least one first pixel circuit is electrically connected with at least two first light emitting elements; the first pixel circuit includes at least one reset transistor; and orthographic projections of at least two first light emitting elements electrically connected with a same first pixel circuit on the base substrate are at least partially overlapped with orthographic projections of reset transistors of the multiple first pixel circuits on the base substrate.

In some exemplary implementation modes, an orthographic projection of an anode of each of the at least two first light emitting elements electrically connected with the same first pixel circuit on the base substrate contains an orthographic projection of an active layer of at least one reset transistor on the base substrate.

In some exemplary implementation modes, the first pixel circuit includes: a first reset transistor and a second reset transistor; an orthographic projection of one of two first light emitting elements electrically connected with a same first pixel circuit on the base substrate is at least partially overlapped with an orthographic projection of the first reset transistor on the base substrate; and an orthographic projection of the other one of the at least two first light emitting elements on the base substrate is at least partially overlapped with an orthographic projection of the second reset transistor on the base substrate.

In some exemplary implementation modes, an orthographic projection of a first light emitting element overlapped with the second reset transistor on the base substrate is not overlapped with an orthographic projection of a first pixel circuit connected with the first light emitting element on the base substrate.

Other aspects may be comprehended after drawings and detailed description are read and understood.

Brief Description of Drawings

Accompanying drawings are used for providing an understanding for technical solutions of the present application and constitute a part of the specification, are used for explaining the technical solutions of the present application together with the embodiments of the present application, and do not constitute limitations on the technical solutions of the present application.

FIG. 1 is a schematic diagram of a display substrate according to at least one embodiment of the present disclosure.

FIG. 2 is an equivalent circuit diagram of a pixel circuit according to at least one embodiment of the present disclosure.

FIG. 3 is a working timing diagram of the pixel circuit provided in FIG. 2.

FIG. 4A and FIG. 4B are partial schematic diagrams of a first display region according to at least one embodiment of the present disclosure.

FIG. 5 is a schematic diagram of a circuit arrangement of a first display region according to at least one embodiment of the present disclosure.

FIG. 6 is a partial top view of a first display region according to at least one embodiment of the present disclosure.

FIG. 7A is a schematic diagram of a first display region after a first semiconductor layer is formed in FIG. 6.

FIG. 7B is a schematic diagram of a circuit island region in FIG. 7A.

FIG. 8A is a schematic diagram of a first display region after a first conductive layer is formed in FIG. 6.

FIG. 8B is a schematic diagram of a first conductive layer in FIG. 8A.

FIG. 8C is a schematic diagram of a circuit island region in FIG. 8A.

FIG. 9A is a schematic diagram of a first display region after a second conductive layer is formed in FIG. 6.

FIG. 9B is a schematic diagram of a second conductive layer in FIG. 9A.

FIG. 9C is a schematic diagram of a circuit island region in FIG. 9A.

FIG. 10A is a schematic diagram of a first display region after a second semiconductor layer is formed in FIG. 6.

FIG. 10B is a schematic diagram of a circuit island region in FIG. 10A.

FIG. 11A is a schematic diagram of a first display region after a third conductive layer is formed in FIG. 6.

FIG. 11B is a schematic diagram of a third conductive layer in FIG. 11A.

FIG. 11C is a schematic diagram of a circuit island region in FIG. 11A.

FIG. 12 is a schematic diagram of a circuit island region after a fifth insulation layer is formed in FIG. 6.

FIG. 13A is a schematic diagram of a first display region after a fourth conductive layer is formed in FIG. 6.

FIG. 13B is a schematic diagram of a fourth conductive layer in FIG. 13A.

FIG. 13C is a schematic diagram of a circuit island region in FIG. 13A.

FIG. 14 is a schematic diagram of a circuit island region after a seventh insulation layer is formed in FIG. 6.

FIG. 15A is a schematic diagram of a first display region after a fifth conductive layer is formed in FIG. 6.

FIG. 15B is a schematic diagram of a fifth conductive layer in FIG. 15A.

FIG. 15C is a schematic diagram of a circuit island region in FIG. 15A.

FIG. 16 is a schematic diagram of a circuit island region after an eighth insulation layer is formed in FIG. 6.

FIG. 17A is a schematic diagram of a first display region after a sixth conductive layer is formed in FIG. 6.

FIG. 17B is a schematic diagram of a sixth conductive layer in FIG. 17A.

FIG. 18 is a schematic diagram of a first display region after a tenth insulation layer is formed in FIG. 6.

FIG. 19A is a schematic diagram of a first display region after an anode layer is formed in FIG. 6.

FIG. 19B is a schematic diagram of the anode layer in FIG. 19A.

FIG. 20 is a schematic diagram of lamination of a first semiconductor layer, a sixth conductive layer, and an anode layer in FIG. 6.

FIG. 21 is another partial top view of a circuit structure layer of a first display region according to at least one embodiment of the present disclosure.

FIG. 22A is a schematic diagram of a first display region after a first semiconductor layer is formed in FIG. 21.

FIG. 22B is a schematic diagram of a circuit island region in FIG. 22A.

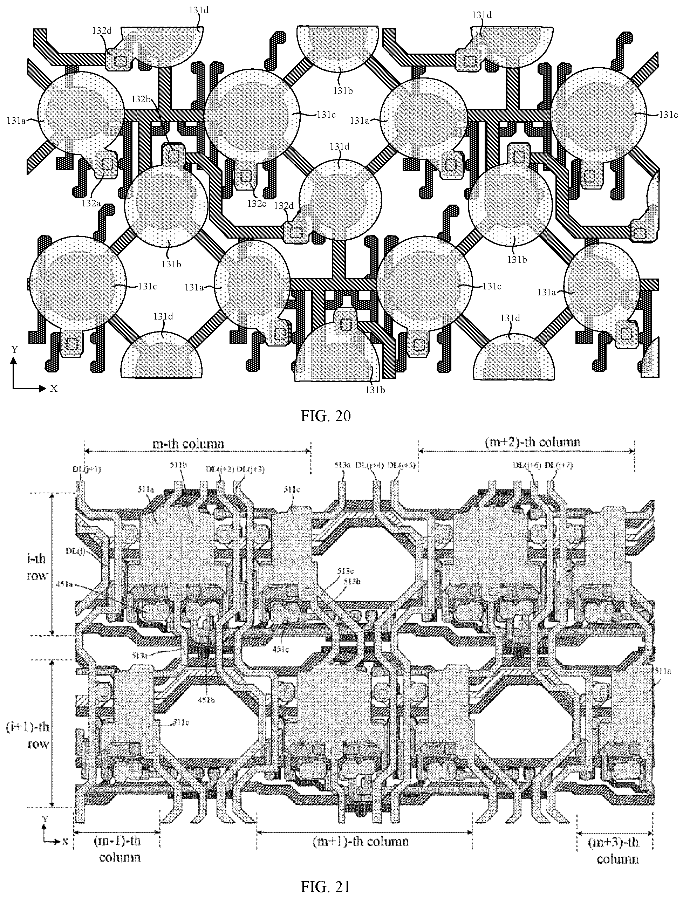

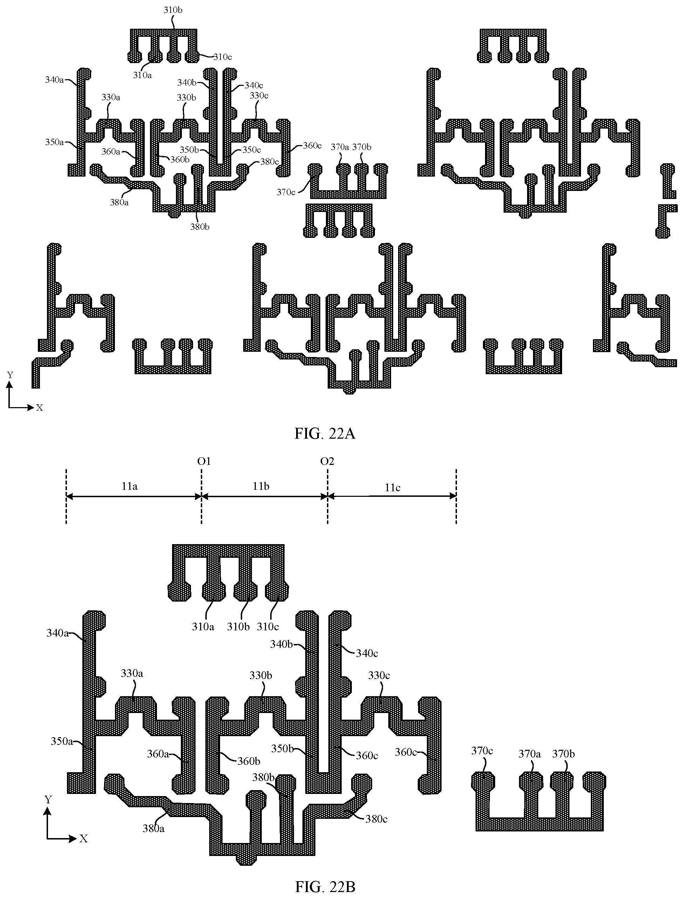

FIG. 22A is a schematic diagram of a first display region after a first semiconductor layer is formed in FIG. 21.

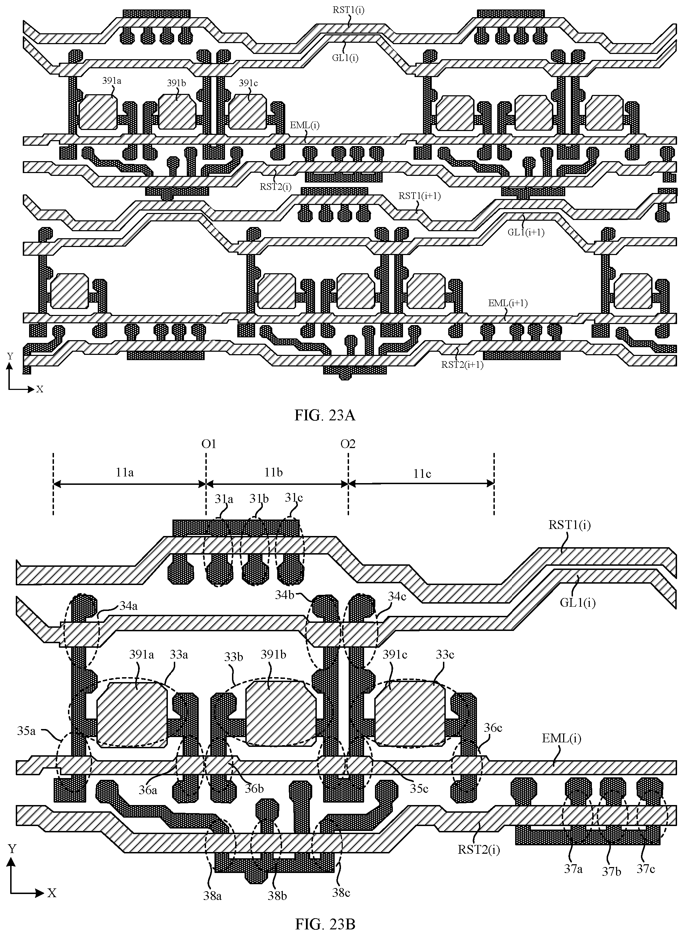

FIG. 23B is a schematic diagram of a circuit island region in FIG. 23A.

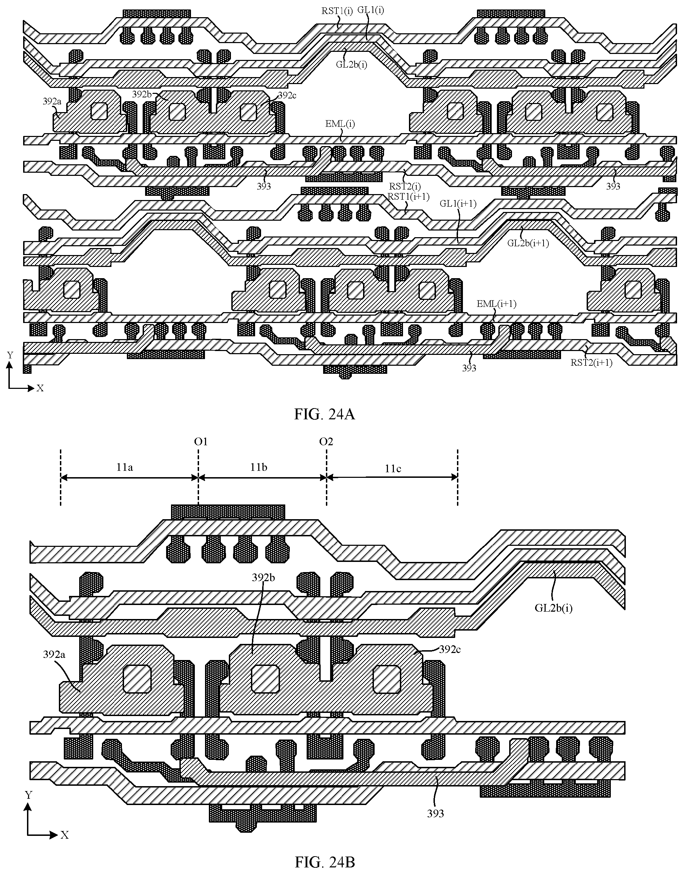

FIG. 24A is a schematic diagram of a first display region after a second conductive layer is formed in FIG. 21.

FIG. 24B is a schematic diagram of a circuit island region in FIG. 24A.

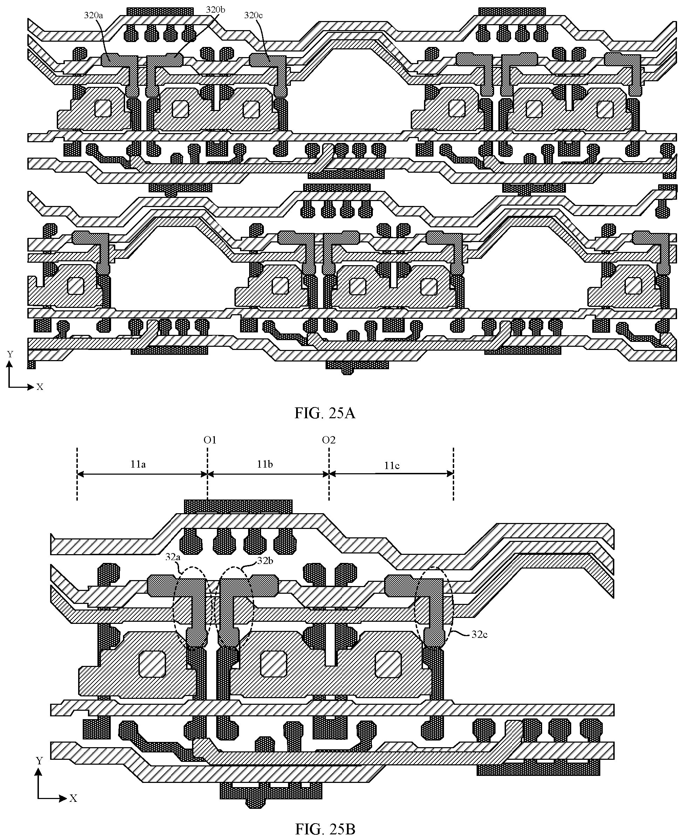

FIG. 25A is a schematic diagram of a first display region after a second semiconductor layer is formed in FIG. 21.

FIG. 25B is a schematic diagram of a circuit island region in FIG. 25A.

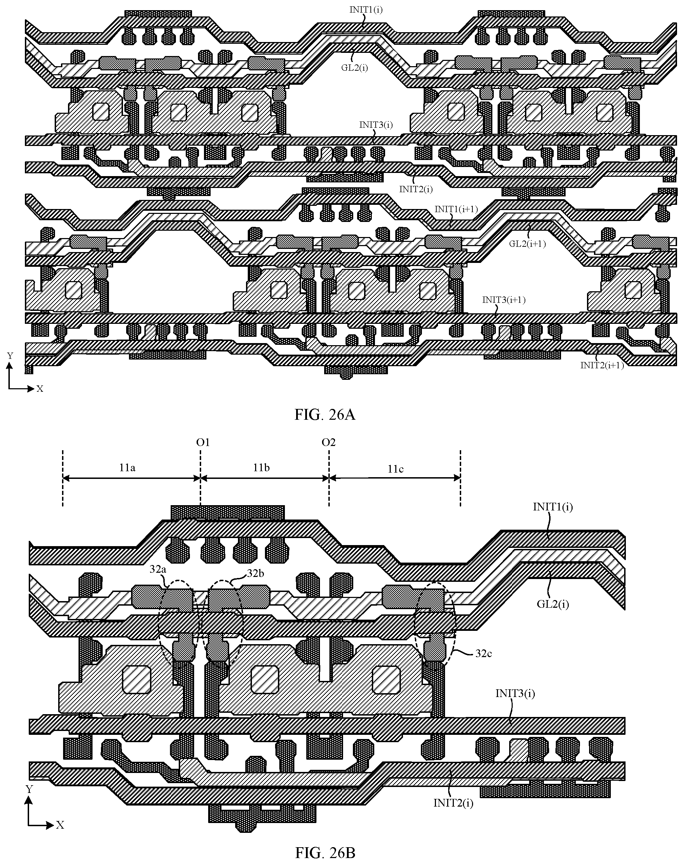

FIG. 26A is a schematic diagram of a first display region after a third conductive layer is formed in FIG. 21.

FIG. 26B is a schematic diagram of a circuit island region in FIG. 26A.

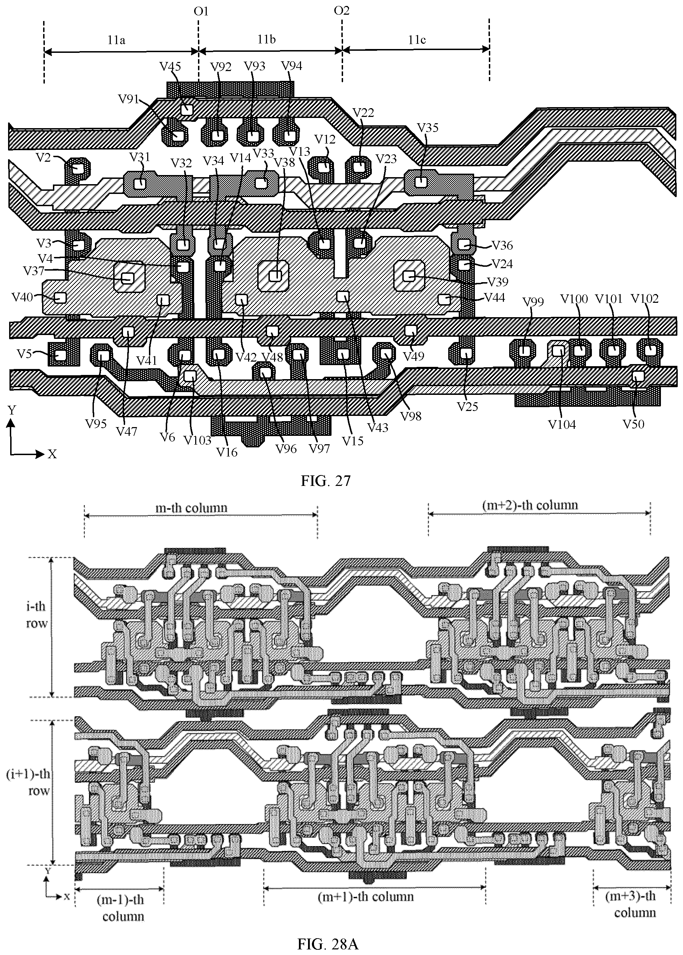

FIG. 27 is a schematic diagram of a circuit island region after a fifth insulation layer is formed in FIG. 21.

FIG. 28A is a schematic diagram of a first display region after a fourth conductive layer is formed in FIG. 21.

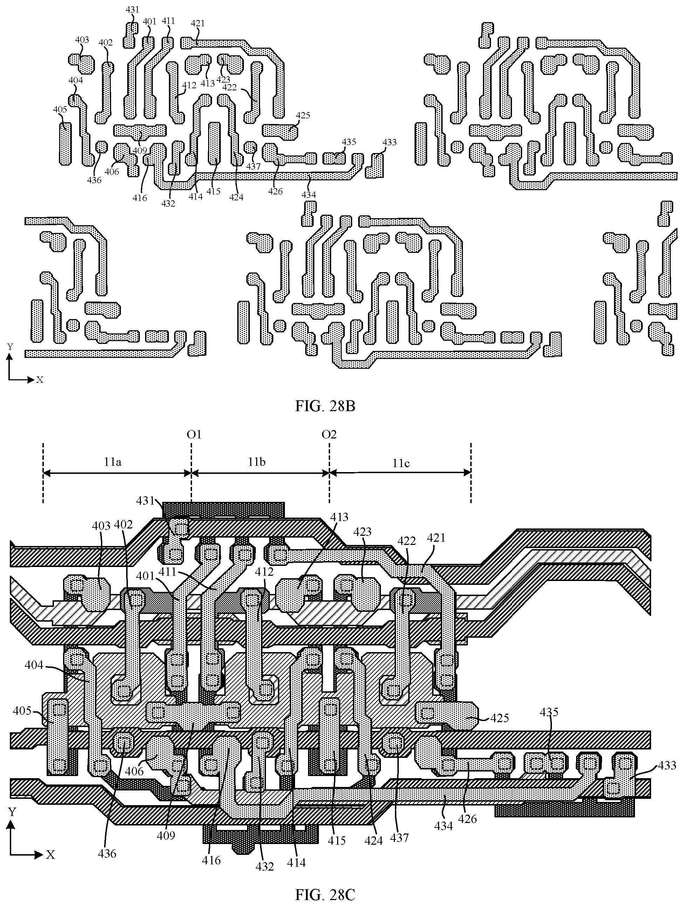

FIG. 28B is a schematic diagram of a fourth conductive layer in FIG. 28A.

FIG. 28C is a schematic diagram of a circuit island region in FIG. 28A.

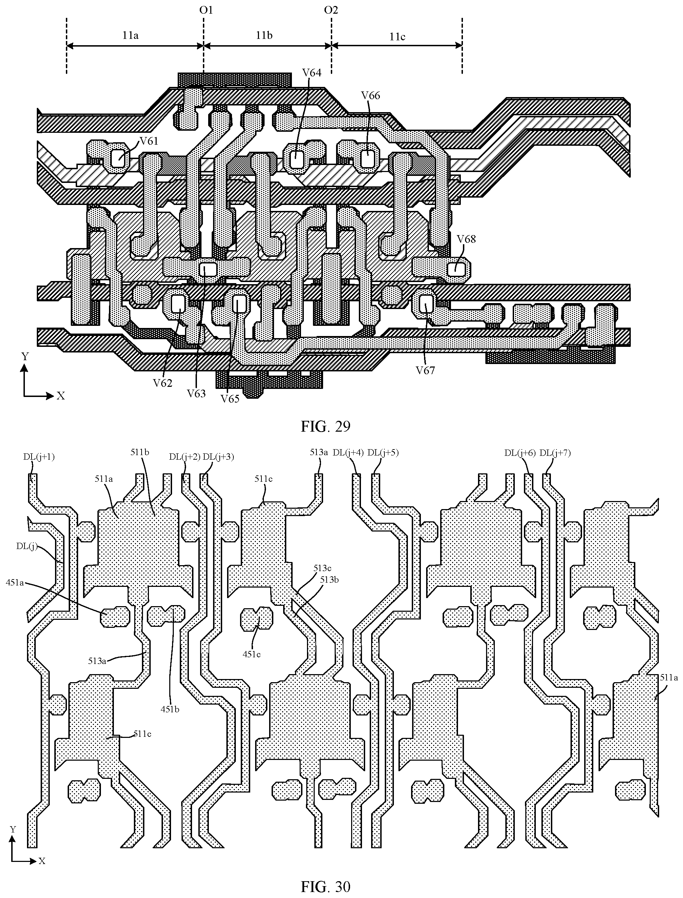

FIG. 29 is a schematic diagram of a circuit island region after a seventh insulation layer is formed in FIG. 21.

FIG. 30 is a schematic diagram of a fifth conductive layer in FIG. 21.

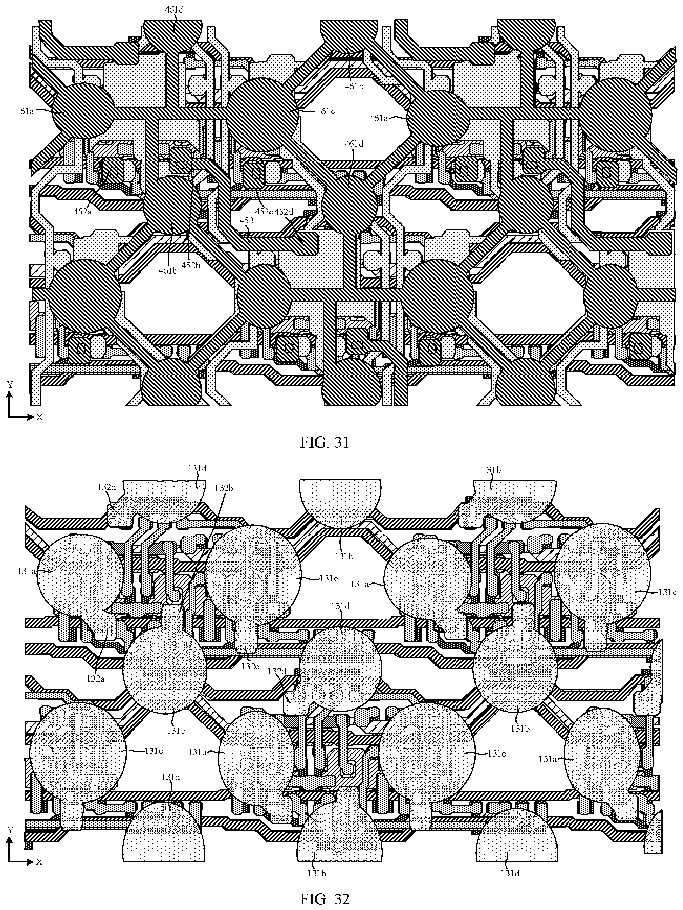

FIG. 31 is a schematic diagram of a first display region after a sixth conductive layer is formed on a side of a fifth conductive layer of FIG. 21 away from a base substrate.

FIG. 32 is a schematic diagram of a positional relationship between a first pixel circuit of a circuit structure layer and an anode layer of a light emitting structure layer shown in FIG. 21.

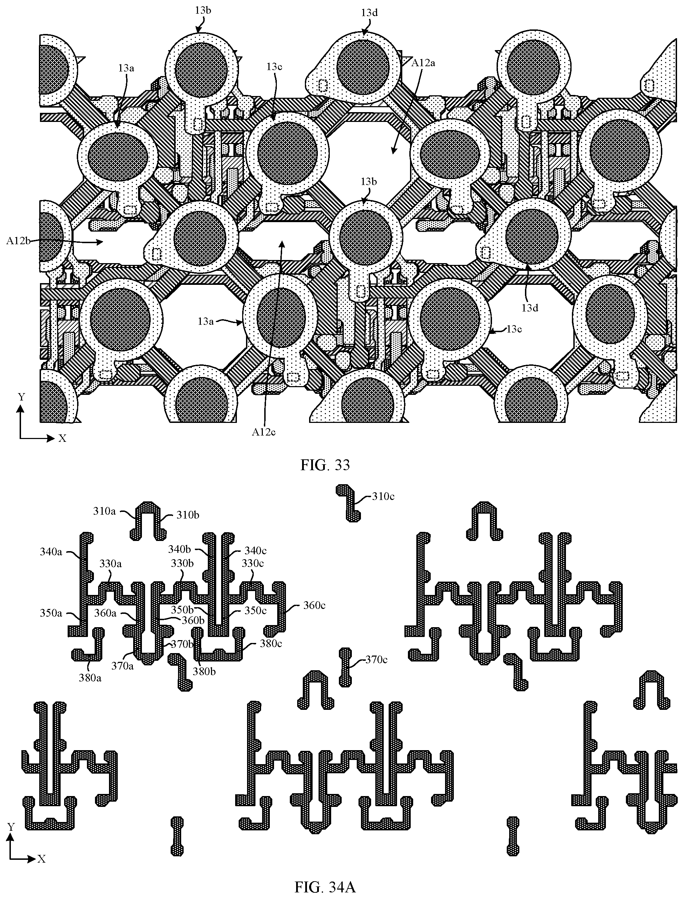

FIG. 33 is another partial top view of a first display region according to at least one embodiment of the present disclosure.

FIG. 34A is a schematic diagram of a first display region after a first semiconductor layer is formed in FIG. 33.

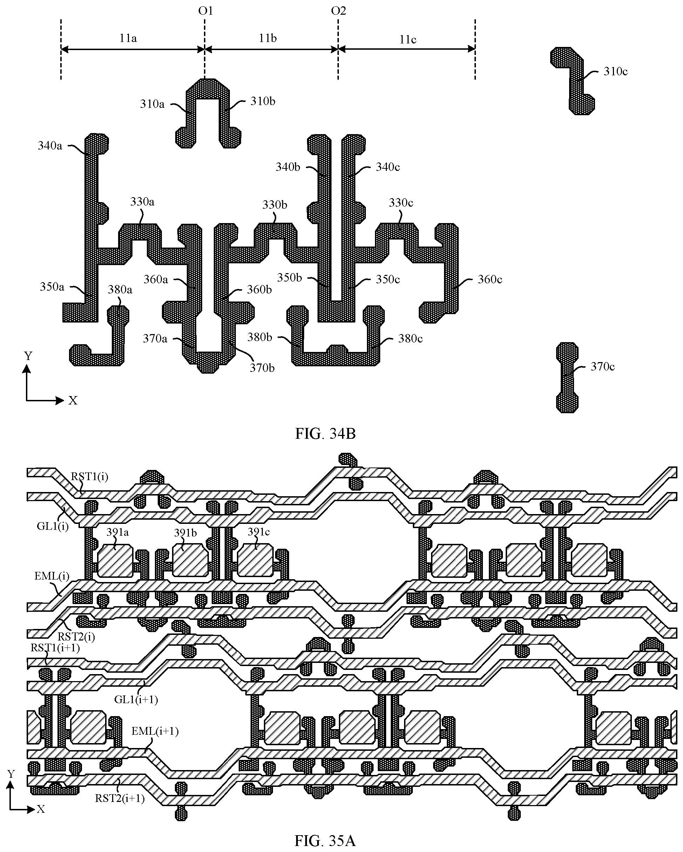

FIG. 34B is a schematic diagram of a circuit island region in FIG. 34A.

FIG. 35A is a schematic diagram of a first display region after a first conductive layer is formed in FIG. 33.

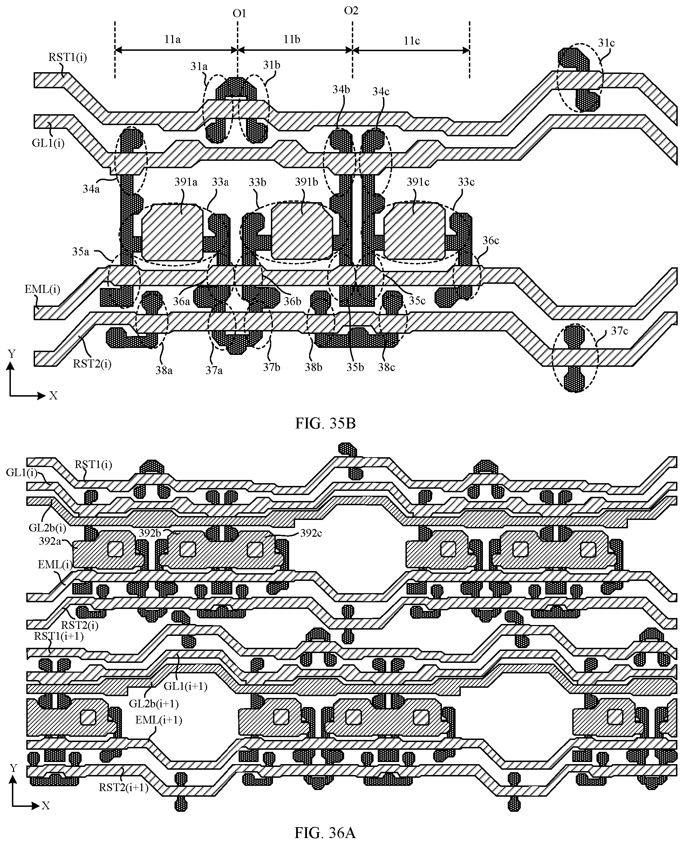

FIG. 35B is a schematic diagram of a circuit island region in FIG. 35A.

FIG. 36A is a schematic diagram of a first display region after a second conductive layer is formed in FIG. 33.

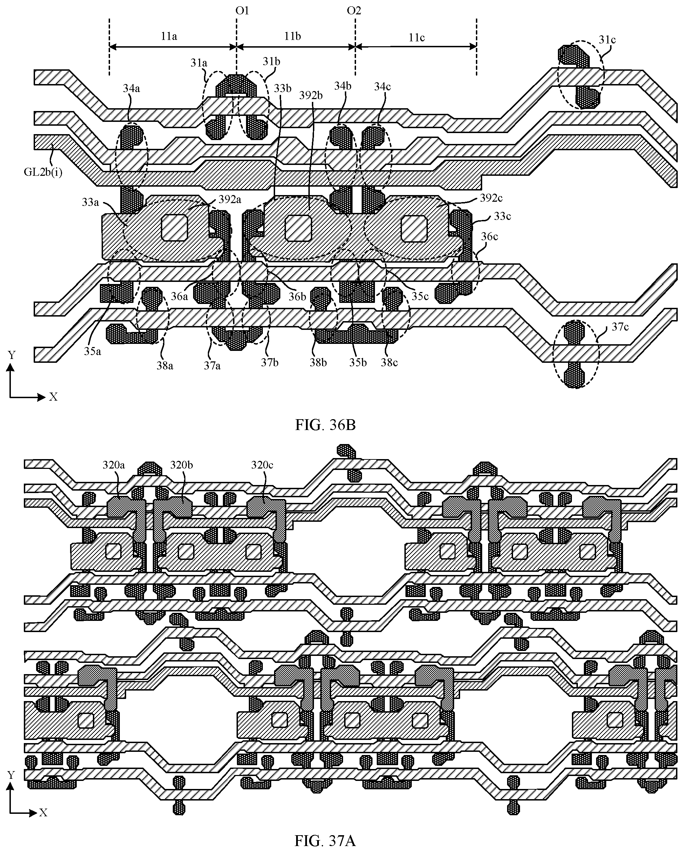

FIG. 36B is a schematic diagram of a circuit island region in FIG. 36A.

FIG. 37A is a schematic diagram of a first display region after a second semiconductor layer is formed in FIG. 33.

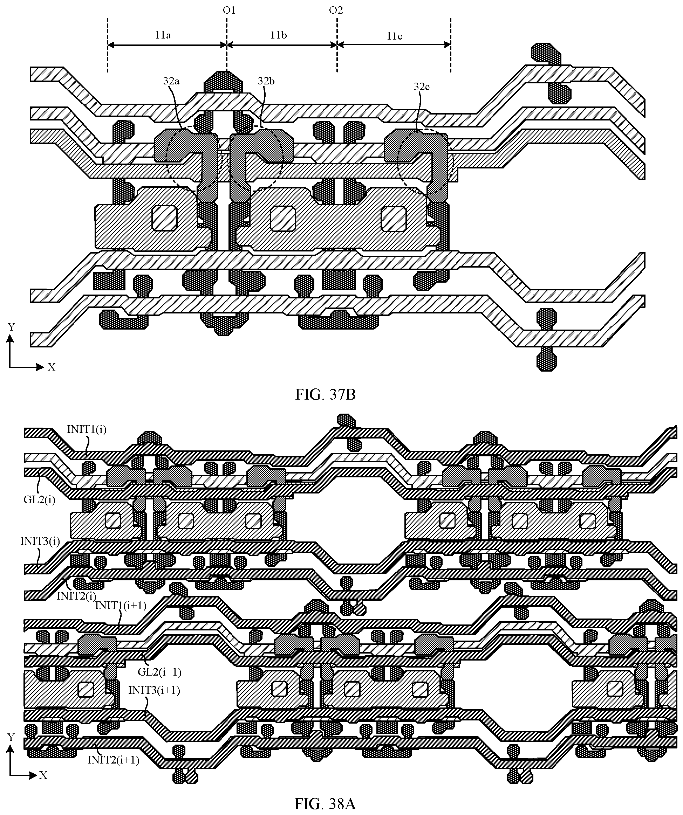

FIG. 37B is a schematic diagram of a circuit island region in FIG. 37A.

FIG. 38A is a schematic diagram of a first display region after a third conductive layer is formed in FIG. 33.

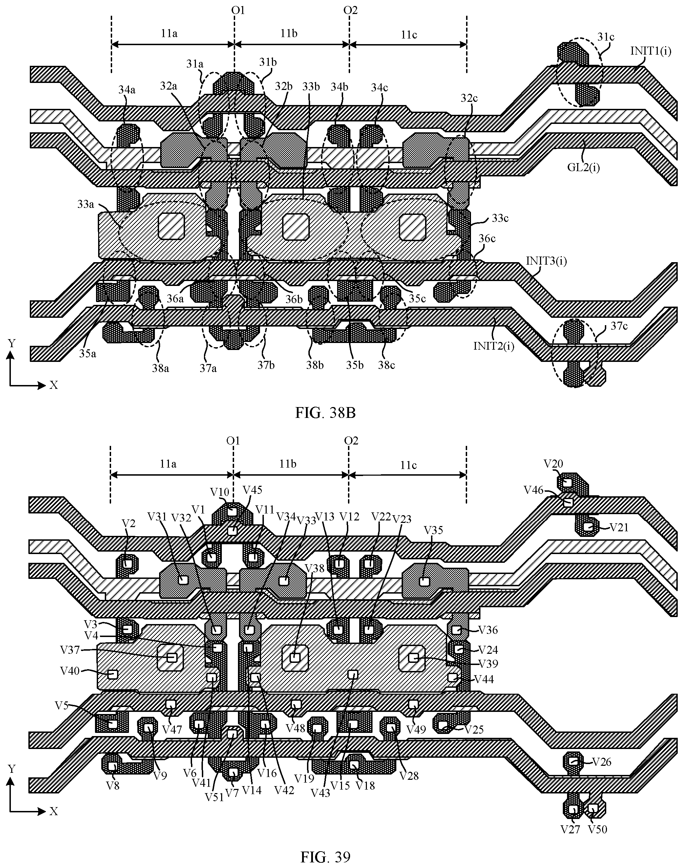

FIG. 38B is a schematic diagram of a circuit island region in FIG. 38A.

FIG. 39 is a schematic diagram of a circuit island region after a fifth insulation layer is formed in FIG. 33.

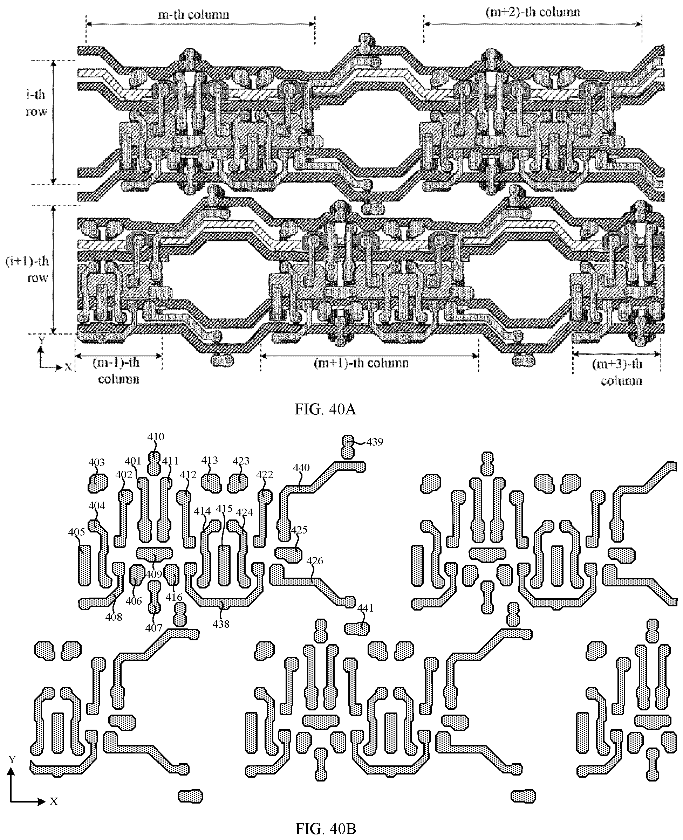

FIG. 40A is a schematic diagram of a first display region after a fourth conductive layer is formed in FIG. 33.

FIG. 40B is a schematic diagram of a fourth conductive layer in FIG. 40A.

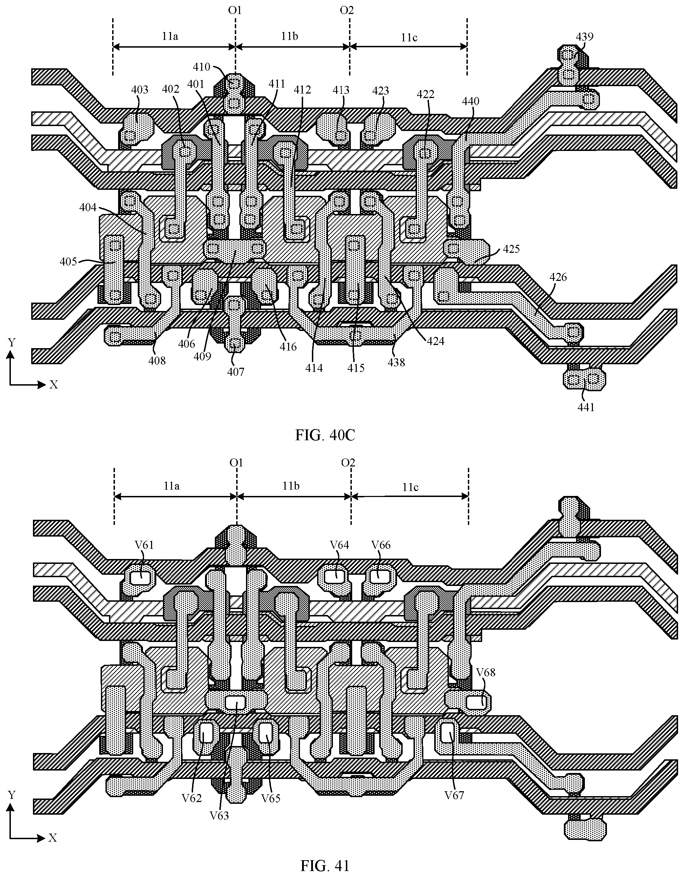

FIG. 40C is a schematic diagram of a circuit island region in FIG. 40A.

FIG. 41 is a schematic diagram of a circuit island region after a seventh insulation layer is formed in FIG. 33.

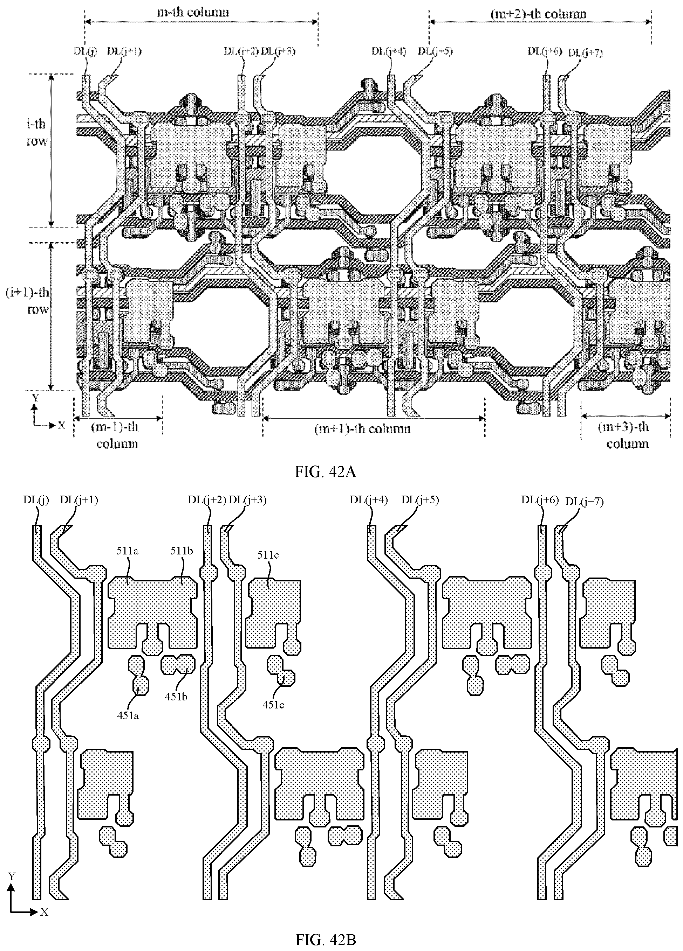

FIG. 42A is a schematic diagram of a first display region after a fifth conductive layer is formed in FIG. 33.

FIG. 42B is a schematic diagram of a fifth conductive layer in FIG. 42A.

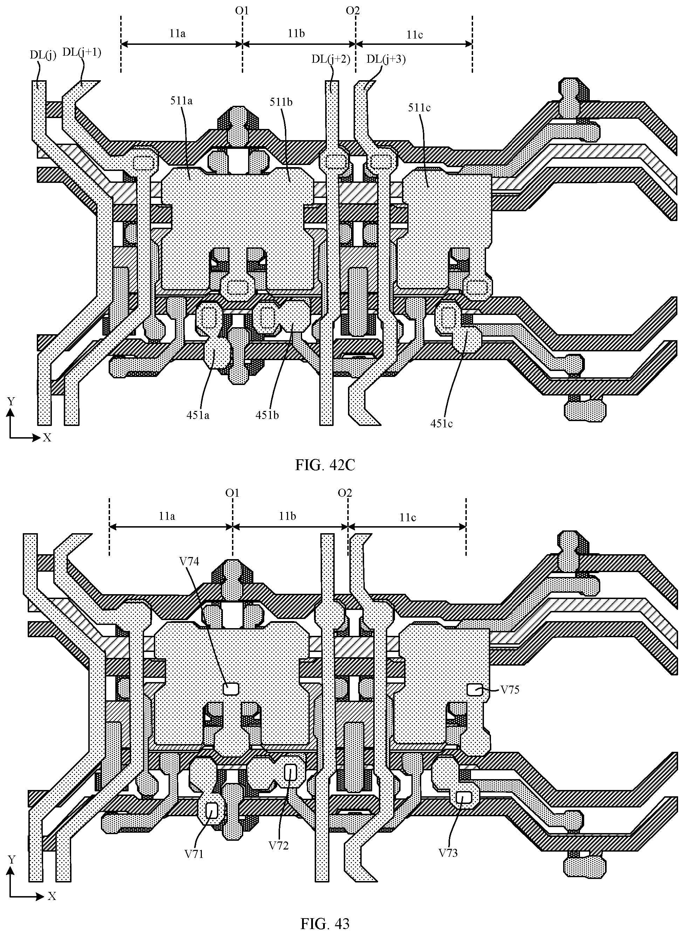

FIG. 42C is a schematic diagram of a circuit island region in FIG. 42A.

FIG. 43 is a schematic diagram of a circuit island region after an eighth insulation layer is formed in FIG. 33.

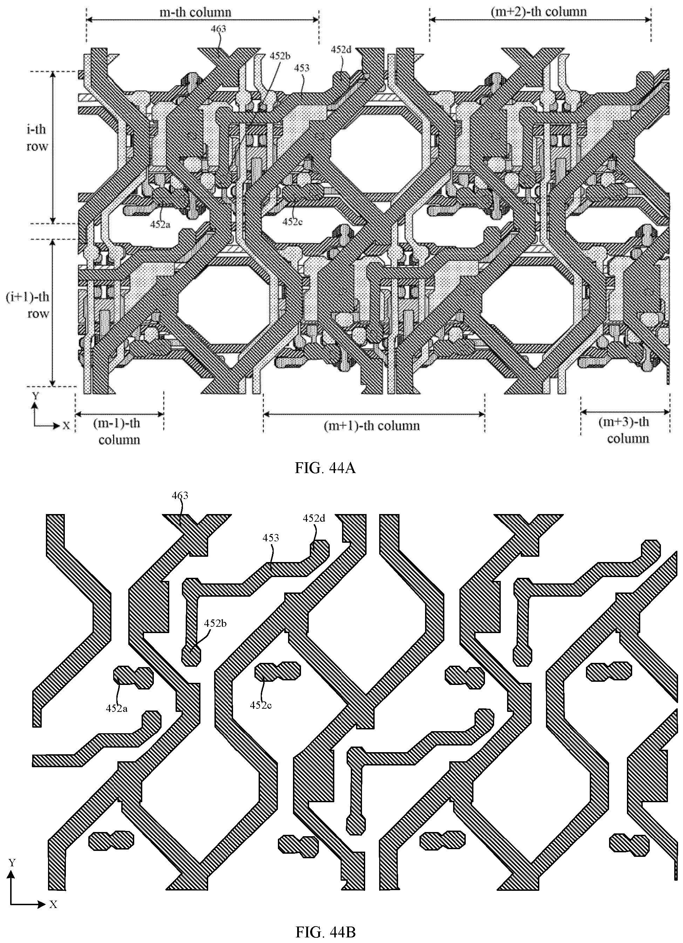

FIG. 44A is a schematic diagram of a first display region after a sixth conductive layer is formed in FIG. 33.

FIG. 44B is a schematic diagram of a sixth conductive layer in FIG. 44A.

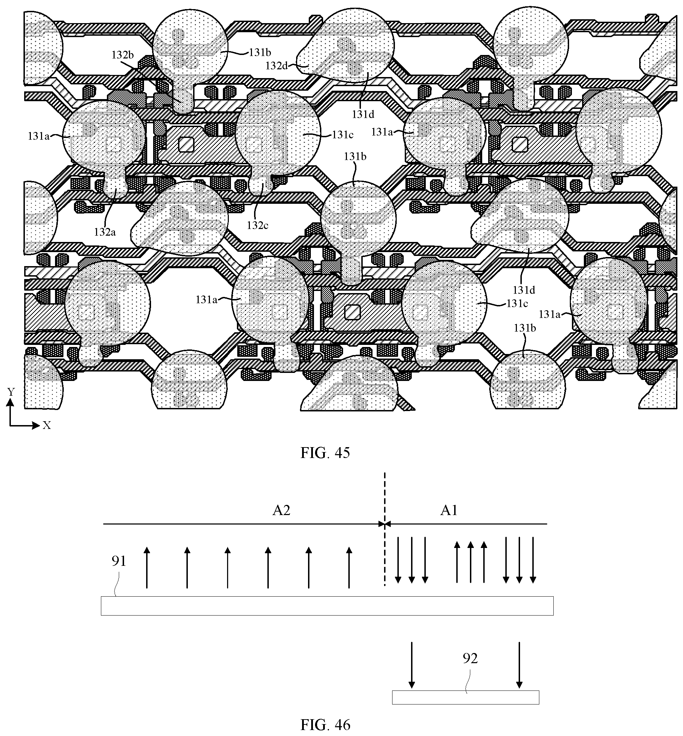

FIG. 45 is a schematic diagram of lamination of a first semiconductor layer, a first conductive layer, a second conductive layer, a second semiconductor layer, a third conductive layer, and an anode layer in FIG. 33.

FIG. 46 is a schematic diagram of a display apparatus according to at least one embodiment of the present disclosure.

Detailed Description

The embodiments of the present disclosure will be described below with reference to the drawings in detail. Implementation modes may be implemented in multiple different forms. Those of ordinary skills in the art may easily understand such a fact that modes and contents may be transformed into other forms without departing from the purpose and scope of the present disclosure. Therefore, the present disclosure should not be explained as being limited to contents recorded in following implementation modes only. The embodiments and features in the embodiments in the present disclosure may be randomly combined with each other if there is no conflict.

In the drawings, a size of one or more constituent elements, a thickness of a layer, or a region is sometimes exaggerated for clarity. Therefore, one mode of the present disclosure is not necessarily limited to the size, and a shape and a size of one or more components in the drawings do not reflect an actual scale. In addition, the accompanying drawings schematically illustrate ideal examples, and a mode of the present disclosure is not limited to shapes, numerical values, or the like shown in the drawings.

Ordinal numerals "first", "second", "third", etc., in the specification are set not to form limits in numbers but only to avoid confusion between constituent elements. In the present disclosure, "plurality" represents two or more than two.

In the specification, for convenience, expressions "central", "above", "below", "front", "back", "vertical", "horizontal", "top", "bottom", "inside", "outside", etc., indicating directional or positional relationships are used to illustrate positional relationships between the constituent elements with reference to the drawings, not to indicate or imply that a referred apparatus or element must have a specific orientation and be structured and operated with the specific orientation but only to easily and simply describe the present specification, and thus should not be understood as limitations on the present disclosure. The positional relationships between the constituent elements are changed as appropriate according to a direction where the constituent elements are described. Therefore, appropriate replacements may be made according to situations, which is not limited to the expressions in the specification.

In the specification, unless otherwise specified and defined, terms "mounting", "mutual connection", and "connection" should be understood in a broad sense. For example, it may be a fixed connection, a detachable connection, or an integral connection; it may be a mechanical connection or a connection; it may be a direct connection, an indirect connection through a middleware, or internal communication inside two elements. Those of ordinary skills in the art may understand meanings of the aforementioned terms in the present disclosure according to situations.

In the specification, an "electrical connection" includes a case that constituent elements are connected together through an element having some electrical function. The "element having some electrical function" is not particularly limited as long as electrical signals between the connected constituent elements may be transmitted. Examples of the "element having some electrical function" not only include an electrode and a wiring, but also include a switching element such as a transistor, a resistor, an inductor, a capacitor, another element with multiple functions, etc.

In the specification, a transistor refers to an element which at least includes three terminals, i.e., a gate, a drain, and a source. The transistor has a channel region between the drain (drain electrode terminal, drain region, or drain electrode) and the source (source electrode terminal, source region, or source electrode), and a current can flow through the drain, the channel region, and the source. In the specification, the channel region refers to a region through which a current mainly flows.

In the specification, a first electrode may be a drain and a second electrode may be a source, or, a first electrode may be a source and a second electrode may be a drain. In a case that transistors with opposite polarities are used, or in a case that a direction of a current is changed during operation of a circuit, or the like, functions of the "source" and the "drain" are sometimes interchangeable. Therefore, the "source" and the "drain" are interchangeable in the specification. In addition, the gate may also be referred to as a control electrode.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a circle, oval, triangle, rectangle, trapezoid, pentagon, or hexagon, etc. is not in the strict sense, but may be an approximate circle, oval, triangle, rectangle, trapezoid, pentagon, or hexagon, etc. Some small deformation due to tolerances may exist, for example, a guide angle, arc edge, and deformation, etc. may exist.

A "light transmittance" in the present disclosure refers to an ability of light to pass through a medium, and is a percentage of luminous flux passing through a transparent or translucent body to its incident luminous flux.

In the present disclosure, "about" and "substantially" refer to that a boundary is not defined strictly and a case within a range of process and measurement errors is allowed. In the present disclosure, "identical" may include completely identical and substantially identical cases, and "substantially identical" refers to a case where an exponential value differs by less than 10%.

In the present disclosure, "A extends along a B direction" means that A may include a main body portion and a secondary portion connected with the main body portion, the main body portion is a line, a line segment, or a strip-shaped body, the main body portion extends along the B direction, and a length of the main body portion extending along the B direction is greater than a length of the secondary portion extending along another direction. "A extends along the B direction" in the present disclosure means "the main portion of A extends along the B direction".

With continuous development of display technologies, cameras are usually installed on display devices to meet needs of camera shooting or face recognition. In order to maximize a screen-to-body ratio, technologies such as a bangs screen, a water drop screen, and screen hollowing have appeared successively. These technologies reduce an area occupied by a camera by digging a hole in a part of a display region and placing the camera under a hole-digging region, thus increasing the screen-to-body ratio. However, the above technologies need to dig out a part of the display region, which will cause some regions in a display picture to be unable to be displayed, and make it impossible to further improve the screen-to-body ratio. In order to avoid drilling a hole in the display region and make a true full screen possible while ensuring practicality of a display substrate, a pixel circuit external method or a pixel circuit built-in method is usually used in a full display with camera region.

The pixel circuit external method means that a pixel circuit connected with a light emitting element in the full display with camera region is set in a normal display region, and a light transmittance of the full display with camera region is improved by arranging the light emitting element and the pixel circuit separately. Since no pixel circuit is disposed in the full display with camera region, there is no other light shielding layer in this region except an anode of the light emitting element, and a relatively high light transmittance may be achieved. However, in this mode, the pixel circuit and the light emitting element need to be electrically connected through a conductive connection line, which is limited by arrangement space of the conductive connection line, and a size (e.g., an aperture) of the full display with camera region of the display substrate using the pixel circuit external method is limited. Increasing the aperture of the full display with camera region usually requires increasing a mask process of the conductive connection line, resulting in increased costs. Moreover, a material of the conductive connection line is usually a transparent conductive material, such as Indium Tin Oxide (ITO). Because of a relatively large square resistance of ITO, a load of the conductive connection line is relatively large, which easily affects brightness of the light emitting element in the full display with camera region adversely and reduces brightness of the full display with camera region, thus causing poor display in the full display with camera region, such as vertical poor display (Mura).

The pixel circuit built-in method refers to setting a light emitting element and a pixel circuit connected with light emitting element in a full display with camera region. Compared with the pixel circuit external method, an electrical connection between the pixel circuit and the light emitting element in the full display with camera region using the built-in method does not need a relatively long conductive connection line, which may avoid a poor display situation of the full display with camera region caused by the conductive connection line. Moreover, the built-in method does not limit a size of the full display with camera region and may support the full display with camera region with a large aperture. However, with increase of Pixels Per Inch (PPI) of a full display with camera region, the built-in pixel circuit method is difficult to meet requirements of a high transmittance and a good display effect.

The embodiments provide a display substrate and a display apparatus, which may improve a light transmittance of a full display with camera region of a display substrate using a pixel circuit built-in method.

An embodiment provide a display substrate including a base substrate, multiple first pixel circuits and multiple first light emitting elements located in a first display region. At least one first pixel circuit is electrically connected with at least two first light emitting elements. At least one first pixel circuit includes at least one reset transistor. An orthographic projection of at least one first light emitting element on the base substrate is at least partially overlapped with an orthographic projection of the reset transistor of the at least one first pixel circuit on the base substrate.

In some examples, multiple first pixel circuits may be divided into two groups. A first pixel circuit in the first group of first pixel circuits is connected with a first light emitting element in a one-drive-one manner, i.e., each first pixel circuit in the first group of first pixel circuits may be electrically connected with a first light emitting element and configured to drive the connected first light emitting element to emit light. A first pixel circuit of the second group of first pixel circuits may be connected with first light emitting elements in a one-drive-many manner, i.e., each first pixel circuit in the second group of first pixel circuits may be electrically connected with at least two first light emitting elements and configured to drive the connected at least two first light emitting elements to emit light. However, the embodiment is not limited thereto. In other examples, multiple first pixel circuits may each be connected with first light emitting elements in a one-drive-many manner, i.e., each first pixel circuit may be connected with at least two first light emitting elements to drive the connected at least two first light emitting elements to emit light.

In some examples, an orthographic projection of a first light emitting element on the base substrate may be at least partially overlapped with an orthographic projection of a reset transistor of a first pixel circuit on the base substrate; as another example, an orthographic projection of a first light emitting element on the base substrate may be at least partially overlapped with an orthographic projection of reset transistors of multiple first pixel circuits on the base substrate. The embodiment is not limited thereto.

In the display substrate provided by the embodiment, a pixel circuit built-in method is adopted, and a first pixel circuit is used for driving first light emitting elements at least using a one-drive-many mode in the first display region, so that a quantity of first pixel circuits in the first display region is less than a quantity of first light emitting elements, which is beneficial for improving a light transmittance of the first display region. In some examples, in a case that pixels per inch of the first display region is increased, a solution of the embodiment may increase a light transmittance area, increase a light transmittance of the first display region, and ensure a display effect of the first display region by reducing first pixel circuits.

In some exemplary implementation modes, multiple first light emitting elements may include multiple first light emitting elements emitting light of different colors. An orthographic projection of at least one of multiple first light emitting elements emitting light of a same color on the base substrate is at least partially overlapped with an orthographic projection of a reset transistor of at least one first pixel circuit on the base substrate. For example, an orthographic projection of at least one first light emitting element on the base substrate may be at least partially overlapped with an orthographic projection of a reset transistor of a first pixel circuit without an electrical connection relationship on the base substrate; or, an orthographic projection of at least one first light emitting element on the base substrate may be at least partially overlapped with an orthographic projection of a reset transistor of a corresponding electrically connected first pixel circuit on the base substrate. In this example, a reset transistor of a first pixel circuit may be disposed under first light emitting elements emitting light of a same color to optimize a circuit layout and increase a light transmittance area of the first display region.

In some exemplary implementation modes, an orthographic projection of an anode of at least one first light emitting element on the base substrate may contain an orthographic projection of an active layer of at least one reset transistor on the base substrate. For example, an orthographic projection of an anode of at least one first light emitting element on the base substrate may contain an orthographic projection of an active layer of a reset transistor on the base substrate. In the example, a reset transistor is shielded by disposing an anode of a first light emitting element to cover an active layer of the reset transistor, so as to increase a light transmittance area of the first display region.

In some exemplary implementation modes, at least one first pixel circuit may include a first reset transistor and a second reset transistor. An orthographic projection of the first reset transistor of the at least one first pixel circuit on the base substrate is at least partially overlapped with an orthographic projection of a first light emitting element on the base substrate, and an orthographic projection of the second reset transistor of the at least one first pixel circuit on the base substrate is at least partially overlapped with an orthographic projection of another first light emitting element emitting a same color light on the base substrate. In the example, by disposing a first reset transistor and a second reset transistor of a same first pixel circuit to be shielded by different first light emitting elements, it is beneficial to optimize a circuit layout, thereby increasing the light transmittance area of the first display region. In some examples, an orthographic projection of a first light emitting element that is overlapped with the second reset transistor on the base substrate may not be overlapped with an orthographic projection of a first pixel circuit connected with the first light emitting element on the base substrate. For example, a first pixel circuit may be electrically connected with at least two first light emitting elements, and one of the at least two first light emitting elements may not be overlapped with an orthographic projection of a first pixel circuit connected with it on the base substrate, but is used for shielding a reset transistor (such as a second reset transistor) of another first pixel circuit to optimize a shielding effect of a first light emitting element on a first pixel circuit, thereby increasing the light transmittance area of the first display region.

In some exemplary implementation modes, multiple first light emitting elements may be divided into multiple light emitting units, each of which may include: a first light emitting element emitting light of a first color, a first light emitting element emitting light of a second color, and two first light emitting elements emitting light of a third color. The first light emitting element emitting light of the first color is electrically connected with a first pixel circuit; the first light emitting element emitting light of the second color is electrically connected with a first pixel circuit; and the two first light emitting elements emitting light of the third color are electrically connected with a same first pixel circuit. In the example, a quantity of first pixel circuits in the first display region may be reduced by reducing a quantity of first pixel circuits electrically connected with the first light emitting elements emitting light of the third color, thereby facilitating improvement of the light transmittance of the first display region.

In some exemplary implementation modes, the first light emitting element emitting light of the first color and the first light emitting element emitting light of the second color in the light emitting unit may be arranged in a same row, the two first light emitting elements emitting light of the third color may be arranged in a same row, and four first light emitting elements in the light emitting unit may be arranged in different columns. Among them, the light of the first color may be red light, the light of the second color may be blue light, and the light of the third color may be green light. However, the embodiment is not limited thereto. An arrangement of first light emitting elements and a connection mode of first pixel circuits in the example may increase the light transmittance of the first display region as much as possible on a basis of ensuring light emitting white balance.

In some exemplary implementation modes, the first display region may include: multiple circuit island regions spaced apart from each other and arranged in an array, each circuit island region includes: three first pixel circuits disposed in sequence in a first direction; two adjacent rows of circuit island regions are dislocated; and three first pixel circuits of a circuit island region are electrically connected with four first light emitting elements in a light emitting unit. An arrangement mode of first pixel circuits in the example is beneficial to increase the light transmittance area of the first display region.

Solutions of the embodiments will be described below through some examples.

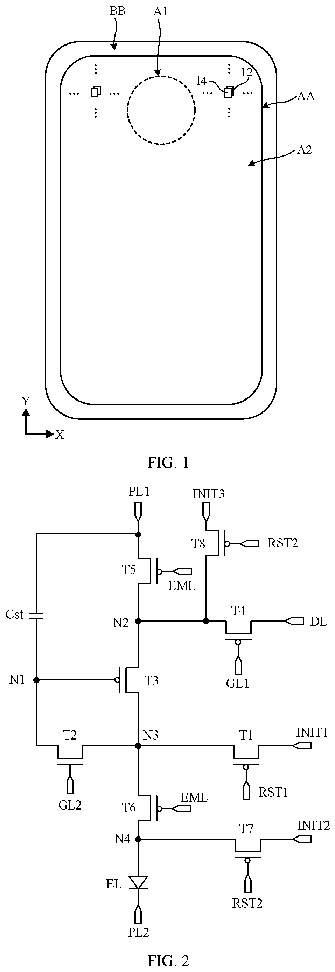

FIG. 1 is a schematic diagram of a display substrate according to at least one embodiment of the present disclosure. In some examples, as shown in FIG. 1, the display substrate may include a display region AA and a peripheral region BB locating outside the display region AA. The display region AA of the display substrate may at least include a first display region A1 and a second display region A2. The second display region A2 may at least partially surround the first display region A1. For example, the second display region A2 may surround the first display region A1. The peripheral region BB may surround the periphery of the second display region A2. However, the embodiment is not limited thereto.

In some examples, as shown in FIG. 1, the first display region A1 may be a light transmitting display region and may also be referred to as a Full Display with Camera (FDC) region. The second display region A2 may be referred to as a normal display region. For example, an orthographic projection of a sensor (such as a camera and other hardware) on the display substrate may be located within the first display region A1 of the display substrate. In some examples, as shown in FIG. 1, the first display region A1 may be circular, and a size of the orthographic projection of the sensor on the display substrate may be less than or equal to a size of the first display region A1. However, the embodiment is not limited thereto. In some other examples, the first display region A1 may be rectangular, and a size of the orthographic projection of the sensor on the display substrate may be less than or equal to a size of an inscribed circle of the first display region A1.

In some examples, as shown in FIG. 1, the first display region A1 may be located at a middle position of a top of the display region AA. The second display region A2 may surround the first display region A1. However, the embodiment is not limited thereto. For example, the first display region A1 may be located in other positions such as an upper left corner, a lower left corner, a lower right corner, or an upper right corner of the display region AA. For example, the second display region A2 may surround at least one side of the first display region A1.

In some examples, as shown in FIG. 1, the display region AA may be in a shape of a rectangle, e.g., a rounded rectangle. The first display region A1 may be circular or elliptical. However, the embodiment is not limited thereto. For example, the first display region A1 may be rectangular, semicircular, pentagonal, or have another shape.

In some examples, the display region AA may be provided with multiple sub-pixels. At least one sub-pixel may include a pixel circuit and a light emitting element. The pixel circuit may be configured to drive a connected light emitting element. For example, the pixel circuit may be configured to provide a drive current for driving the light emitting element to emit light. The pixel circuit may include multiple transistors and at least one capacitor. For example, the pixel circuit may be of a 3T1C, 4T1C, 5T1C, 5T2C, 6T1C, 7T1C, or 8T1C structure. Among them, in the above circuit structure, T refers to a thin film transistor, C refers to a capacitor, a number before T represents a quantity of thin film transistors in the circuit, and a number before C represents a quantity of capacitors in the circuit.

In some examples, the light emitting element may be any of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, etc. under drive of a pixel circuit corresponding to the light emitting element. A color of light emitted from the light emitting element may be determined as required. In some examples, the light emitting element may include an anode, a cathode, and an organic emitting layer located between the anode and the cathode. The anode of the light emitting element may be electrically connected with a corresponding pixel circuit. However, the embodiment is not limited thereto.

FIG. 2 is an equivalent circuit diagram of a pixel circuit according to at least one embodiment of the present disclosure. The pixel circuit of the example is described by taking a 8T1C structure as an example. In some examples, as, shown in FIG. 2, the pixel circuit of the example may include eight transistors (i.e., a first transistor T1 to an eighth transistor T8) and a storage capacitor Cst. The first transistor T1 may also be referred to as a first reset transistor, the second transistor T2 may also be referred to as a threshold compensation transistor, the third transistor T3 may also be referred to as a drive transistor, the fourth transistor T4 may also be referred to as a data writing transistor, the fifth transistor T5 may also be referred to as a first light emitting control transistor, the sixth transistor T6 may also be referred to as a second light emitting control transistor, the seventh transistor T7 may also be referred to as a second reset transistor, and the eighth transistor T8 may also be referred to as a third reset transistor. The light emitting element EL may include an anode, a cathode, and an organic emitting layer disposed between the anode and the cathode.

In some examples, the first transistor T1 and the third transistor T3 to the eighth transistor T8 may be a first type transistor, for example, may be a P-type transistor, and the second transistor T2 may be a second type transistor, for example, may be an N-type transistor. However, the embodiment is not limited thereto. For example, the multiple transistors of the pixel circuit may be all P-type transistors, or all N-type transistors.

In some examples, for first type transistors (e.g., including the first transistor T1 and the third transistor T3 to the eighth transistor T8) of the pixel circuit, a low temperature poly silicon thin film transistor may be adopted, and for a second type transistor (e.g., including the second transistor T2) of the pixel circuit, an oxide thin film transistor may be adopted. Low Temperature Poly Silicon (LTPS) is adopted for an active layer of a low temperature poly silicon thin film transistor and an oxide semiconductor (Oxide) is adopted for an active layer of an oxide thin film transistor. A low temperature poly silicon thin film transistor has advantages such as a high mobility rate and fast charging, and an oxide thin film transistor has advantages such as a low leakage current. The low temperature poly silicon thin film transistor and the oxide thin film transistor are integrated on one display substrate to form a Low Temperature Polycrystalline Oxide (LTPS + Oxide) display substrate, and advantages of both the low temperature poly silicon thin film transistor and the oxide thin film transistor may be utilized, which may achieve low-frequency drive, reduce power consumption, and improve display quality.

In some examples, as shown in FIG. 2, the pixel circuit may be electrically connected with a first scan line GL1, a second scan line GL2, a data line DL, a first power supply line PL1, a second power supply line PL2, a light emitting control line EML, a first initial signal line INIT1, a second initial signal line INIT2, a third initial signal line INIT3, a first reset control line RST1, and a second reset control line RST2. The first power supply line PL1 may be configured to provide a constant first voltage signal VDD to the pixel circuit, the second power supply line PL2 may be configured to provide a constant second voltage signal VSS to the pixel circuit, and the first voltage signal VDD is greater than the second voltage signal VSS. The first scan line GL1 may be configured to provide a first scan signal SCAN1 to the pixel circuit. The second scan line GL2 may be configured to provide a second scan signal SCAN2 to the pixel circuit. The data line DL may be configured to provide a data signal to the pixel circuit. The light emitting control line EML may be configured to provide a light emitting control signal EM to the pixel circuit. The first reset control line RST1 may be configured to provide a first reset control signal RESET1 to the pixel circuit. The second reset control line may be configured to provide a second reset control signal RESET2 to the pixel circuit.

In some examples, as shown in FIG. 2, a gate of the third transistor T3 is electrically connected with a first node N1, a first electrode of the third transistor T3 is electrically connected with a second node N2, and a second electrode of the third transistor T3 is electrically connected with a third node N3. A gate electrode of the fourth transistor T4 is electrically connected with the first scan line GL1, a first electrode of the fourth transistor T4 is electrically connected with the data line DL, and a second electrode of the fourth transistor T4 is electrically connected with the second node N2. A gate electrode of the second transistor T2 is connected with the second scan signal line GL2, a first electrode of the second transistor T2 is electrically connected with the first node N1, and a second electrode of the second transistor T2 is electrically connected with the third node N3. A gate of the fifth transistor T5 is electrically connected with the light emitting control line EML, a first electrode of the fifth transistor T5 is electrically connected with the first power supply line PL1, and a second electrode of the fifth transistor T5 is electrically connected with the second node N2. A gate of the sixth transistor T6 is electrically connected with the light emitting control line EML, a first electrode of the sixth transistor T6 is electrically connected with the third node N3, and a second electrode of the sixth transistor T6 is electrically connected with a fourth node N4. A gate electrode of the first transistor T1 is electrically connected with the first reset control line RST1, a first electrode of the first transistor T1 is electrically connected with the first initial signal line INIT1, and a second electrode of the first transistor T1 is electrically connected with the third node N3. The first transistor T1 may be configured to reset the third node N3. A gate electrode of the seventh transistor T7 is electrically connected with the second reset control line RST2, a first electrode of the seventh transistor T7 is electrically connected with the second initial signal line INIT2, and a second electrode of the seventh transistor T7 is electrically connected with the fourth node N4. The seventh transistor T7 may be configured to reset the fourth node N4. A gate electrode of the eighth transistor T8 is electrically connected with the second reset control line RST2, a first electrode of the eighth transistor T8 is electrically connected with the third initial signal line INIT3, and a second electrode of the eighth transistor T8 is electrically connected with the second node N2. The eighth transistor T8 may be configured to reset the second node N2. A first electrode of the storage capacitor Cst is electrically connected with the first node N1, and a second electrode of the storage capacitor Cst is electrically connected with the first power supply line PL1.

In the example, the first node N1 is a connection point of the storage capacitor Cst, the second transistor T2, and the third transistor T3, the second node N2 is a connection point of the fifth transistor T5, the fourth transistor T4, the eighth transistor T8, and the third transistor T3, the third node N3 is a connection point of the first transistor T1, the third transistor T3, the second transistor T2, and the sixth transistor T6, and the fourth node N4 is a connection point of the sixth transistor T6, the seventh transistor T7, and the light emitting element EL.

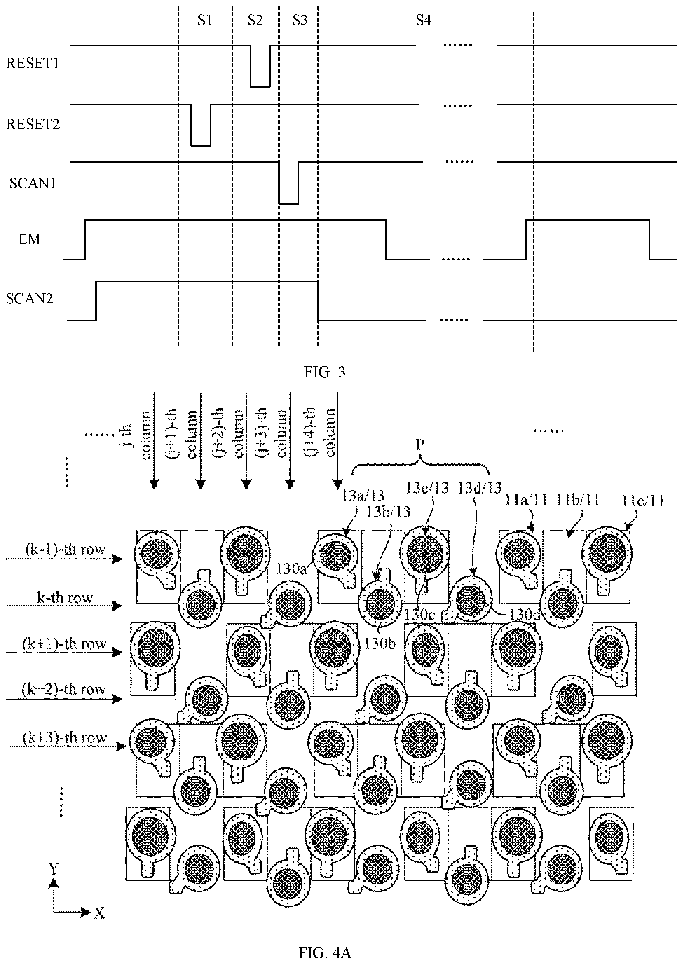

FIG. 3 is a working timing diagram of the pixel circuit provided in FIG. 2. A working process of the pixel circuit shown in FIG. 2 will be described below with reference to FIG. 3. Herein, the first transistor T1 and the third transistor T3 to the eighth transistor T8 of the pixel circuit are P-type transistors, and the second transistor T2 is an N-type transistor.

In some examples, as shown in FIG. 2 and FIG. 3, during one frame display time period, the working process of the pixel circuit may at least include a first stage S1, a second stage S2, a third stage S3, and a fourth stage S4.

The first stage S1 is referred to as a first reset stage. The second reset control signal RESET2 provided by the second reset control line RST2 is a low level signal, so that the seventh transistor T7 and the eighth transistor T8 are turned on, and the second scan signal SCAN2 provided by the second scan line GL2 is a high level signal, so that the second transistor T2 is turned on. The eighth transistor T8 is turned on, so that the third initial signal provided by the third initial signal line INIT3 is provided to the second node N2. The seventh transistor T7 is turned on, so that the second initial signal provided by the second initial signal line INIT2 is provided to the fourth node N4 to initialize the fourth node N4. The first scan signal SCAN1 provided by the first scan line GL1 is a high level signal, the first reset control signal RESET1 provided by the first reset control line RST1 is a high level signal, and the light emitting control signal EM provided by the light emitting control line EML is a high level signal, so that the fourth transistor T4, the first transistor T1, the fifth transistor T5, and the sixth transistor T6 are turned off. In this stage, the light emitting element EL does not emit light.

The second stage S2 is referred to as a second reset stage. The first reset control signal RESET1 provided by the first reset control line RST1 is a low level signal, and the first transistor T1 is turned on; the second scan signal SCAN2 provided by the second scan line GL2 is a high level signal, and the second transistor T2 is turned on. The first transistor T1 and the second transistor T2 are turned on, so that a first initial signal line provided by the first initial signal line INIT1 is provided to the first node N1 to initialize the first node N1. The second reset control signal RESET2 provided by the second reset control line RST2 is a high level signal, the first scan signal SCAN1 provided by the first scan line GL1 is a high level signal, and the light emitting control signal EM provided by the light emitting control line EML is a high level signal, so that the seventh transistor T7, the eighth transistor T8, the fourth transistor T4, the fifth transistor T5, and the sixth transistor T6 are turned off. In this stage, the light emitting element EL does not emit light.

The third stage S3 is referred to as a data writing stage or a threshold compensation stage. The first scan signal SCAN1 provided by the first scan line GL1 is a low level signal, and the fourth transistor T4 is turned on; the second scan signal SCAN2 provided by the second scan line GL2 is a high level signal, and the second transistor T2 is turned on. In this stage, the first electrode of the storage capacitor Cst is at a low level and the third transistor T3 is turned on. The second transistor T2, the fourth transistor T4, and the third transistor T3 are turned on, so that a data voltage Vdata output by the data line DL is provided to the first node N1 through the second node N2, the turned-on third transistor T3, the third node N3, and the turned-on second transistor T2, and the storage capacitor Cst is charged with a difference between the data voltage Vdata output by the data line DL and a threshold voltage of the third transistor T3. A voltage of the first electrode (i.e., the first node N1) of the storage capacitor Cst is Vdata-|Vth|, wherein Vdata is the data voltage output by the data line DL, and Vth is the threshold voltage of the third transistor T3. The first reset control signal RESET1 provided by the first reset control line RST1 is a high level signal, the second reset control signal RESET2 provided by the second reset control line RST2 is a high level signal, and the light emitting control signal EM provided by the light emitting control line EML is a high level signal, so that the first transistor T1, the seventh transistor T7, the eighth transistor T8, the fifth transistor T5, and the sixth transistor T6 are turned off.

In the fourth stage S4, the light emitting control signal EM provided by the light emitting control line EML may be switched from a high level signal to a low level signal, so that the fifth transistor T5 and the sixth transistor T6 are turned on. The second scan signal SCAN2 provided by the second scan line GL2 is a low level signal, so that the second transistor T2 is turned off. The first scan signal SCAN1 provided by the first scan line GL1, the first reset control signal RESET1 provided by the first reset control line RST1, and the second reset control signal RESET2 provided by the second reset control line RST2 are high level signals, so that the fourth transistor T4, the first transistor T1, the seventh transistor T7, and the eighth transistor T8 are turned off. The first voltage signal VDD outputted by the first power supply line PL1 may provide a drive voltage to an anode of the light emitting element EL through the turned-on fifth transistor T5, the third transistor T3, and the sixth transistor T6, to drive the light emitting element EL to emit light.

In a drive process of the pixel circuit, a drive current flowing through the third transistor T3 is determined by a voltage difference between the gate and the first electrode of the third transistor T3. Since the voltage of the first node N1 is Vdata-|Vth|, the drive current of the third transistor T3 is as follows.

$$I = K \times (Vgs - Vth)^2 = K \times [(VDD - Vdata + |Vth|) - Vth]^2 = K \times [VDD - Vdata]^2$$

Herein, I is the drive current flowing through the third transistor T3, that is, a drive current for driving the light emitting element, K is a constant, Vgs is the voltage difference between the gate and the first electrode of the third transistor T3, Vth is the threshold voltage of the third transistor T3, Vdata is the data voltage outputted by the data line DL, and VDD is the first voltage signal outputted by the first power supply line PL1.

It may be seen from the above formula that a current flowing through the light emitting element is independent of the threshold voltage of the third transistor T3. Therefore, the pixel circuit according to the embodiment may better compensate the threshold voltage of the third transistor T3. Moreover, the pixel circuit provided in the embodiment may improve a poor display situation caused by a low frequency and improve a display effect of the light emitting element.

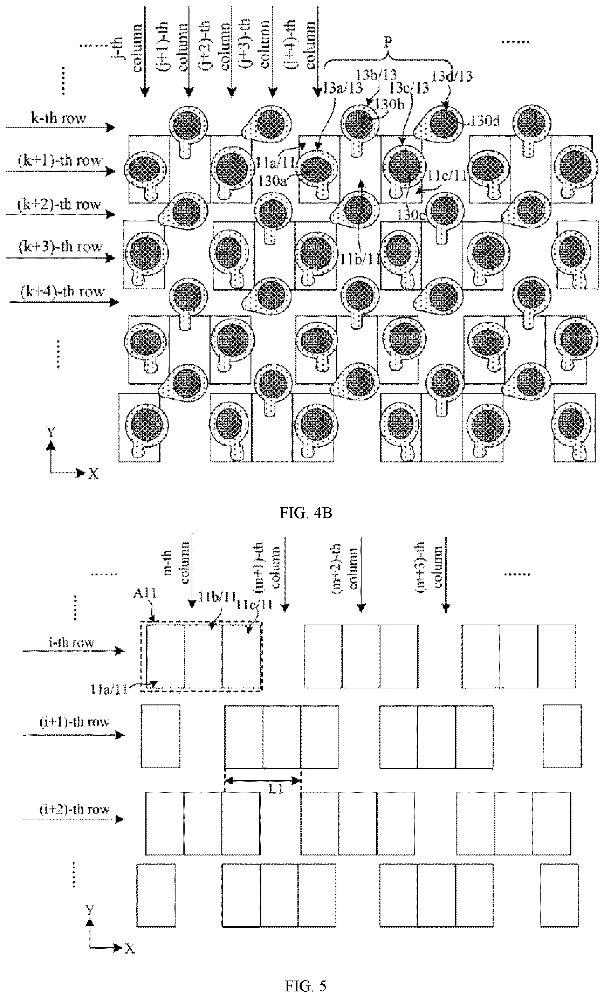

FIG. 4A and FIG. 4B are partial schematic diagrams of a first display region according to at least one embodiment of the present disclosure. In some examples, as shown in FIGs. 1, 4A, and 4B, the first display region A1 of the display substrate may include multiple first light emitting elements 13 and multiple first pixel circuits 11. Multiple first pixel circuits 11 are electrically connected with multiple first light emitting elements 13. The second display region A2 may include multiple second light emitting elements 14 and multiple second pixel circuits 12. Circuit structures of a first pixel circuit 11 and a second pixel circuit 12 of the example may be the same, for example, may be the 8T1C structure as previously described.

In some examples, as shown in FIG. 1, at least one second pixel circuit 12 is electrically connected with at least one second light emitting element 14. For example, multiple second pixel circuits 12 and multiple second light emitting elements 14 may be electrically connected in one-to-one correspondence and one second pixel circuit 12 may be configured to drive one second light emitting element 14 to emit light. An orthographic projection of the second light emitting element 14 on the base substrate may be at least partially overlapped with an orthographic projection of a connected second pixel circuit 12 on the base substrate. However, the embodiment is not limited thereto. In other examples, multiple second pixel circuits may be configured to drive one second light emitting element, or, a second pixel circuit may be configured to drive multiple second light emitting elements.

In some examples, as shown in FIGs. 4A and 4B, multiple first light emitting elements 13 of the first display region may include multiple first light emitting elements 13a emitting light of a first color, multiple first light emitting elements 13c emitting light of a second color, and multiple first light emitting elements 13b and 13d emitting light of a third color. In some examples, light of the first color may be red light (R), light of the second color may be blue light (B), and light of the third color may be green light (G). The embodiment is not limited thereto.

In some examples, as shown in FIGs. 4A and 4B, the multiple first light emitting elements 13 within the first display region may be arranged according to a Pentile structure. The first light emitting elements 13b and 13d emitting light of the third color may be alternately arranged in a k-th row at a certain interval, and the first light emitting elements 13a emitting light of the first color and the first light emitting elements 13c emitting light of the second color may be alternately arranged in a (k+1)-th row; the first light emitting elements 13b and 13d emitting light of the third color may be alternately arranged at a certain interval in a (k+2)-th row adjacent to the (k+1)-th row, and the first light emitting elements 13a emitting light of the first color and the first light emitting elements 13c emitting light of the second color may be alternately arranged in a (k+3)-th row adjacent to the (k+2)-th row. According to the above rule, multiple rows of first light emitting elements 13 may be repeatedly arranged. The first light emitting elements 13a emitting light of the first color and the first light emitting elements 13c emitting light of the second color may be alternately arranged in a j-th column, and the first light emitting elements 13b and 13d emitting light of the third color may be arranged at a certain interval in a (j+1)-th column adjacent to the j-th column. The first light emitting elements 13a emitting light of the first color and the first light emitting elements 13c emitting light of the second color may be alternately arranged in a (j+2)-th column adjacent to the (j+1)-th column, and the first light emitting elements 13b and 13d emitting light of the third color may be arranged at a certain interval in a (j+3)-th column. According to the above rule, multiple columns of first light emitting elements 13 may be repeatedly arranged. Among them, k and j are integers. In the present disclosure, multiple first light emitting elements 13 arranged in a first direction X may be referred to as a row of first light emitting elements, and multiple first light emitting elements 13 arranged in a second direction Y may be referred to as a column of first light emitting elements.

In some examples, as shown in FIGs. 4A and 4B, one light emitting unit P of the first display region may include four first light emitting elements 13, i.e., one first light emitting element 13a that emits light of a first color, one first light emitting element 13c that emits light of a second color, and two first light emitting elements 13b and 13d that emit light of a third color. In the light emitting unit P, the first light emitting element 13a emitting light of the first color and the first light emitting element 13c emitting light of the second color may be arranged in a same row, the two first light emitting elements 13b and 13d emitting light of the third color may be arranged in a same column, and four first light emitting elements 13 included in the light emitting unit P may be arranged in different columns. As shown in FIG. 4A, a row where the first light emitting element 13a emitting light of the first color and the first light emitting element 13c emitting light of the second color within one light emitting unit P are located may be located in an upper row of a row where the two first light emitting elements 13b and 13d emitting light of the third color are located. As shown in FIG. 4B, a row where the first light emitting element 13a emitting light of the first color and the first light emitting element 13c emitting light of the second color within one light emitting unit P are located may be located in a lower row where the two first light emitting elements 13b and 13d emitting light of the third color are located. However, the embodiment is not limited thereto.

In some examples, as shown in FIGs. 4A and 4B, the first light emitting element 13a emitting light of the first color has a first light emitting region 130a, the first light emitting element 13c emitting light of the second color has a second light emitting region 130c, the first light emitting element 13b emitting light of the third color has a third light emitting region 130b, and the first light emitting element 13d emitting light of the third color has a fourth light emitting region 130d. The first light emitting region 130a, the second light emitting region 130c, the third light emitting region 130b, and the fourth light emitting region 130d may be substantially circular or elliptical. The first light emitting region 130a of the first light emitting element 13a emitting light of the first color may be smaller than the second light emitting region 130c of the first light emitting element 13c emitting light of the second color. The second light emitting region 130c of the first light emitting element 13c emitting light of the second color may be larger than the third light emitting region 130b of the first light emitting element 13b and the fourth light emitting region 130d of the first light emitting element 13d emitting light of the third color. The third light emitting region 130b and the fourth light emitting region 130d may be substantially the same. In the example, a light emitting region of a light emitting element may be a portion where the light emitting element is located at a pixel opening of a pixel definition layer.

FIG. 5 is a schematic diagram of a circuit arrangement of a first display region according to at least one embodiment of the present disclosure. FIG. 5 is a schematic diagram of an arrangement of a first pixel circuit in a partial region of the first display region in FIGs. 4A and 4B. In some examples, as shown in FIG. 5, the first display region may include multiple circuit island regions A11 spaced from each other. Each circuit island region A11 may include multiple first pixel circuits 11, for example, three first pixel circuits 11. In a plane parallel to the display substrate, multiple circuit island regions A11 may be arranged in multiple rows and multiple columns. The multiple circuit island regions A11 arranged in the first direction X may be referred to as a row of circuit island regions, and the multiple circuit island regions A11 arranged in the second direction Y may be referred to as a column of circuit island regions. Centerlines of multiple circuit island regions A11 of a column of circuit island regions in the first direction X may be substantially aligned. Two adjacent circuit island regions A11 in one row of circuit island regions may be arranged at an interval of one column. For example, a circuit island region A11 in circuit island regions of an i-th row is located in an (m+2)-th column, then a circuit island region adjacent to the circuit island region A11 in the i-th row may be located in an m-th column or in an (m+4)-th column. Two adjacent circuit island regions A11 in a column of circuit island regions may be arranged at an interval of one column. For example, one circuit island region in circuit island regions of the m-th column is located in the i-th row, a circuit island region adjacent to the circuit island region in the m-th column may be located in an (i-2)-th row or an (i+2)-th row. Among them, i and m are integers. In the example, circuit island regions A11 of adjacent rows may be dislocated in the second direction Y, and circuit island regions A11 of adjacent columns may be dislocated in the first direction X.

In some examples, as shown in FIGs. 4A, 4B, and 5, a single circuit island region A11 of the first display region may include three first pixel circuits 11 (e.g., including first pixel circuits 11a, 11b, and 11c) arranged in sequence in the first direction X. The three first pixel circuits 11 are electrically connected with four first light emitting elements 13, the four first light emitting elements 13 connected with the three first pixel circuits 11 may belong to one light emitting unit P. The first pixel circuit 11a may be electrically connected with a first light emitting element 13a emitting light of a first color, and is configured to drive the first light emitting element 13a to emit light. The first pixel circuit 11b may be electrically connected with two first light emitting elements 13b and 13d emitting light of a third color and is configured to drive the two first light emitting elements 13b and 13d emitting light of a same color to emit light. The first pixel circuit 11c may be electrically connected with a first light emitting element 13c emitting light of a second color and is configured to drive the first light emitting element 13c emitting light of the second color to emit light.

In some examples, as shown in FIGs. 4A to 5, a gap between adjacent circuit island regions A11 in a row of circuit island regions may be greater than or equal to a length of one first pixel circuit along the first direction X. For example, a dislocation distance L1 between two adjacent rows of circuit island regions may be greater than 1 time the length of the first pixel circuit along the first direction X and less than 3 times the length of the first pixel circuit along the first direction X, for example, may be about 2 times or 1.5 times. However, the embodiment is not limited thereto.

In some examples, as shown in FIGs. 4A and 4B, within the first display region, orthographic projections of the first light emitting element 13a and a first pixel circuit 11a with which it is connected on the base substrate may be at least partially overlapped, and orthographic projections of the first light emitting element 13c and a first pixel circuit 11c with which it is connected on the base substrate may be at least partially overlapped. Orthographic projections of the first light emitting element 13b and a first pixel circuit 11b with which it is connected on the base substrate may be at least partially overlapped, and orthographic projections of the first light emitting element 13d and a first pixel circuit 11b with which it is connected on the base substrate may not be overlapped.

In the example, by setting a same first pixel circuit to drive two first light emitting elements emitting light of the third color, a quantity of first pixel circuits required by a circuit island region may be reduced, occupied space of the first pixel circuits in the first display region may be saved, wiring space may be saved, thereby increasing the light transmittance of the first display region.

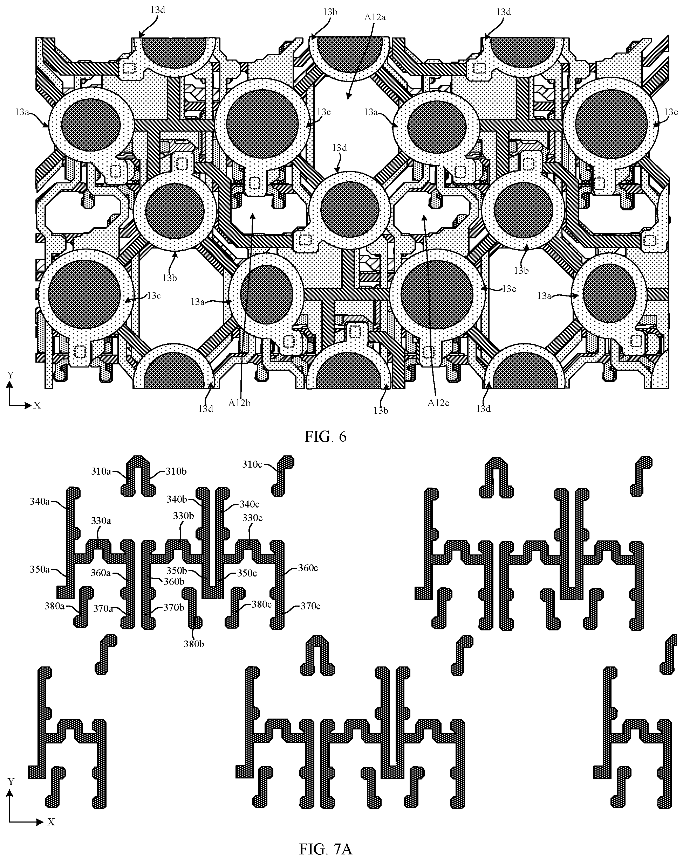

FIG. 6 is a partial top view of a first display region according to at least one embodiment of the present disclosure. FIG. 6 is a partial top view of the first display region shown in FIG. 4A. In some examples, as shown in FIG. 6, the first display region may include a first light-transmitting region A12a, a second light-transmitting region A12b, and a third light-transmitting region A12c. The first light-transmitting region A12a may be located in an interval region between adjacent circuit island regions in the first direction X, and may be surrounded by a first light emitting element 13c of one light emitting unit, a first light emitting element 13a of a light emitting unit adjacent to the one light emitting unit along the first direction X, a first light emitting element 13d of the one light emitting unit, a first light emitting element 13b adjacent to the first light emitting element 13d along the second direction Y, and a connection trace between two circuit island regions adjacent along the first direction X. The second light-transmitting region A12b and the third light-transmitting region A12c may be located in an interval region between adjacent circuit island regions along the second direction Y; the second light-transmitting region A12b may be surrounded by first light emitting elements 13b, 13c, and 13d of one light emitting unit, a first light emitting element 13a of an adjacent light emitting unit along the second direction Y, and a connection trace between adjacent circuit island regions. The third light-transmitting region A12c may be surrounded by a first light emitting element 13d of one light emitting unit, first light emitting elements 13b and 13a of a light emitting unit adjacent to the one light emitting unit along the first direction X, a first light emitting element 13c of a light emitting unit adjacent to the one light emitting unit along the second direction Y, and a connection trace between adjacent circuit island regions.

In some examples, in a direction perpendicular to the display substrate, the display substrate may include a base substrate, and a circuit structure layer and a light emitting structure layer disposed on the base substrate. The light emitting structure layer may be located on a side of the circuit structure layer away from the base substrate. The circuit structure layer of the first display region may include multiple first pixel circuits, and the light emitting structure layer of the first display region may include multiple first light emitting elements.

In some examples, the circuit structure layer may include: a first semiconductor layer, a first conductive layer, a second conductive layer, a second semiconductor layer, a third conductive layer, a fourth conductive layer, a fifth conductive layer, and a sixth conductive layer disposed on the base substrate. A first insulation layer may be disposed between the first semiconductor layer and the first conductive layer, a second insulation layer may be disposed between the first conductive layer and the second conductive layer, a third insulation layer may be disposed between the second conductive layer and the second semiconductor layer, a fourth insulation layer may be disposed between the second semiconductor layer and the third conductive layer, a fifth insulation layer may be disposed between the third conductive layer and the fourth conductive layer, a sixth insulation layer and a seventh insulation layer may be disposed between the fourth conductive layer and the fifth conductive layer, an eighth insulation layer may be disposed between the fifth conductive layer and the sixth conductive layer, and a ninth insulation layer and a tenth insulation layer may be disposed on a side of the sixth conductive layer away from the base substrate. In some examples, the first insulation layer to the sixth insulation layer may be inorganic insulation layers, and the seventh insulation layer to the tenth insulation layer may be organic insulation layers. The embodiment is not limited thereto. In some other examples, an insulation layer may be disposed between the fourth conductive layer and the fifth conductive layer. In other examples, an insulation layer may be disposed on a side of the sixth conductive layer away from the base substrate.

In some examples, the light emitting structure layer may include an anode layer, a pixel definition layer, an organic emitting layer, and a cathode layer disposed sequentially on the circuit structure layer. The anode layer may be electrically connected with a pixel circuit of the circuit structure layer, the organic emitting layer may be connected with the anode layer, the cathode layer may be connected with the organic emitting layer, and the organic emitting layer may emit light of a corresponding color under drive of the anode layer and the cathode layer.

A structure of the display substrate will be described below through an example of a preparation process of the display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or another process. If the "thin film" does not need to be processed through a patterning process in an entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process.

"A and B are disposed in a same layer" in the present disclosure means that A and B are formed simultaneously through a same patterning process, or distances between surfaces of A and B close to a base substrate and the base substrate are substantially the same, or the surfaces of A and B close to the base substrate are in direct contact with a same film layer. A "thickness" of a film layer is a dimension of the film layer in a direction perpendicular to the display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B. A "shape of A" mentioned in the present disclosure refers to a shape of an orthographic projection of A on a base substrate.

The circuit structure layer is described below by taking three first pixel circuits of one circuit island region of the first display region as an example. The example is explained by taking a case that a first pixel circuit is of the aforementioned 8T1C structure. Among them, a first first pixel circuit (i.e., the first pixel circuit 11a) may include a first transistor 31a, a second transistor 32a, a third transistor 33a, a fourth transistor 34a, a fifth transistor 35a, a sixth transistor 36a, a seventh transistor 37a, an eighth transistor 38a, and a storage capacitor; a second first pixel circuit (i.e., the first pixel circuit 11b) may include a first transistor 31b, a second transistor 32b, a third transistor 33b, a fourth transistor 34b, a fifth transistor 35b, a sixth transistor 36b, a seventh transistor 37b, an eighth transistor 38b, and a storage capacitor; a third first pixel circuit (i.e., the first pixel circuit 11c) may include a first transistor 31c, a second transistor 32c, a third transistor 33c, a fourth transistor 34c, a fifth transistor 35c, a sixth transistor 36c, a seventh transistor 37c, an eighth transistor 38c, and a storage capacitor. A connection relationship between eight transistors and a storage capacitor in each first pixel circuit may be referred to the equivalent circuit diagram shown in FIG. 2.

In some examples, the preparing process of the display substrate may include following operations.

(1) A base substrate is provided. In some examples, the base substrate may be a rigid base substrate or a flexible base substrate. For example, the rigid base substrate may be made of, but not limited to, one or more of glass and quartz. The flexible base substrate may be made of, but not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In some examples, the flexible base may include a first flexible material layer, a first inorganic material layer, a second flexible material layer, and a second inorganic material layer which are stacked. The first flexible material layer and the second flexible material layer may be made of a material such as Polyimide (PI), Polyethylene Terephthalate (PET), or a surface-treated polymer soft film, and materials of the first inorganic material layer and the second inorganic material layer may be Silicon Nitride (SiNx, x>0) or Silicon Oxide (SiOy, y>0), etc., to improve water-oxygen resistance of the base substrate.

(2) A first semiconductor layer is formed. In some examples, a first semiconductor thin film is deposited on the base substrate, and the first semiconductor thin film is patterned through a patterning process to form the first semiconductor layer disposed on the base substrate. In some examples, a material of the first semiconductor layer may be amorphous Silicon (a-Si), polycrystalline Silicon (p-Si), hexathiophene, or polythiophene, or another material.

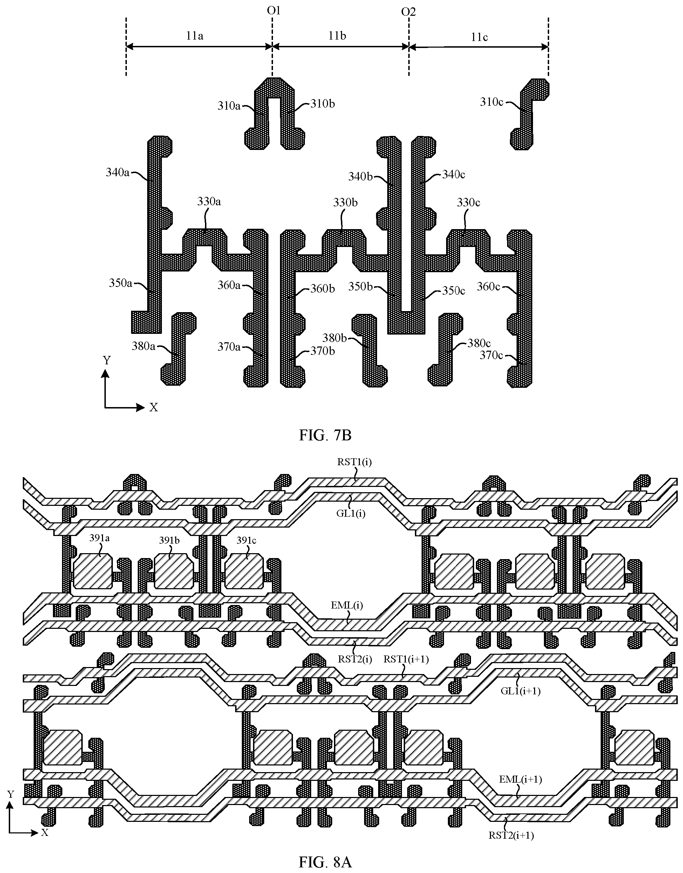

FIG. 7A is a schematic diagram of a first display region after a first semiconductor layer is formed in FIG. 6. FIG. 7B is a schematic diagram of a circuit island region in FIG. 7A.

In some examples, as shown in FIGs. 7A and 7B, the first semiconductor layer of the first display region may at least include: active layers of multiple first type transistors of multiple first pixel circuits (e.g., including: a first active layer 310a of a first transistor, a third active layer 330a of the third transistor, a fourth active layer 340a of the fourth transistor, a fifth active layer 350a of the fifth transistor, a sixth active layer 360a of the sixth transistor, a seventh active layer 370a of the seventh transistor, and an eighth active layer 380a of the eighth transistor of the first pixel circuit 11a; a first active layer 310b of the first transistor, a third active layer 330b of the third transistor, a fourth active layer 340b of the fourth transistor, a fifth active layer 350b of the fifth transistor, a sixth active layer 360b of the sixth transistor, a seventh active layer 370b of the seventh transistor, and an eighth active layer 380b of the eighth transistor of the first pixel circuit 11b; a first active layer 310c of the first transistor, a third active layer 330c of the third transistor, a fourth active layer 340c of the fourth transistor, a fifth active layer 350c of the fifth transistor, a sixth active layer 360c of the sixth transistor, a seventh active layer 370c of the seventh transistor, and an eighth active layer 380c of the eighth transistor of the first pixel circuit 11c).

In some examples, as shown in FIG. 7B, a pattern of the first semiconductor layer of the first pixel circuits 11a and 11b in one circuit island region may be substantially symmetrical with respect to a first centerline O1, and a pattern of the first semiconductor layer of the first pixel circuits 11b and 11c may be substantially symmetrical with respect to a second centerline O2. As shown in FIG. 7A, patterns of the first semiconductor layer of different circuit island regions may be independent of each other.

In some examples, as shown in FIG. 7B, the first active layer 310a of the first pixel circuit 11a and the first active layer 310b of the first pixel circuit 11b may be of an interconnected integrated structure. A shape of the integrated structure of the first active layers 310a and 310b may be approximately a shape of a Chinese character "几". The third active layer 330b, the fourth active layer 340b, the fifth active layer 350b, the sixth active layer 360b, the seventh active layer 370b of the first pixel circuit 11b, and the third active layer 330c, the fourth active layer 340c, the fifth active layer 350c, the sixth active layer 360c, and the seventh active layer 370c of the first pixel circuit 11c may be of an interconnected integrated structure, wherein the fifth active layer 350b of the first pixel circuit 11b and the fifth active layer 350c of the first pixel circuit 11c may be directly connected.

In some examples, as shown in FIG. 7B, the pattern of the first semiconductor layer of the first pixel circuit 11a is taken as an example for description. The first active layer 310a and the fourth active layer 340a of the first pixel circuit 11a may be located on a side of the third active layer 330a along the second direction Y, and the fifth active layer 350a, the sixth active layer 360a, the seventh active layer 370a, and the eighth active layer 380a may be located on a side of the third active layer 330a along an opposite direction of the second direction Y. The first active layer 310a and the seventh active layer 370a may be aligned in the second direction Y. In some examples, the third active layer 330a may be substantially u-shaped, the fourth active layer 340a, the sixth active layer 360a, the seventh active layer 370a, and the eighth active layer 380a may be substantially I-shaped, and the fifth active layer 350a may be substantially L-shaped. However, the embodiment is not limited thereto. An arrangement and a shape of the pattern of the first semiconductor layer of the first pixel circuits 11b and 11c are similar to an arrangement and a shape of the pattern of the first semiconductor layer of the first pixel circuit 11a and therefore will not be repeated here.

In some examples, an active layer of each transistor may include: a first region, a second region, and a channel region located between the first region and the second region. Among them, a material of the first semiconductor layer may include, for example, polysilicon. The channel region may not be doped with an impurity, and has characteristics of a semiconductor. The first region and the second region may be doped regions on both sides of the channel region, and are doped with impurities, and thus have conductivity. The impurities may be changed according to a type of the transistor. In some examples, a doped region of an active layer may be interpreted as a source electrode or a drain electrode of a transistor. A part of the active layer between transistors may be interpreted as a wiring doped with an impurity, and may be used for electrically connecting the transistors. The embodiment is not limited thereto.

(3) A first conductive layer is formed. In some examples, a first insulation thin film and a first conductive thin film are deposited sequentially on the base substrate on which the aforementioned structures are formed, and the first conductive thin film is patterned through a patterning process to form a first insulation layer and a first conductive layer disposed on the first insulation layer. In some examples, the first conductive layer may also be referred to as a first gate metal layer and the first insulation layer may also be referred to as a first gate insulation layer.

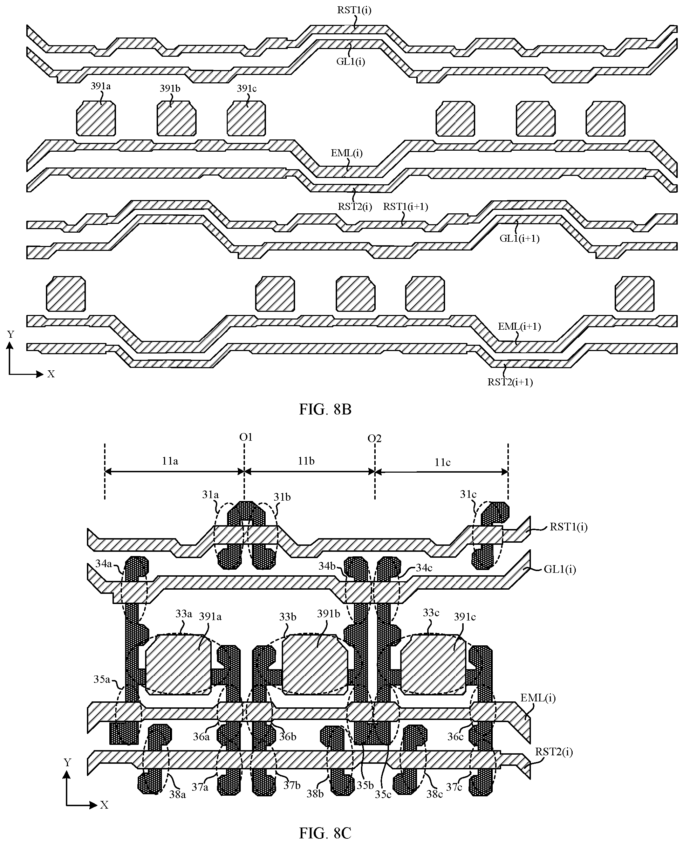

FIG. 8A is a schematic diagram of a first display region after a first conductive layer is formed in FIG. 6. FIG. 8B is a schematic diagram of a first conductive layer in FIG. 8A. FIG. 8C is a schematic diagram of a circuit island region in FIG. 8A.

In some examples, as shown in FIGs. 8A to 8C, the first conductive layer of the first display region may at least include multiple first scan lines (e.g., including first scan lines GL1(i) and GL1(i+1)), multiple light emitting control lines (e.g., including light emitting control lines EML(i) and EML(i+1)), multiple first reset control lines (e.g., including first reset control lines RST1(i) and RST1(i+1)), multiple second reset control lines (e.g., including second reset control lines RST2(i) and RST2(i+1)), and first electrodes of storage capacitors of multiple first pixel circuits (e.g., including first electrodes 391a, 391b, and 391c)).

In some examples, the first scan line GL1(i) may be located on a side of a first electrode (e.g., 391a, 391b, and 391c) of a storage capacitor of a first pixel circuit in the second direction Y, and the first reset control line RST1(i) may be located on a side of the first scan line GL1(i) in the second direction Y. The light emitting control line EML(i) may be located on a side of the first electrode (e.g., 391a, 391b, and 391c) of the storage capacitor of the first pixel circuit in an opposite direction of the second direction Y, and the second reset control line RST2(i) may be located on a side of the light emitting control line EML(i) in the opposite direction of the second direction Y.

In some examples, the first reset control line RST1(i), the first scan line GL1(i), the second reset control line RST2(i), and the light emitting control line EML(i) may bypass an interval region between adjacent circuit island regions in the first direction X by bending. For example, the first reset control line RST1(i) and the first scan line GL1(i) may bypass from an interval region of a circuit island region on a side along the second direction Y, and the second reset control line RST2(i) and the light emitting control line EML(i) may bypass from the interval region on a side along an opposite direction of the second direction Y. In the example, it is beneficial to improve a light transmittance of the first display region by arranging a trace of the first conductive layer to be bent to bypass an interval region between circuit island regions.

In some examples, a shape of the first reset control line RST1(i) may be substantially a polyline shape extending along the first direction X. In a circuit island region, an overlapping region of the first reset control line RST1(i) and first active layers of three first pixel circuits may serve as gates of first transistors of the three first pixel circuits (including, for example, a gate of the first transistor 31a, a gate of the first transistor 31b, and a gate of the first transistor 31c).

In some examples, a shape of the first scan line GL1(i) may be substantially a polyline shape extending along the first direction X. In a circuit island region, an overlapping region of the first scan line GL1(i) and fourth active layers of three first pixel circuits may serve as gates of fourth transistors of the three first pixel circuits (including, for example, a gate of the fourth transistor 34a, a gate of the fourth transistor 34b, and a gate of the fourth transistor 34c).

In some examples, a shape of the light emitting control line EML(i) may be substantially a polyline shape extending along the first direction X. In a circuit island region, an overlapping region of the light emitting control line EML(i) and fifth active layers of three first pixel circuits may serve as gates of fifth transistors of the three first pixel circuits (e.g., including gates of the fifth transistors 35a, 35b, and 35c), and an overlapping region of the light emitting control line EML(i) and sixth active layers of the three first pixel circuits may serve as gates of sixth transistors of the three first pixel circuits (e.g., including gates of the sixth transistors 36a, 36b, and 36c).

In some examples, a shape of the second reset control line RST2(i) may be substantially a polyline shape extending along the first direction X. In a circuit island region, an overlapping region of the second reset control line RST2(i) and seventh active layers of three first pixel circuits may serve as gates of seventh transistors of the three first pixel circuits (e.g., including gates of the seventh transistors 37a, 37b, and 37c), and an overlapping region of the second reset control line RST2(i) and eighth active layers of the three first pixel circuits may serve as gates of eighth transistors of the three first pixel circuits (e.g., including gates of the eighth transistors 38a, 38b, and 38c).

In some examples, the first electrode 391a of the storage capacitor of the first pixel circuit 11a may simultaneously serve as a gate of the third transistor 33a, the first electrode 391b of the storage capacitor of the first pixel circuit 11b may simultaneously serve as a gate of the third transistor 33b, and the first electrode 391c of the storage capacitor of the first pixel circuit 11c may simultaneously serve as a gate of the third transistor 33c. Orthographic projections of the first electrodes 391a, 391b, and 391c on the base substrate may be substantially in a shape of a rectangle, for example, a rounded rectangle or a rectangle with chamfers. The embodiment is not limited thereto.

(4) A second conductive layer is formed. In some examples, a second insulation thin film and a second conductive thin film are deposited sequentially on the base substrate on which the aforementioned structures are formed, and the second conductive thin film is patterned through a patterning process to form a second insulation layer and a second conductive layer disposed on the second insulation layer. In some examples, the second conductive layer may also be referred to as a second gate metal layer and the second insulation layer may also be referred to as a second gate insulation layer.

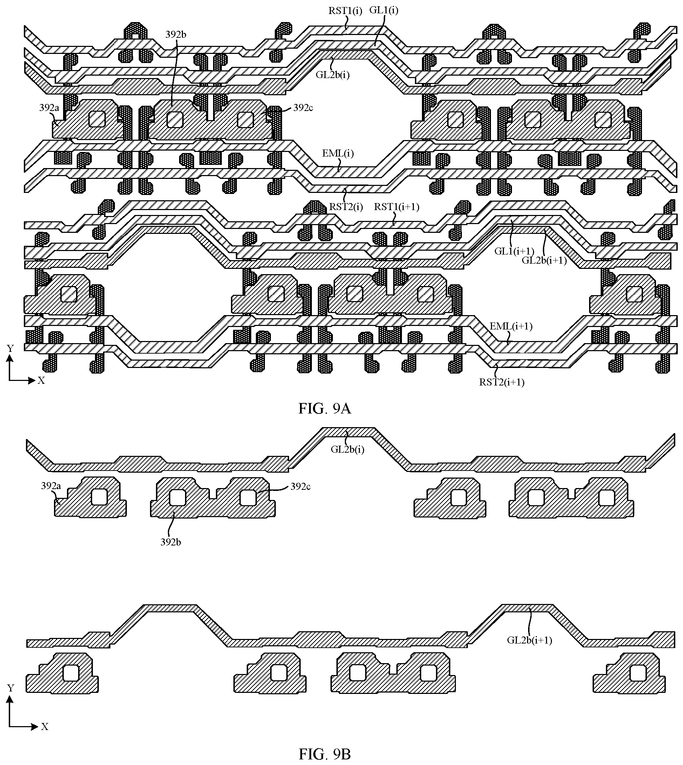

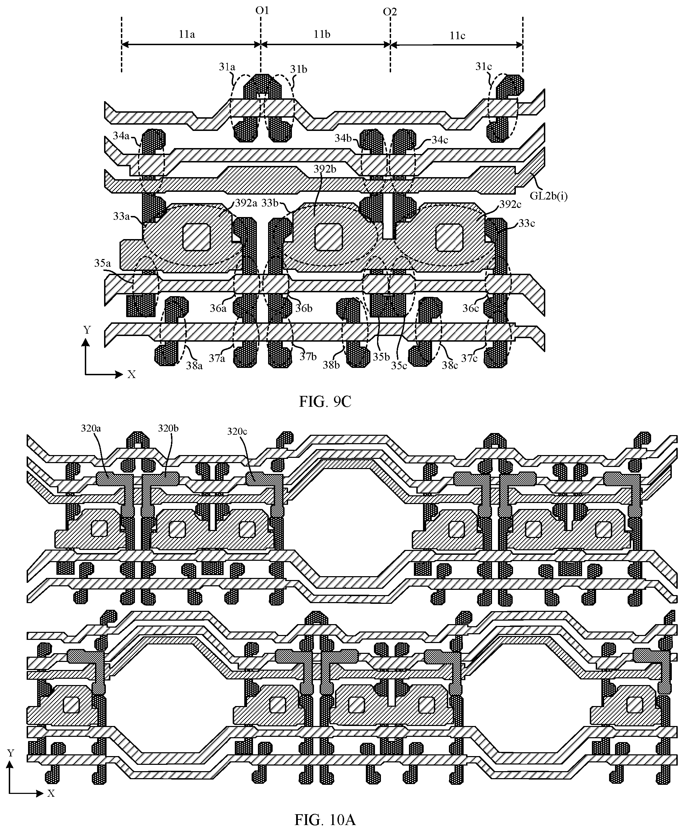

FIG. 9A is a schematic diagram of a first display region after a second conductive layer is formed in FIG. 6. FIG. 9B is a schematic diagram of a second conductive layer in FIG. 9A. FIG. 9C is a schematic diagram of a circuit island region in FIG. 9A.

In some examples, as shown in FIGs. 9A to 9C, the second conductive layer of the first display region may at least include multiple second scan auxiliary lines (e.g., including second scan auxiliary lines GL2b(i) and GL2b(i+1)), second electrodes of storage capacitors of multiple first pixel circuits (e.g., including second electrodes 392a, 392b, and 392c).

In some examples, a shape of the second scan auxiliary line GL2b(i) may be substantially a polyline shape extending along the first direction X. In a circuit island region, the second scan auxiliary line GL2b(i) may be located on a side of a second electrode (e.g., 392a, 392b, and 392c) of a storage capacitor of a first pixel circuit in the second direction Y. The second scan auxiliary line GL2b(i) may bypass an interval region of the circuit island region from a side of the second direction Y and is located on a side of the first scan line GL1(i) along an opposite direction of the second direction Y.

In some examples, within a circuit island region, an orthographic projection of a second electrode of a storage capacitor of each first pixel circuit on the base substrate may be substantially a rectangular structure having a hollow region, an orthographic projection of the hollow region on the base substrate may be substantially in a shape of a rectangle, and the rectangle may have rounded corners or chamfers. The second electrode 392b of the storage capacitor of the first pixel circuit 11b and the second electrode 392c of the storage capacitor of the first pixel circuit 11c may be of an interconnected integrated structure. The second electrodes 392a and 392b may be substantially symmetrical about a first centerline O1, and the second electrodes 392b and 392c may be substantially symmetrical about a second centerline O2.

(5) A second semiconductor layer is formed. In some examples, a third insulation thin film and a second semiconductor thin film are sequentially deposited on the base substrate on which the aforementioned patterns are formed, and the second semiconductor thin film is patterned through a patterning process to form a third insulation layer and a second semiconductor layer disposed on the third insulation layer. In some examples, a material of the second semiconductor layer may include Indium Gallium Zinc Oxide (IGZO). In some examples, the third insulation layer may also be referred to as a third gate insulation layer.

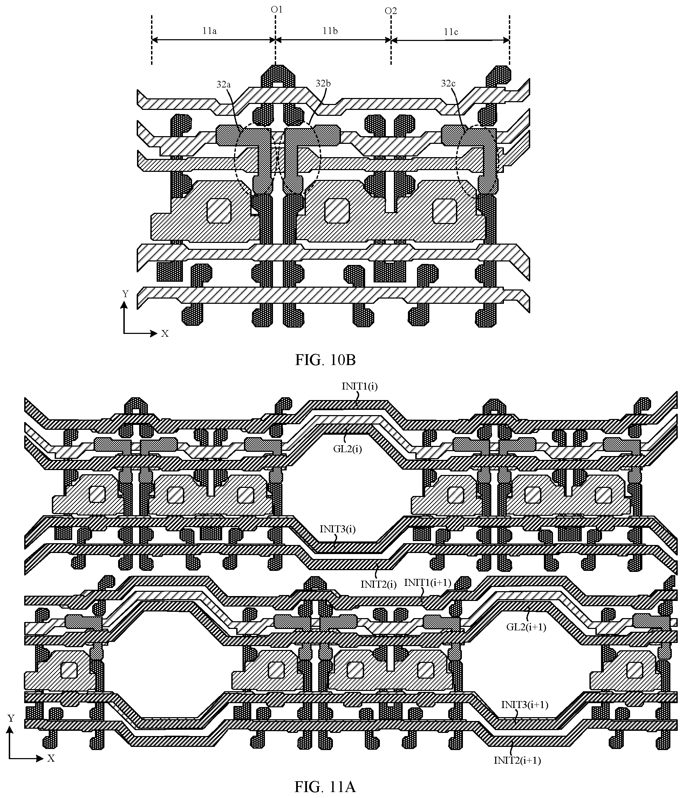

FIG. 10A is a schematic diagram of a first display region after a second semiconductor layer is formed in FIG. 6. FIG. 10B is a schematic diagram of a circuit island region in FIG. 10A.

In some examples, as shown in FIGs. 10A and 10B, the second semiconductor layer of the first display region may at least include active layers of second type transistors of multiple first pixel circuits (e.g., a second active layer 320a of a second transistor 32a of the first pixel circuit 11a, a second active layer 320b of a second transistor 32b of the first pixel circuit 11b, a second active layer 320c of a second transistor 32c of the first pixel circuit 11c).

In some examples, within a circuit island region, the pattern of the second semiconductor layer of the first pixel circuits 11a and 11b may be substantially symmetrical about a first centerline O1, and the pattern of the second semiconductor layer of the first pixel circuits 11b and 11c may be substantially symmetrical about a second centerline O2.

In some examples, the second active layers 320a, 320b, and 320c may be substantially L-shaped. An overlapping region of the second scan auxiliary line GL2b(i) and the second active layer 320a may serve as a bottom gate of the second transistor 32a, an overlapping region of the second scan auxiliary line GL2b(i) and the second active layer 320b may serve as a bottom gate of the second transistor 32b, and an overlapping region of the second scan auxiliary line GL2b(i) and the second active layer 320c may serve as a bottom gate of the second transistor 32c.

(6) A third conductive layer is formed. In some examples, a fourth insulation thin film and a third conductive thin film are sequentially deposited on the base substrate on which the aforementioned patterns are formed, and the third conductive thin film is patterned through a patterning process to form a fourth insulation layer and a third conductive layer disposed on the fourth insulation layer. In some examples, the third conductive layer may also be referred to as a third gate metal layer and the fourth insulation layer may also be referred to as a fourth gate insulation layer.

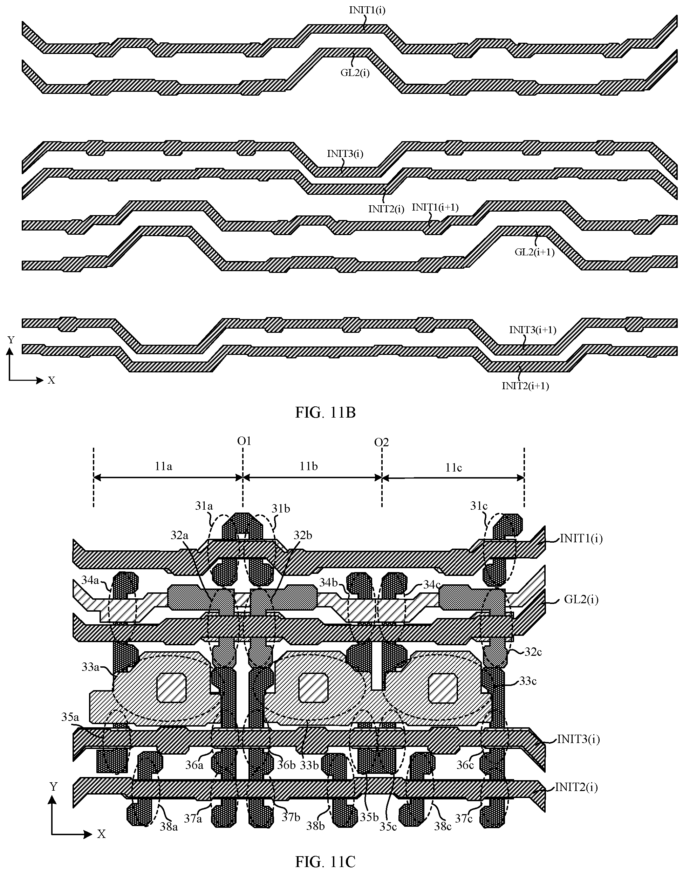

FIG. 11A is a schematic diagram of a first display region after a third conductive layer is formed in FIG. 6. FIG. 11B is a schematic diagram of a third conductive layer in FIG. 11A. FIG. 11C is a schematic diagram of a circuit island region in FIG. 11A.

In some examples, the third conductive layer of the first display region may at least include multiple second scan lines (e.g., including second scan lines GL2(i) and GL2(i+1)), multiple first initial signal lines (e.g., including first initial signal lines INIT1(i) and INIT1(i+1)), multiple second initial signal lines (e.g., including second initial signal lines INIT2(i) and INIT2(i+1)), and multiple third initial signal lines (e.g., including third initial signal lines INIT3(i) and INIT3(i+1)). Shapes of the first initial signal lines, the second scan lines, the second initial signal lines, and the third initial signal lines may each be substantially a polyline shape extending along the first direction X.

In some examples, within a circuit island region, the first initial signal line INIT1(i) may be located on a side of the second scan line GL2(i) in the second direction Y, the third initial signal line INIT3(i) and the second initial signal line INIT2(i) may be located on a side of the second scan line GL2(i) in an opposite direction of the second direction Y, and the second initial signal line INIT2(i) may be located on a side of the third initial signal line INIT3(i) in the opposite direction of the second direction Y.

In some examples, an orthographic projection of the first initial signal line INIT1(i) on the base substrate and an orthographic projection of the first reset control line RST1(i) on the base substrate may be at least partially overlapped. For example, an orthographic projection of the first initial signal line INIT1(i) on the base substrate may contain an orthographic projection of the first reset control line RST1(i) on the base substrate. An orthographic projection of the second scan line GL2(i) on the base substrate and an orthographic projection of the second scan auxiliary line GL2b(i) on the base substrate may be at least partially overlapped. For example, an orthographic projection of the second scan line GL2(i) on the base substrate may contain an orthographic projection of the second scan auxiliary line GL2b(i) on the base substrate. An orthographic projection of the third initial signal line INIT3(i) on the base substrate and an orthographic projection of the light emitting control line EML(i) on the base substrate may be at least partially overlapped. For example, an orthographic projection of the third initial signal line INIT3(i) on the base substrate may contain an orthographic projection of the light emitting control line EML(i) on the base substrate. An orthographic projection of the second initial signal line INIT2(i) on the base substrate and an orthographic projection of the second reset control line RST2(i) on the base substrate may be at least partially overlapped. For example, an orthographic projection of the second initial signal line INIT2(i) on the base substrate may contain an orthographic projection of the second reset control line RST2(i) on the base substrate. In the example, traces of different conductive layers (for example, the first conductive layer, the second conductive layer, and the third conductive layer) are stacked to avoid occupying too much trace space, which is beneficial to saving wiring space, thereby improving a light transmittance of the first display region.

(7) A fifth insulation layer is formed. In some examples, a fifth insulation thin film is deposited on the base substrate on which the aforementioned patterns are formed, and the fifth insulation thin film is patterned through a patterning process to form a fifth insulation layer. In some examples, the fifth insulation layer may also be referred to as an interlayer dielectric layer.

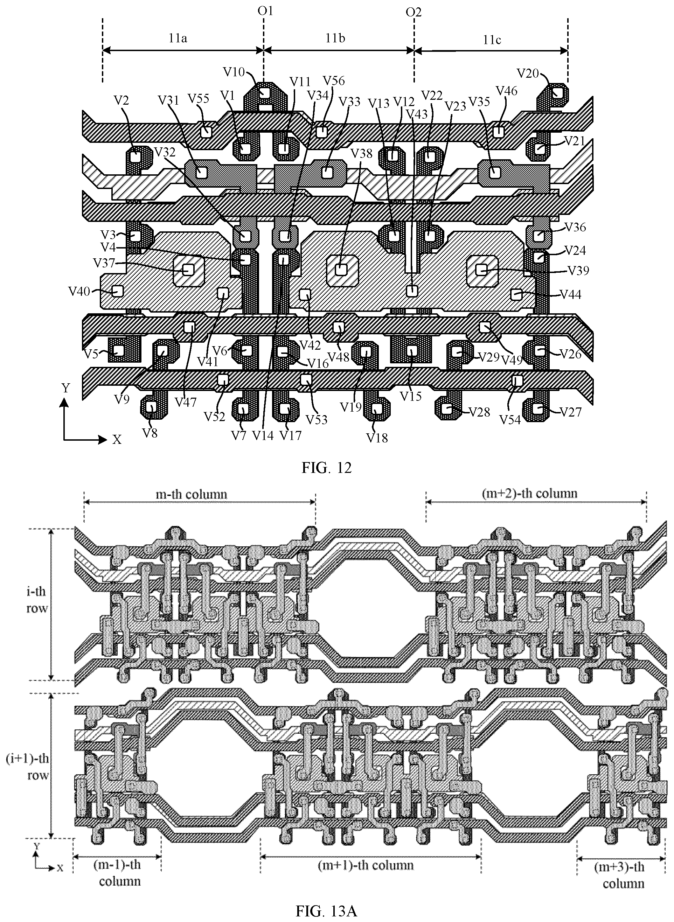

FIG. 12 is a schematic diagram of a circuit island region after a fifth insulation layer is formed in FIG. 6. In some examples, as shown in FIG. 12, the fifth insulation layer of the first display region may be provided with multiple vias, for example, may include a first vias V1 to a twenty-fourth via V24, a twenty-sixth via V26 to a twenty-ninth via V29, a thirty-first via V31 to a forty-fourth via V44, a forty-sixth via V46 to a forty-ninth via V49, and a fifty-second via V52 to a fifty-sixth via V56.

In some examples, the fifth insulation layer, the fourth insulation layer, the third insulation layer, the second insulation layer, and the first insulation layer within the first via V1 to the twenty-fourth via V24 and the twenty-sixth via V26 to the twenty-ninth via V29 may be removed, exposing part of a surface of the first semiconductor layer. The fifth insulation layer and the fourth insulation layer within the thirty-first via V31 to the thirty-sixth via V36 may be removed, exposing part of a surface of the second semiconductor layer. The fifth insulation layer, the fourth insulation layer, the third insulation layer, and the second insulation layer within the thirty-seventh via V37 to the thirty-ninth via V39 may be removed, exposing part of a surface of the first conductive layer. The fifth insulation layer, the fourth insulation layer, and the third insulation layer within the fortieth via V40 to the forty-fourth via V44 may be removed, exposing part of a surface of the second conductive layer. The fifth insulation layer within the forty-sixth via V46 to the forty-ninth via V49 and the fifty-second via V52 to the fifty-sixth via V56 may be removed, exposing part of a surface of the third conductive layer.

(8) A fourth conductive layer is formed. In some examples, a fourth conductive thin film is deposited on the base substrate on which the aforementioned patterns are formed, and the fourth insulation thin film is patterned through a patterning process to form the fourth conductive layer on the fifth insulation layer. In some examples, the fourth conductive layer may also be referred to as a first source-drain metal layer.

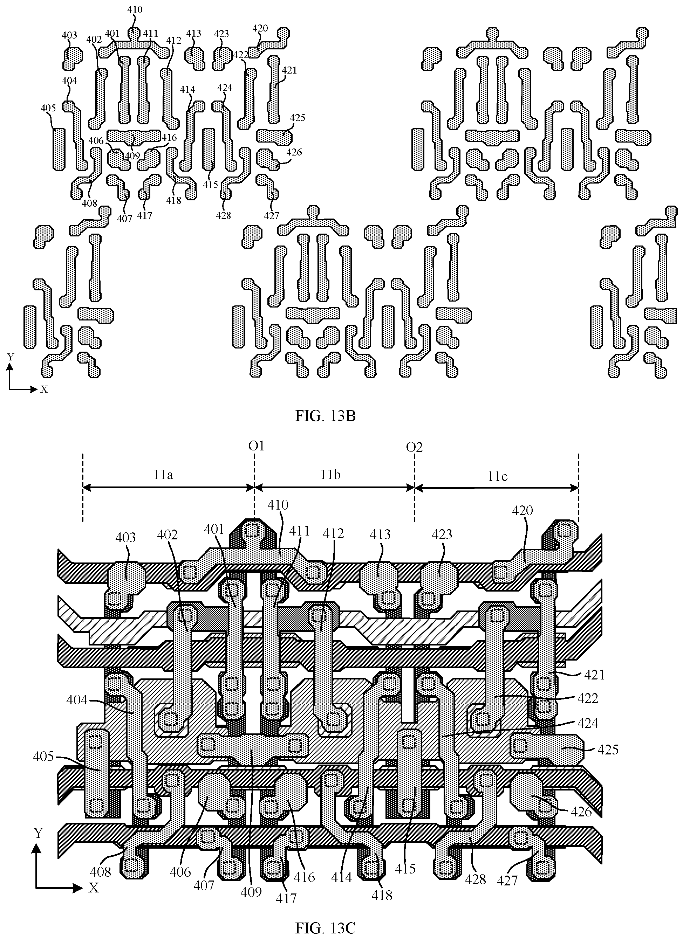

FIG. 13A is a schematic diagram of a first display region after a fourth conductive layer is formed in FIG. 6. FIG. 13B is a schematic diagram of the fourth conductive layer in FIG. 13A. FIG. 13C is a schematic diagram of a circuit island region in FIG. 13A.

In some examples, as shown in FIGs. 13A to 13C, the fourth conductive layer of the first display region may at least include multiple connection electrodes (e.g., including a first connection electrode 401 to an eighteenth connection electrode 418 and a twentieth connection electrode 420 to a twenty-eighth connection electrode 428).

In some examples, a shape of the first connection electrode 401 may be substantially a strip structure extending along the second direction Y. One terminal of the first connection electrode 401 may be electrically connected with the first active layer 310a of the first transistor 31a of the first pixel circuit 11a through the first via V1, the other terminal may be electrically connected with the second active layer 320a of the second transistor 32a of the first pixel circuit 11a through the thirty-second via V32, and electrically connected with the sixth active layer 360a of the sixth transistor 36a of the first pixel circuit 11a through the fourth via V4. The first connection electrode 401 is electrically connected with a second electrode of the first transistor 31a, a second electrode of the second transistor 32a, a second electrode of the third transistor 33a, and a first electrode of the sixth transistor 36a, and may serve as a third node of the first pixel circuit 11a.

In some examples, a shape of the second connection electrode 402 may be substantially a strip structure extending along the second direction Y. One terminal of the second connection electrode 402 may be electrically connected with the second active layer 320a of the second transistor 32a of the first pixel circuit 11a through the thirty-first via V31, and the other terminal may also be electrically connected with the first electrode 391a of the storage capacitor of the first pixel circuit 11a through the thirty-seventh via V37. The second connection electrode 402 is electrically connected with a first electrode of the second transistor 32a, a gate of the third transistor 33a, and a first electrode 391a of the storage capacitor, and may serve as a first node of the first pixel circuit 11a.

In some examples, a shape of the third connection electrode 403 may be substantially a rectangle. The third connection electrode 403 may be electrically connected with the fourth active layer 340a of the fourth transistor 34a of the first pixel circuit 11a through the second via V2.

In some examples, a shape of the fourth connection electrode 404 may be substantially a polyline shape extending along the second direction Y. One terminal of the fourth connection electrode 404 may be electrically connected with the third active layer 330a of the third transistor 33a of the first pixel circuit 11a through the third via V3, and the other terminal may be electrically connected with the eighth active layer 380a of the eighth transistor 38a of the first pixel circuit 11a through the ninth via V9. The fourth connection electrode 404 is electrically connected with a first electrode of the third transistor 33a, a second electrode of the fourth transistor 34a, a second electrode of the fifth transistor 35a, and a first electrode of the eighth transistor 38a, and may serve as a second node of the first pixel circuit 11a.

In some examples, a shape of the fifth connection electrode 405 may be substantially a strip structure extending along the second direction Y. One terminal of the fifth connection electrode 405 may be electrically connected with the fifth active layer 350a of the fifth transistor 35a of the first pixel circuit 11a through the fifth via V5, and the other terminal may be electrically connected with the second electrode 392a of the storage capacitor of the first pixel circuit 11a through the fortieth via V40.

In some examples, a shape of the sixth connection electrode 406 may be substantially a rectangle. The sixth connection electrode 406 may be electrically connected with the sixth active layer 360a of the sixth transistor 36a of the first pixel circuit 11a through the sixth via V6.

In some examples, the seventh connection electrode 407 may be substantially dumbbell-shaped. One terminal of the seventh connection electrode 407 may be electrically connected with the seventh active layer 370a of the seventh transistor 37a of the first pixel circuit 11a through the seventh via V7, and the other terminal may be electrically connected with the second initial signal line INIT2(i) through the fifty-second via V52.

In some examples, a shape of the eighth connection electrode 408 may be substantially a polyline shape extending along the second direction Y. One terminal of the eighth connection electrode 408 may be electrically connected with the eighth active layer 380a of the eighth transistor 38a of the first pixel circuit 11a through the eighth via V8, and the other terminal may be electrically connected with the third initial signal line INIT3(i) through the forty-seventh via V47.

In some examples, a shape of the ninth connection electrode 409 may be substantially a strip structure extending along the first direction X. One terminal of the ninth connection electrode 409 may be electrically connected with the second electrode 392a of the storage capacitor of the first pixel circuit 11a through the forty-first via V41, and the other terminal may be electrically connected with the second electrode 392b of the storage capacitor of the first pixel circuit 11b through the forty-second via V42.

In some examples, a shape of the tenth connection electrode 410 may be substantially an arch extending along the first direction X. Two terminals of the tenth connection electrode 410 may be electrically connected with the first initial signal line INIT1(i) through the fifty-fifth via V55 and the fifty-sixth via V56, respectively, and the other terminal may be electrically connected with an integrated structure of the first active layer 310a of the first pixel circuit 11a and the first active layer 310b of the first pixel circuit 11b through the tenth via V10.

In some examples, a shape of the eleventh connection electrode 411 may be substantially a strip structure extending along the second direction Y. One terminal of the eleventh connection electrode 411 may be electrically connected with the first active layer 310b of the first transistor 31b of the first pixel circuit 11b through the eleventh via V11, the other terminal may be electrically connected with the second active layer 320b of the second transistor 32b of the first pixel circuit 11b through the thirty-fourth via V34, and electrically connected with the sixth active layer 360b of the sixth transistor 36b of the first pixel circuit 11b through the fourteenth via V14. The eleventh connection electrode 411 is electrically connected with a second electrode of the first transistor 31b, a second electrode of the second transistor 32b, a second electrode of the third transistor 33b, and a first electrode of the sixth transistor 36b, and may serve as a third node of the first pixel circuit 11b.

In some examples, a shape of the twelfth connection electrode 412 may be substantially a strip structure extending along the second direction Y. One terminal of the twelfth connection electrode 412 may be electrically connected with the second active layer 320b of the second transistor 32b of the first pixel circuit 11b through the thirty-third via V33, and the other terminal may also be electrically connected with the first electrode 391b of the storage capacitor of the first pixel circuit 11b through the thirty-eighth via V38. The twelfth connection electrode 412 is electrically connected with a first electrode of the second transistor 32b, a gate of the third transistor 33b, and a first electrode 391b of the storage capacitor, and may serve as a first node of the first pixel circuit 11b.

In some examples, a shape of the thirteenth connection electrode 413 may be substantially a rectangle. The thirteenth connection electrode 413 may be electrically connected with the fourth active layer 340b of the fourth transistor 34b of the first pixel circuit 11b through the twelfth via V12.

In some examples, a shape of the fourteenth connection electrode 414 may be substantially a polyline shape extending along the second direction Y. One terminal of the fourteenth connection electrode 414 may be electrically connected with the third active layer 330b of the third transistor 33b of the first pixel circuit 11b through the thirteenth via V13, and the other terminal may be electrically connected with the eighth active layer 380b of the eighth transistor 38b of the first pixel circuit 11b through the nineteenth via V19. The fourteenth connection electrode 414 is electrically connected with a first electrode of the third transistor 33b, a second electrode of the fourth transistor 34b, a second electrode of the fifth transistor 35b, and a first electrode of the eighth transistor 38b, and may serve as a second node of the first pixel circuit 11b.

In some examples, a shape of the fifteenth connection electrode 415 may be substantially a strip structure extending along the second direction Y. One terminal of the fifteenth connection electrode 415 may be electrically connected with an integrated structure of the fifth active layer 350b of the fifth transistor 35b of the first pixel circuit 11b and the fifth active layer 350c of the fifth transistor 35c of the first pixel circuit 11c through the fifteenth via V15, and the other terminal may be electrically connected with an integrated structure of a second electrode 392b of the storage capacitor of the first pixel circuit 11b and a second electrode 392c of the storage capacitor of the first pixel circuit 11c through the forty-third via V43.

In some examples, a shape of the sixteenth connection electrode 416 may be substantially a rectangle. The sixteenth connection electrode 416 may be electrically connected with the sixth active layer 360b of the sixth transistor 36b of the first pixel circuit 11b through the sixteenth via V16.

In some examples, the seventeenth connection electrode 417 may be substantially dumbbell-shaped. One terminal of the seventeenth connection electrode 417 may be electrically connected with the seventh active layer 370b of the seventh transistor 37b of the first pixel circuit 11b through the seventeenth via V17, and the other terminal may be electrically connected with the second initial signal line INIT2(i) through the fifty-third via V53.

In some examples, a shape of the eighteenth connection electrode 418 may be substantially a polyline shape extending along the second direction Y. One terminal of the eighteenth connection electrode 418 may be electrically connected with the eighth active layer 380b of the eighth transistor 38b of the first pixel circuit 11b through the eighteenth via V18, and the other terminal may be electrically connected with the third initial signal line INIT3(i) through the forty-eighth via V48.

In some examples, a shape of the twentieth connection electrode 420 may be substantially a polyline shape extending along the first direction X. One terminal of the twentieth connection electrode 420 may be electrically connected with the first active layer 310c of the first transistor 31c of the first pixel circuit 11c through the twentieth via V20, and the other terminal may be electrically connected with the first initial signal line INIT1(i) through the forty-sixth via V46.

In some examples, a shape of the twenty-first connection electrode 421 may be substantially a strip structure extending along the second direction Y. One terminal of the twenty-first connection electrode 421 may be electrically connected with the first active layer 310c of the first transistor 31c of the first pixel circuit 11c through the twenty-first via V21, the other terminal may be electrically connected with the second active layer 320c of the second transistor 32c of the first pixel circuit 11c through the thirty-sixth via V36, and electrically connected with the sixth active layer 360c of the sixth transistor 36c of the first pixel circuit 11c through the twenty-fourth via V24. The twenty-first connection electrode 421 is electrically connected with a second electrode of the first transistor 31c, a second electrode of the second transistor 32c, a second electrode of the third transistor 33c, and a first electrode of the sixth transistor 36c, and may serve as a third node of the first pixel circuit 11c.

In some examples, a shape of the twenty-second connection electrode 422 may be substantially a strip structure extending along the second direction Y. One terminal of the twenty-second connection electrode 422 may be electrically connected with the second active layer 320c of the second transistor 32c of the first pixel circuit 11c through the thirty-fifth via V35, and the other terminal may be electrically connected with the first electrode 391c of the storage capacitor of the first pixel circuit 11c through the thirty-ninth via V39. The twenty-second connection electrode 422 is electrically connected with a first electrode of the second transistor 32c, a gate of the third transistor 33c, and a first electrode 391c of the storage capacitor, and may serve as a first node of the first pixel circuit 11c.

In some examples, a shape of the twenty-third connection electrode 423 may be substantially a rectangle. The twenty-third connection electrode 423 may be electrically connected with the fourth active layer 340c of the fourth transistor 34c of the first pixel circuit 11c through the twenty-second via V22.

In some examples, a shape of the twenty-fourth connection electrode 424 may be substantially a polyline shape extending along the second direction Y. One terminal of the twenty-fourth connection electrode 424 may be electrically connected with the third active layer 330c of the third transistor 33c of the first pixel circuit 11c through the twenty-third via V23, and the other terminal may be electrically connected with the eighth active layer 380c of the eighth transistor 38c of the first pixel circuit 11c through the twenty-ninth via V29. The twenty-fourth connection electrode 424 is electrically connected with a first electrode of the third transistor 33c, a second electrode of the fourth transistor 34c, a second electrode of the fifth transistor 35c, and a first electrode of the eighth transistor 38c, and may serve as a second node of the first pixel circuit 11c.

In some examples, a shape of the twenty-fifth connection electrode 425 may be substantially a strip structure extending along the first direction X. The twenty-fifth connection electrode 425 may be electrically connected with the second electrode 392c of the storage capacitor of the first pixel circuit 11c through the forty-fourth via V44.

In some examples, a shape of the twenty-sixth connection electrode 426 may be substantially a rectangle. The twenty-sixth connection electrode 426 may be electrically connected with the sixth active layer 360c of the sixth transistor 36c of the first pixel circuit 11c through the twenty-sixth via V26.

In some examples, the twenty-seventh connection electrode 427 may be substantially dumbbell-shaped. One terminal of the twenty-seventh connection electrode 427 may be electrically connected with the seventh active layer 370c of the seventh transistor 37c of the first pixel circuit 11c through the twenty-seventh via V27, and the other terminal may be electrically connected with the second initial signal line INIT2(i) through the fifty-fourth via V54.

In some examples, a shape of the twenty-eighth connection electrode 428 may be substantially a polyline shape extending along the second direction Y. One terminal of the twenty-eighth connection electrode 428 may be electrically connected with the eighth active layer 380c of the eighth transistor 38c of the first pixel circuit 11c through the twenty-eighth via V28, and the other terminal may be electrically connected with the third initial signal line INIT3(i) through the forty-ninth via V49.

In some examples, within a circuit island region, the first pixel circuits 11a and 11b may be substantially symmetrical with respect to the first centerline O1, and the first pixel circuits 11b and 11c may be substantially symmetrical with respect to the second centerline O2. In the example, any two adjacent first pixel circuits within the circuit island region may be disposed substantially symmetrically with respect to their centerline, thereby facilitating saving of space occupied by circuits.

In some examples, first pixel circuits with a row of circuit island regions arranged along the first direction X may be aligned in the first direction X, and first pixel circuits of a row of circuit island regions arranged along the second direction Y may be dislocated in the second direction Y. For example, an interval region between two adjacent circuit island regions in one row of circuit island regions may be disposed in alignment with a second first pixel circuit of one circuit island region in a next row of circuit island regions in the second direction Y. The example illustrates three circuit island regions of a m-th column and an i-th row, an (m+2)-th column and the i-th row, and an (m+1)-th column and a (i+1)-th row, a third first pixel circuit in a circuit island region of an (m-1)-th column and the (i+1)-th row, and a first first pixel circuit in a circuit island region of the (m+1)-th column and the (i+1)-th row.

(9) A sixth insulation layer and a seventh insulation layer are formed. In some examples, a sixth insulation thin film is deposited on the base substrate on which the aforementioned patterns are formed, and then a seventh insulation thin film is coated, and the seventh insulation thin film and the sixth insulation thin film are patterned through a patterning process to form the sixth insulation layer and the seventh insulation layer. In some examples, the sixth insulation layer may also be referred to as a passivation layer and the seventh insulation layer may also be referred to as a first planarization layer.

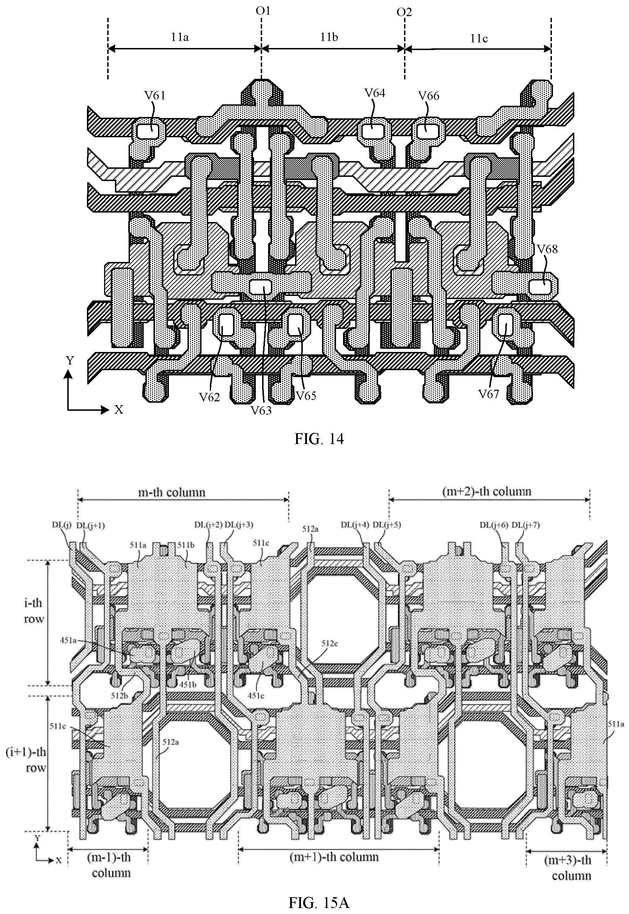

FIG. 14 is a schematic diagram of a circuit island region after a seventh insulation layer is formed in FIG. 6. In some examples, as shown in FIG. 14, the seventh insulation layer of the first display region may be provided with multiple vias, which may include, for example, a sixty-first via V61 to a sixty-eighth via V68. The seventh insulation layer and the sixth insulation layer within the sixty-first via V61 to the sixty-eighth via V68 may be removed, exposing part of a surface of the fourth conductive layer.

(10) A fifth conductive layer is formed. In some examples, a fifth conductive thin film is deposited on the base substrate on which the aforementioned patterns are formed, the fifth conductive thin film is patterned through a patterning process to form a fifth conductive layer on the seventh insulation layer. In some examples, the fifth conductive layer may also be referred to as a second source-drain metal layer.

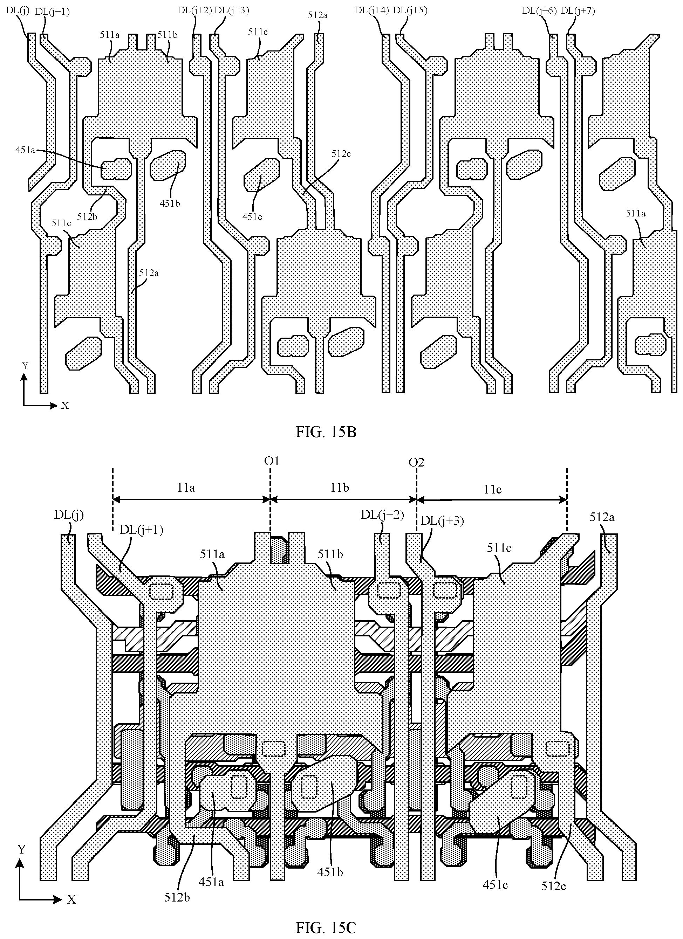

FIG. 15A is a schematic diagram of a first display region after a fifth conductive layer is formed in FIG. 6. FIG. 15B is a schematic diagram of the fifth conductive layer in FIG. 15A. FIG. 15C is a schematic diagram of a circuit island region in FIG. 15A.

In some examples, as shown in FIGs. 15A to 15C, the fifth conductive layer of the first display region may at least include multiple data lines (e.g., including data lines DL(j), DL(j+1), DL(j+2), DL(j+3), DL(j+4), DL(j+5), DL(j+6), and DL(j+7)), multiple first anode connection electrodes (e.g., including first anode connection electrodes 451a, 451b, and 451c), multiple first shield electrodes (e.g., including first shield electrodes 511a, 511b, and 511c), and multiple first power supply connection lines (e.g., including first power supply connection lines 512a, 512b, and 512c).

In some examples, the multiple data lines may be substantially in a polyline shape extending along the second direction Y. The data lines DL(j) and DL(j+1) may be adjacent, and the data lines DL(j+2) and DL(j+3) may be adjacent. The data line DL(j+1) may be electrically connected with the third connection electrode 403 through the sixty-first via V61 to achieve an electrical connection with a first electrode of the fourth transistor 34a of the first pixel circuit 11a. The data line DL(j+2) may be electrically connected with the thirteenth connection electrode 413 through the sixty-fourth via V64 to achieve an electrical connection with a first electrode of the fourth transistor 34b of the first pixel circuit 11b. The data line DL(j+3) may be electrically connected with the twenty-third connection electrode 423 through the sixty-sixth via V66 to achieve an electrical connection with a first electrode of the fourth transistor 34c of the first pixel circuit 11c.

In some examples, four data lines may be disposed penetrating through each circuit island region, and three of the four data lines may be electrically connected with three first pixel circuits in the circuit island region, respectively. Four data lines DL(j), DL(j+1), DL(j+2), and DL(j+3) may penetrate through a circuit island region of an i-th row and an m-th column, wherein three data lines DL(j+1), DL(j+2), and DL(j+3) may be electrically connected with three first pixel circuits in the circuit island region of the i-th row and the m-th column, respectively. Four data lines DL(j+4), DL(j+5), DL(j+6), and DL(j+7) may penetrate through a circuit island region of the i-th row and an (m+2)-th column, wherein three data lines DL(j+5), DL(j+6), and DL(j+7) may be electrically connected with three first pixel circuits in the circuit island region of the i-th row and the (m+2)-th column, respectively. Four data lines DL(j+2), DL(j+3), DL(j+4), and DL(j+5) may penetrate through a circuit island region of an (i+1)-th row and an (m+1)-th column, wherein three data lines DL(j+3), DL(j+4), and DL(j+5) may be electrically connected with three first pixel circuits in the circuit island region of the (i+1)-th row and the (m+1)-th column, respectively. Among them, the data lines DL(j), DL(j+2), DL(j+4), and DL(j+6) may be configured to provide a data signal to a first pixel circuit (e.g., the first pixel circuit 11b) connected with a first light emitting element emitting light of a third color. The data lines DL(j), DL(j+2), DL(j+4), and DL(j+6) may be configured to provide data signals to multiple first pixel circuits disposed every other row. For example, the data lines DL(j) and DL(j+4) are not electrically connected with a first pixel circuit in a circuit island region of an i-th row, but are electrically connected with a first pixel circuit in a circuit island region of an (i+1)-th row; and the data lines DL(j+2) and DL(j+6) are electrically connected with a first pixel circuit in a circuit island region of the i-th row, but are not electrically connected with a first pixel circuit in a circuit island region of the (i+1)-th row. In the example, a data line providing a data signal to a first pixel circuit (for example, the first pixel circuit 11b) connected with a first light emitting element emitting light of a third color is electrically connected with multiple first pixel circuits disposed every other row to provide a data signal to the multiple first pixel circuits disposed every other row. An arrangement mode of data lines in the example is beneficial to a trace arrangement.

In some examples, shapes of the first shield electrodes 511a, 511b, and 511c may be irregular polygons. The first shield electrodes 511a and 511b may be substantially symmetrical with respect to the first centerline O1 and the first shield electrodes 511b and 511c may be substantially symmetrical with respect to the second centerline O2. The first shield electrodes 511a and 511b may be of an interconnected integrated structure. The first shield electrodes 511a and 511b may be located between the data lines DL(j+1) and DL(j+2). The integrated structure of the first shield electrodes 511a and 511b may be electrically connected with the ninth connection electrode 409 through the sixty-third via V63, which achieves an electrical connection with second electrodes of storage capacitors of the first pixel circuits 11b and 11c. The first shield electrode 511c may be located on a side of the data line DL(j+3) away from the data line DL(j+2). The first shield electrode 511c may be electrically connected with the twenty-fifth connection electrode 425 through the sixty-eighth via V68, which achieves an electrical connection with the second electrode of the storage capacitor of the first pixel circuit 11c.

In some examples, an orthographic projection of the first shield electrode 511a on the base substrate may cover an orthographic projection of the second connection electrode 402 on the base substrate, which may achieve shielding of the first node of the first pixel circuit 11a; an orthographic projection of the first shield electrode 511b on the base substrate may cover an orthographic projection of the twelfth connection electrode 412 on the base substrate, which may achieve shielding of the first node of the first pixel circuit 11b; an orthographic projection of the first shield electrode 511c on the base substrate may cover an orthographic projection of the twenty-second connection electrode 422 on the base substrate, which may achieve shielding of the first node of the first pixel circuit 11c, thereby shielding an influence of remaining signals on first nodes of the first pixel circuits 11a, 11b, and 11c.

In some examples, an orthographic projection of the first shield electrode 511a on the base substrate may cover an orthographic projection of the first connection electrode 401 on the base substrate, which may achieve shielding of the third node of the first pixel circuit 11a; an orthographic projection of the first shield electrode 511b on the base substrate may cover an orthographic projection of the eleventh connection electrode 411 on the base substrate, which may achieve shielding of the third node of the first pixel circuit 11b; an orthographic projection of the first shield electrode 511c on the base substrate may cover an orthographic projection of the twenty-first connection electrode 421 on the base substrate, which may achieve shielding of the thirteenth node of the first pixel circuit 11c, thereby shielding an influence of remaining signals on third nodes of the first pixel circuits 11a, 11b, and 11c.

In some examples, first shield electrodes of adjacent circuit island regions may be electrically connected through a first power supply connection line. Each of shapes of the first power supply connection lines 512a, 512b, and 512c may be substantially a polyline shape extending along the second direction Y. The first power supply connection line 512a may be located on a side of the first shield electrode 511c away from the data line DL(j+3). The first power supply connection line 512a may connect first shield electrodes 511b within adjacent circuit island regions in a same column of circuit island regions. For example, one terminal of one first power supply connection line 512a may be connected with a first shield electrode 511b in a circuit island region of an (i-1)-th row and an (m+1)-th column, and after bypassing one side of a first shield electrode 511c of a circuit island region of an i-th row and an m-th column, the other terminal may be connected with a first shield electrode 511b within a circuit island region of an (i+1)-th row and the (m+1)-th column. The first power supply connection line 512a and a connected first shield electrode 511b may be of an interconnected integrated structure.

In some examples, the first power supply connection line 512b may connect a first shield electrode 511a in one circuit island region (e.g., a circuit island region of an i-th row and an m-th column) with a first shield electrode 511c in a circuit island region of a left column of an adjacent row (e.g., a circuit island region of an (i+1)-th row and an (m-1)-th column). The first power supply connection line 512a and a connected first shield electrode may be of an interconnected integrated structure.

In some examples, the first power supply connection line 512c may connect a first shield electrode 511c in one circuit island region (e.g., a circuit island region of an i-th row and an m-th column) with a first shield electrode 511a in a circuit island region of a right column of an adjacent row (e.g., a circuit island region of an (i+1)-th row and an (m+1)-th column). The first power supply connection line 512c and a connected first shield electrode may be of an interconnected integrated structure.

In the example, transmission of a first voltage signal along the second direction Y may be achieved through a connection between a first shield electrode and a first power supply connection line, and transmission of the first voltage signal along the first direction X may be achieved through a second electrode of a storage capacitor of a first pixel circuit and a connection electrode.

In some examples, shapes of the first anode connection electrodes 451a, 451b, and 451c may be substantially rectangles. The first anode connection electrode 451a may be located between the first power supply connection lines 512a and 512b, and the first anode connection electrode 451b may be located between the first power supply connection line 512a and the data line DL(j+2). The first anode connection electrode 451c may be located between the data line DL(j+3) and the first power supply connection line 512c.

In some examples, the first anode connection electrode 451a may be electrically connected with the sixth connection electrode 406 through the sixty-second via V62, thereby achieving an electrical connection with the sixth transistor of the first pixel circuit 11a. The first anode connection electrode 451b may be electrically connected with the sixteenth connection electrode 416 through the sixty-fifth via V65, thereby achieving an electrical connection with the sixth transistor of the first pixel circuit 11b. The first anode connection electrode 451c may be electrically connected with the twenty-sixth connection electrode 426 through the sixty-seventh via V67, thereby achieving an electrical connection with the sixth transistor of the first pixel circuit 11c.

(11) An eighth insulation layer is formed. In some examples, an eighth insulation layer is coated on the base substrate on which the aforementioned patterns are formed, and the eighth insulation layer is patterned through a patterning process to form an eighth insulation layer. In some examples, the eighth insulation layer may also be referred to as a second planarization layer.

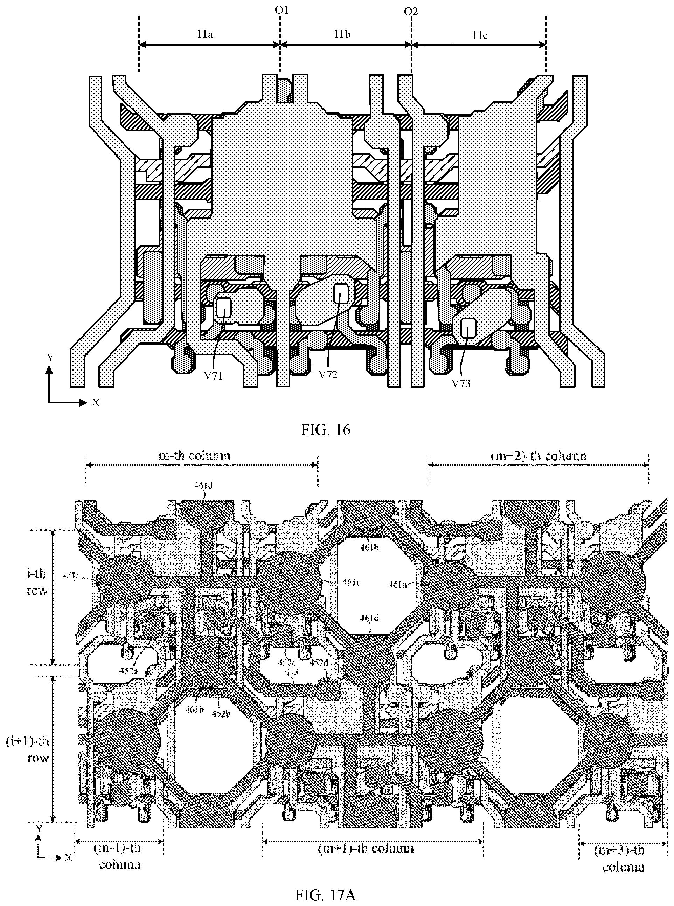

FIG. 16 is a schematic diagram of a circuit island region after an eighth insulation layer is formed in FIG. 6. In some examples, as shown in FIG. 16, the eighth insulation layer of the first display region may be provided with multiple vias, for example, may include a seventy-first via V71 to a seventy-third via V73. The eighth insulation layer within the seventy-first via V71 to the seventy-third via V73 may be removed, exposing part of a surface of the fifth conductive layer.

(12) A sixth conductive layer is formed. In some examples, a sixth conductive thin film is deposited on the base substrate on which the aforementioned patterns are formed, and the sixth conductive thin film is patterned through a patterning process to form a sixth conductive layer on the eighth insulation layer. In some examples, the sixth conductive layer may also be referred to as a third source-drain metal layer.

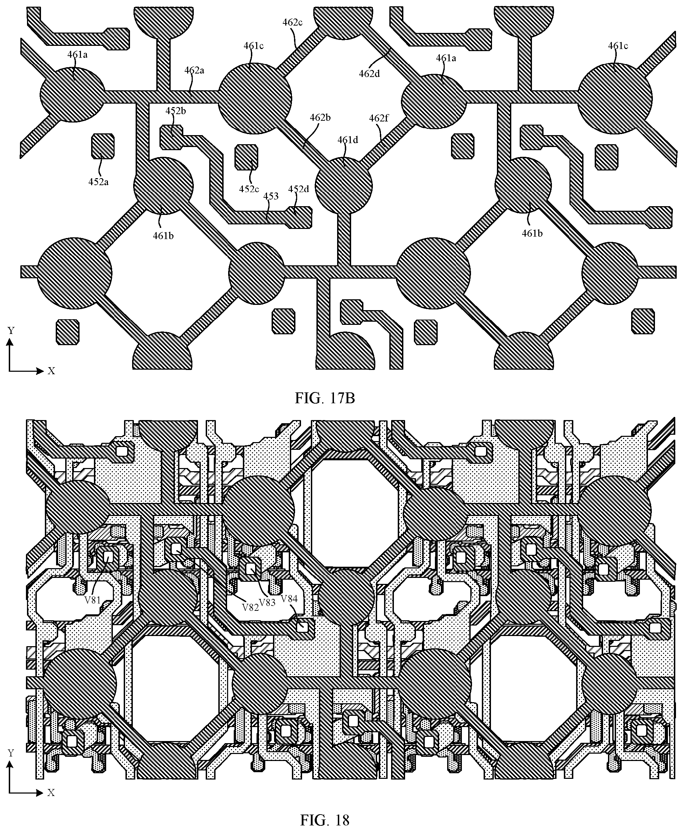

FIG. 17A is a schematic diagram of a first display region after a sixth conductive layer is formed in FIG. 6. FIG. 17B is a schematic diagram of the sixth conductive layer in FIG. 17A.

In some examples, as shown in FIGs. 17A and 17B, the sixth conductive layer of the first display region may at least include multiple auxiliary electrodes (e.g., including auxiliary electrodes 461a, 461b, 461c, and 461d), multiple auxiliary connection strips (e.g., including auxiliary connection strips 462a, 462b, 462c, 462d, and 462f), multiple second anode connection electrodes (e.g., including second anode connection electrodes 452a, 452b, 452c, and 452d), and multiple anode connection strips 453.

In some examples, shapes of the second anode connection electrodes 452a, 452b, 452c, and 452d may all be substantially rectangles. The second anode connection electrode 452a may be electrically connected with the first anode connection electrode 451a through the seventy-first via V71 to achieve an electrical connection with the sixth transistor of the first pixel circuit 11a. The second anode connection electrode 452c may be electrically connected with the first anode connection electrode 451c through the seventy-third via V73 to achieve an electrical connection with the sixth transistor of the first pixel circuit 11c. The second anode connection electrode 452b may be electrically connected with the first anode connection electrode 451b through the seventy-second via V72 to achieve an electrical connection with the sixth transistor of the first pixel circuit 11b.

In some examples, the second anode connection electrode 452b may be electrically connected with the second anode connection electrode 452d through an anode connection strip 453. The second anode connection electrodes 452b, 452d, and the anode connection strip 453 may be of an interconnected integrated structure. A second anode connection electrode 452d connected with a second anode connection electrode 452b of a circuit island region of an i-th row and an m-th column may be located in a circuit island region of an (i+1)-th row and an (m+1)-th column. The anode connection strip 453 may be substantially in an L-shaped polyline shape.

In some examples, the auxiliary electrodes 461a, 461b, 461c, and 461d may be substantially circular or elliptical in shape. The auxiliary electrode 461a may be located below an anode of a first light emitting element 13a, the auxiliary electrode 461b may be located below an anode of a first light emitting element 13b, the auxiliary electrode 461c may be located below an anode of a first light emitting element 13c, and the auxiliary electrode 461d may be located below an anode of a first light emitting element 13d. An auxiliary electrode may flatten an anode, ensure flatness of a surface of the anode close to the base substrate, reduce a color deviation caused by unevenness of the anode, and may shield an influence of a pixel circuit below the anode.

In some examples, adjacent auxiliary electrodes may be connected through an auxiliary connection strip. A shape of the auxiliary connection strip 462a may be substantially a strip-shaped intersection shape extending along the first direction X and the second direction Y. The auxiliary connection strip 462a may be located in a circuit island region and four ends of the auxiliary connection strip 462a are connected with four auxiliary electrodes 461a, 461b, 461c, and 461d respectively. The auxiliary connection strips 462b, 462c, 462d, and 462f may each be of a strip structure extending along one direction. The auxiliary connection strips 462b, 462c, 462d, and 462f may be located in an interval region between adjacent circuit island regions in a row of circuit island regions. The auxiliary connection strip 462b may connect adjacent auxiliary electrodes 461c and 461d, the auxiliary connection strip 462c may connect adjacent auxiliary electrodes 461c and 461b, the auxiliary connection strip 462d may connect adjacent auxiliary electrodes 461b and 461a, and the auxiliary connection strip 462f may connect adjacent auxiliary electrodes 461a and 461d. In an interval region between adjacent circuit island regions, four auxiliary connection strips 462b, 462c, 462d, and 462f, and four auxiliary electrodes 461a, 461b, 461c, and 461d may be connected sequentially in a grid shape.

In some examples, multiple auxiliary electrodes and multiple auxiliary connection blocks are electrically connected to form a mesh structure. The multiple auxiliary electrodes and the multiple auxiliary connection blocks may be of an interconnected integrated structure. The integrated structure of the auxiliary electrodes and the auxiliary connection blocks may be electrically connected with a first power supply connection line located in the fifth conductive layer in a peripheral region (or a second display region), so as to achieve transmission of a first voltage signal and make a first voltage signal of the first display region uniform. However, the embodiment is not limited thereto. In other examples, the integrated structure of the auxiliary electrodes and the auxiliary connection blocks may be electrically connected with a first power supply connection line or a first shield electrode located in the fifth conductive layer through a via opened in the eighth insulation layer of the first display region to achieve transmission of a first voltage signal.

(13) A ninth insulation layer and a tenth insulation layer are formed. In some examples, a ninth insulation layer is coated on the base substrate on which the aforementioned patterns are formed, and the ninth insulation layer is patterned through a patterning process to form a ninth insulation layer. Subsequently, a tenth insulation layer is coated on the base substrate on which the aforementioned patterns are formed, and the tenth insulation layer is patterned through a patterning process to form a tenth insulation layer. In some examples, the ninth insulation layer may also be referred to as a third planarization layer and the tenth insulation layer may also be referred to as a fourth planarization layer.

FIG. 18 is a schematic diagram of a first display region after a tenth insulation layer is formed in FIG. 6. In some examples, as shown in FIG. 18, the tenth insulation layer of the first display region may be provided with multiple vias, which may include, for example, an eighty-first via V81 to an eighty-fourth via V84. The tenth insulation layer and the ninth insulation layer within the eighty-first via V81 to the eighty-fourth via V84 may be removed, exposing part of a surface of the sixth conductive layer.

At this point, preparation of a circuit structure layer may be completed. A film layer structure of a circuit structure layer of the second display region is similar to a film layer structure of the first display region, and therefore, it will not be repeated herein.

In the example, flatness of an anode layer may be further ensured by disposing the ninth insulation layer and the tenth insulation layer.

(14) A light emitting structure layer is formed. In some examples, an anode thin film is deposited on the base substrate on which the aforementioned patterns are formed, and the anode thin film is patterned through a patterning process to form an anode layer.

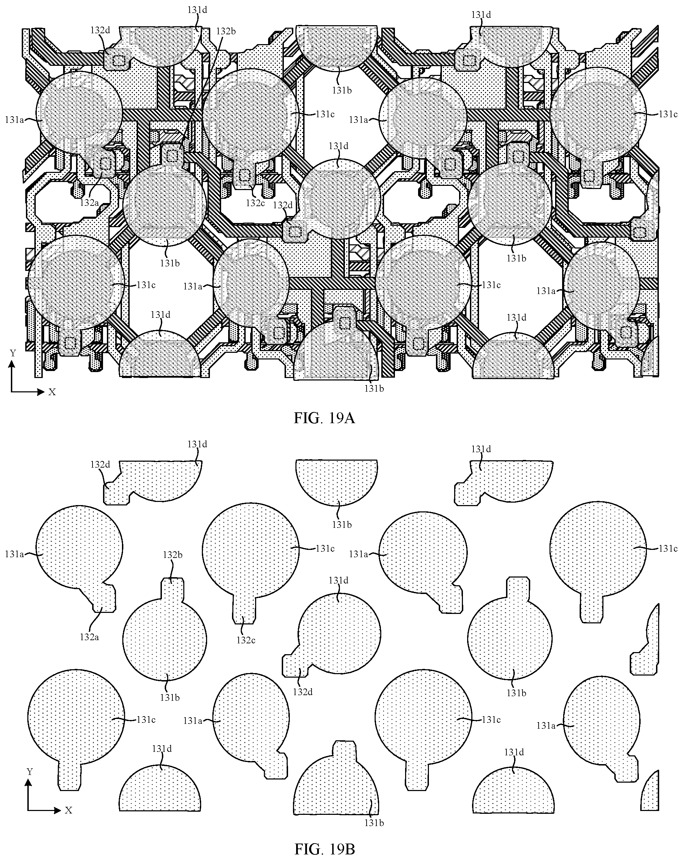

FIG. 19A is a schematic diagram of a first display region after an anode layer is formed in FIG. 6. FIG. 19B is a schematic diagram of the anode layer in FIG. 19A. In some examples, as shown in FIGs. 19A and 19B, the anode layer of the first display region may at least include anodes of multiple first light emitting elements (e.g., including an anode 131a of the first light emitting element 13a, an anode 131b of the first light emitting element 13b, an anode 131c of the first light emitting element 13c, and an anode 131d of the first light emitting element 13d), and multiple third anode connection electrodes (e.g., including third anode connection electrodes 132a, 132b, 132c, and 132d).

In some examples, the anodes 131a, 131b, 131c, and 131d may be substantially circular or elliptical in shape. The third anode connection electrodes 132a, 132b, 132c, and 132d may substantially have a rectangular shape. The anode 131a and the third anode connection electrode 132a may be of an interconnected integrated structure. The third anode connection electrode 132a may be electrically connected with the second anode connection electrode 452a through the eighty-first via V81 to achieve an electrical connection with the first pixel circuit 11a. The anode 131b and the third anode connection electrode 132b may be of an interconnected integrated structure. The third anode connection electrode 132b may be electrically connected with the second anode connection electrode 452b through the eighty-second via V82 to achieve an electrical connection with the first pixel circuit 11b. The anode 131c and the third anode connection electrode 132c may be of an interconnected integrated structure. The third anode connection electrode 132c may be electrically connected with the second anode connection electrode 452c through the eighty-third via V83 to achieve an electrical connection with the first pixel circuit 11c. The anode 131d and the third anode connection electrode 132d may be of an interconnected integrated structure. The third anode connection electrode 132d may be electrically connected with the second anode connection electrode 452d through the eighty-fourth via V84. Since the second anode connection electrodes 452d and 452b are of an integrated structure, an electrical connection between the third anode connection electrode 132d and the first pixel circuit 11b is achieved.

In some examples, an orthographic projection of the anode 131a on the base substrate may contain an orthographic projection of the auxiliary electrode 461a on the base substrate. An orthographic projection of the anode 131b on the base substrate may contain an orthographic projection of the auxiliary electrode 461b on the base substrate. An orthographic projection of the anode 131c on the base substrate may contain an orthographic projection of the auxiliary electrode 461c on the base substrate. An orthographic projection of the anode 131d on the base substrate may contain an orthographic projection of the auxiliary electrode 461d on the base substrate. In the example, an auxiliary electrode is arranged below an anode, which may not only ensure flatness of the anode, but also shield an influence of a pixel circuit on the anode layer. However, the embodiment is not limited thereto. In other examples, an orthographic projection of an auxiliary electrode on the base substrate may coincide with an orthographic projection of a corresponding anode on the base substrate.

FIG. 20 is a schematic diagram of lamination of a first semiconductor layer, a sixth conductive layer, and an anode layer in FIG. 6. In some examples, as shown in FIG. 20, an orthographic projection of the anode 131b of the first light emitting element 13b on the base substrate may be partially overlapped with an orthographic projection of the seventh active layer of the seventh transistor (i.e., a second reset transistor) and the eighth active layer of the eighth transistor (i.e., a third reset transistor) of a connected first pixel circuit 11b on the base substrate. An orthographic projection of the anode 131d of the first light emitting element 13d on the base substrate may not be overlapped with an orthographic projection of a connected first pixel circuit 11b on the base substrate. An orthographic projection of the anode 131d of the first light emitting element 13d on the base substrate may be partially overlapped with an orthographic projection of an integrated structure of first active layers of first transistors (i.e., first reset transistors) of two first pixel circuits on the base substrate.

In some examples, a pixel definition thin film is coated on the base substrate on which the aforementioned patterns are formed, and a pixel definition layer is formed through masking, exposure, and development processes. The pixel definition layer may be formed with multiple pixel openings (as shown in FIG. 6) exposing the anode layer. An organic emitting layer is formed within the pixel openings formed above, and the organic emitting layer is connected with the anode layer. Subsequently, a cathode thin film is deposited, and the cathode thin film is patterned through a patterning process to form a pattern of a cathode, and the cathode is connected with the organic emitting layer.

In some examples, an encapsulation structure layer may be formed on the cathode after preparation of the light emitting structure layer. In some examples, the encapsulation structure layer may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer may be disposed between the first encapsulation layer and the third encapsulation layer to form a laminated structure of an inorganic material/an organic material/an inorganic material, which may ensure that external water vapor cannot enter the light emitting structure layer. In some possible implementation modes, the display substrate may include other film layers, such as a touch structure layer and a color filter layer, which is not limited here in the embodiment.

In some examples, the first conductive layer, the second conductive layer, the third conductive layer, the fourth conductive layer, the fifth conductive layer, and the sixth conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo. The first insulation layer, the second insulation layer, the third insulation layer, the fourth insulation layer, the fifth insulation layer, and the sixth insulation layer may be made of any one or more of Silicon Oxide (SiOx, x>0), Silicon Nitride (SiNy, y>0), and Silicon OxyNitride (SiON), and may be a single layer, a multi-layer, or a composite layer. The seventh insulation layer, the eighth insulation layer, the ninth insulation layer, and the tenth insulation layer may be made of an organic material such as polyimide, acrylic, or polyethylene terephthalate. The pixel definition layer may be made of an organic material, such as polyimide, acrylic, or polyethylene terephthalate. The anode layer may be made of a reflective material such as a metal, and the cathode may be made of a transparent conductive material. However, the embodiment is not limited thereto.

A structure and the preparation process of the display substrate of the embodiment are merely illustrative. In some exemplary implementation modes, a corresponding structure may be changed and a patterning process may be added or removed according to actual needs. A preparation process of the exemplary embodiment may be implemented using an existing mature preparation device, and may be compatible well with an existing preparation process, simple in process implementation, easy to implement, high in a production efficiency, low in a production cost, and high in a yield.

According to the display substrate in the example, by reducing a quantity of first pixel circuits of the first display region, a first light emitting element emitting light of a third color is designed in a one-drive-two manner (i.e., one first pixel circuit simultaneously drives two first light emitting elements emitting light of the third color), and a wiring design of avoiding a light-transmitting region is carried out in an interval region of adjacent circuit island region, which may be beneficial to improve a light transmittance of the first display region, and may ensure light emitting white balance of the first display region, and may be beneficial to support PPI promotion of the first display region.

FIG. 21 is another partial top view of a circuit structure layer of a first display region according to at least one embodiment of the present disclosure. In FIG. 21, a partial structure in circuit island regions of two rows and five columns (an i-th row and an (i+1)-th row, an m-th column to an (m+2)-th column, and part of an (m-1)-th column and part of an (m+3)-th column) is taken as an example for illustration. A quantity and order of film layers of the display substrate of the example are the same as those of the foregoing embodiments. A preparation process of the display substrate of the example may be referred to description of the foregoing embodiments. Compared with the foregoing embodiments, in the example, reset transistors (including the first transistor, the seventh transistor, and the eighth transistor) of three first pixel circuits of a circuit island region are disassembled and reorganized. A structure of the display substrate of the example similar to that of the display substrate of the foregoing embodiment is omitted or briefly described, and reference may be made to description of the foregoing embodiment.

FIG. 22A is a schematic diagram of a first display region after a first semiconductor layer is formed in FIG. 21. FIG. 22B is a schematic diagram of a circuit island region in FIG. 22A. In some examples, as shown in FIGs. 22A and 22B, the first semiconductor layer of the first display region may at least include active layers of multiple first type transistors of multiple first pixel circuits. First transistors, seventh transistors, and eighth transistors of three first pixel circuits within a circuit island region are disassembled and reorganized. The first active layer 310a of the first pixel circuit 11a, the first active layer 310b of the first pixel circuit 11b, and the first active layer 310c of the first pixel circuit 11c may be of an interconnected integrated structure, an orthographic projection of the integrated structure on the base substrate may be substantially of a comb-tooth-shaped structure, and the integrated structure may be located on a side of the third active layers 330a and 330b in the second direction Y.

In some examples, the seventh active layer 370a of the first pixel circuit 11a, the seventh active layer 370b of the first pixel circuit 11b, and the seventh active layer 370c of the first pixel circuit 11c may be of an interconnected integrated structure, and an orthographic projection of the integrated structure on the base substrate may be substantially of a comb-tooth-shaped structure. An integrated structure of three seventh active layers of a circuit island region of an i-th row and an m-th column may be adjacent to an integrated structure of three first active layers of a circuit island region of an (i+1)-th row and an (m+1)-th column. Comb teeth of the integrated structure of the three seventh active layers of the circuit island region of the i-th row and the m-th column are arranged in an opposite direction to comb teeth of the integrated structure of the three first active layers of the circuit island region of the (i+1)-th row and the (m+1)-th column.

In some examples, the eighth active layer 380a of the first pixel circuit 11a, the eighth active layer 380b of the first pixel circuit 11b, and the eighth active layer 380c of the first pixel circuit 11c may be of an interconnected integrated structure, and the integrated structure may be located on a side of an integrated structure of three seventh active layers in an opposite direction of the first direction X. An integrated structure of three seventh active layers of a circuit island region may be located in an interval region between adjacent circuit island regions.

In some examples, the third active layer 330b, the fourth active layer 340b, the fifth active layer 350b, and the sixth active layer 360b of the first pixel circuit 11b and the third active layer 330c, the fourth active layer 340c, the fifth active layer 350c, and the sixth active layer 360c of the first pixel circuit 11c may be of an interconnected integrated structure, wherein the fifth active layers 350b and 350c may be directly connected.

In some examples, the third active layer 330b, the fourth active layer 340b, the fifth active layer 350b, and the sixth active layer 360b of the first pixel circuit 11a may be substantially symmetrical with the third active layer 330b, the fourth active layer 340b, the fifth active layer 350b, and the sixth active layer 360b of the first pixel circuit 11b with respect to the first centerline O1. The third active layer 330b, the fourth active layer 340b, the fifth active layer 350b, and the sixth active layer 360b of the first pixel circuit 11b may be substantially symmetrical with the third active layer 330c, the fourth active layer 340c, the fifth active layer 350c, and the sixth active layer 360c of the first pixel circuit 11c with respect to the second centerline O2.

FIG. 23A is a schematic diagram of a first display region after a first conductive layer is formed in FIG. 21. FIG. 23B is a schematic diagram of a circuit island region in FIG. 23A. In some examples, as shown in FIGs. 23A and 23B, the first conductive layer of the first display region may at least include multiple first scan lines (e.g., including first scan lines GL1(i) and GL1(i+1)), multiple light emitting control lines (e.g., including light emitting control lines EML(i) and EML(i+1)), multiple first reset control lines (e.g., including first reset control lines RST1(i) and RST1(i+1)), multiple second reset control lines (e.g., including second reset control lines RST2(i) and RST2(i+1)), and first electrodes of storage capacitors of multiple first pixel circuits (e.g., including first electrodes 391a, 391b, and 391c)). A shape of a light emitting control line may be substantially a line shape extending along the first direction X, and shapes of the first scan lines, the first reset control lines, and the second reset control lines may be substantially polyline shapes extending along the first direction X.

FIG. 24A is a schematic diagram of a first display region after a second conductive layer is formed in FIG. 21. FIG. 24B is a schematic diagram of a circuit island region in FIG. 24A. In some examples, as shown in FIGs. 24A and FIG. 24B, the second conductive layer of the first display region may at least include multiple second scan auxiliary lines (e.g., including second scan auxiliary lines GL2b(i) and GL2b(i+1)), second electrodes of storage capacitors of multiple first pixel circuits (e.g., including second electrodes 392a, 392b, and 392c), and a first connection line 393. A shape of the first connection line 393 may be a strip structure extending along the first direction X. The first connection line 393 may be configured to achieve an electrical connection between the sixth transistor and the seventh transistor of the first pixel circuit 11a.

FIG. 25A is a schematic diagram of a first display region after a second semiconductor layer is formed in FIG. 21. FIG. 25B is a schematic diagram of a circuit island region in FIG. 25A. In some examples, as shown in FIGs. 25A and 25B, the second semiconductor layer of the first display region may at least include active layers of second type transistors of multiple first pixel circuits (e.g., the second active layer 320a of the second transistor 32a of the first pixel circuit 11a, the second active layer 320b of the second transistor 32b of the first pixel circuit 11b, the second active layer 320c of the second transistor 32c of the first pixel circuit 11c). within a circuit island region, a pattern of the second semiconductor layer of the first pixel circuits 11a and 11b may be substantially symmetrical about the first centerline O1, and a pattern of the second semiconductor layer of the first pixel circuits 11b and 11c may be substantially symmetrical about the second centerline O2.

FIG. 26A is a schematic diagram of a first display region after a third conductive layer is formed in FIG. 21. FIG. 26B is a schematic diagram of a circuit island region in FIG. 26A. In some examples, as shown in FIGs. 26A and 26B, the third conductive layer of the first display region may at least include multiple second scan lines (e.g., including second scan lines GL2(i) and GL2(i+1)), multiple first initial signal lines (e.g., including first initial signal lines INIT1(i) and INIT1(i+1)), multiple second initial signal lines (e.g., including second initial signal lines INIT2(i) and INIT2(i+1)), and multiple third initial signal lines (e.g., including third initial signal lines INIT3(i) and INIT3(i+1)). Shapes of the first initial signal lines, the second scan lines, and the second initial signal lines may each be substantially a polyline shape extending along the first direction X. A shape of a third initial signal line may be substantially a straight line extending along the first direction X.

FIG. 27 is a schematic diagram of a circuit island region after a fifth insulation layer is formed in FIG. 21. In some examples, as shown in FIG. 27, the fifth insulation layer of the first display region may be provided with multiple vias, which may include, for example, a second via V2 to a sixth via V6, a twelfth via V12 to a sixteenth via V16, a twenty-second via V22 to a twenty-fifth via V25, a thirty-first via V31 to a forty-fifth via V45, a forty-seventh via V47 to a fiftieth via V50, and a 103rd via V103 to a 104th via V104.

In some examples, the fifth insulation layer, the fourth insulation layer, the third insulation layer, the second insulation layer, and the first insulation layer within the second via V2 to the sixth via V6, the twelfth via V12 to the sixteenth via V16, the twenty-second via V22 to the twenty-fifth via V25, and the ninety-first via V91 to the 102nd via V102 may be removed, exposing part of a surface of the first semiconductor layer. The fifth insulation layer and the fourth insulation layer within the thirty-first via V31 to the thirty-sixth via V36 may be removed, exposing part of a surface of the second semiconductor layer. The fifth insulation layer, the fourth insulation layer, the third insulation layer, and the second insulation layer within the thirty-seventh via V37 to the thirty-ninth via V39 may be removed, exposing part of a surface of the first conductive layer. The fifth insulation layer, the fourth insulation layer, and the third insulation layer within the fortieth via V40 to the forty-fourth via V44 and the 103rd via V103 to the 104th via V104 may be removed, exposing part of a surface of the second conductive layer. The fifth insulation layer within the forty-fifth via V45 and the forty-seventh via V47 to the fiftieth via V50 may be removed, exposing part of a surface of the third conductive layer.

FIG. 28A is a schematic diagram of a first display region after a fourth conductive layer is formed in FIG. 21. FIG. 28B is a schematic diagram of the fourth conductive layer in FIG. 28A. FIG. 28C is a schematic diagram of a circuit island region in FIG. 28A.

In some examples, as shown in FIGs. 28A to 28C, the fourth conductive layer of the first display region may at least include multiple connection electrodes (e.g., including a first connection electrode 401 to a sixth connection electrode 406, a ninth connection electrode 409, an eleventh connection electrode 411 to a sixteenth connection electrode 416, a twenty-first connection electrode 421 to a twenty-sixth connection electrode 426, and a thirty-first connection electrode 431 to a thirty-seventh connection electrode 437).

In some examples, a shape of the first connection electrode 401 may be substantially a polyline shape extending along the second direction Y. One terminal of the first connection electrode 401 may be electrically connected with the first active layer 310a through the ninety-second via V92, the other terminal may be electrically connected with the second active layer 320a of the second transistor 32a of the first pixel circuit 11a through the thirty-second via V32, and electrically connected with the sixth active layer 360a of the sixth transistor 36a of the first pixel circuit 11a through the fourth via V4.

In some examples, a shape of the second connection electrode 402 may be substantially a strip structure extending along the second direction Y. One terminal of the second connection electrode 402 may be electrically connected with the second active layer 320a of the second transistor 32a of the first pixel circuit 11a through the thirty-first via V31, and the other terminal may also be electrically connected with the first electrode 391a of the storage capacitor of the first pixel circuit 11a through the thirty-seventh via V37.

In some examples, a shape of the third connection electrode 403 may be substantially a rectangle. The third connection electrode 403 may be electrically connected with the fourth active layer 340a of the fourth transistor 34a of the first pixel circuit 11a through the second via V2.

In some examples, a shape of the fourth connection electrode 404 may be substantially a polyline shape extending along the second direction Y. One terminal of the fourth connection electrode 404 may be electrically connected with the third active layer 330a of the third transistor 33a of the first pixel circuit 11a through the third via V3, and the other terminal may be electrically connected with the eighth active layer 380a of the eighth transistor 38a of the first pixel circuit 11a through the ninety-fifth via V95.

In some examples, a shape of the fifth connection electrode 405 may be substantially a strip structure extending along the second direction Y. One terminal of the fifth connection electrode 405 may be electrically connected with the fifth active layer 350a of the fifth transistor 35a of the first pixel circuit 11a through the fifth via V5, and the other terminal may be electrically connected with the second electrode 392a of the storage capacitor of the first pixel circuit 11a through the fortieth via V40.

In some examples, a shape of the sixth connection electrode 406 may be substantially a rectangle. The sixth connection electrode 406 may be electrically connected with the sixth active layer 360a of the sixth transistor 36a of the first pixel circuit 11a through the sixth via V6, and may also be electrically connected with one terminal of the first connection line 393 through the 103rd via V103. The other terminal of the first connection line 393 may be electrically connected with the thirty-fifth connection electrode 435 through the 104th via V104, and the thirty-fifth connection electrode 435 may also be electrically connected with the seventh active layer 370b through the hundredth via V100. In the example, a connection between the sixth transistor and the seventh transistor of the first pixel circuit 11a may be achieved through the sixth connection electrode 406, the first connection line 393, and the thirty-fifth connection electrode 435.

In some examples, a shape of the ninth connection electrode 409 may be substantially a strip structure extending along the first direction X. One terminal of the ninth connection electrode 409 may be electrically connected with the second electrode 392a of the storage capacitor of the first pixel circuit 11a through the forty-first via V41, and the other terminal may be electrically connected with the second electrode 392b of the storage capacitor of the first pixel circuit 11b through the forty-second via V42.

In some examples, a shape of the eleventh connection electrode 411 may be substantially a polyline shape extending along the second direction Y. One terminal of the eleventh connection electrode 411 may be electrically connected with the first active layer 310b of the first pixel circuit 11b through the ninety-third via V93, the other terminal may be electrically connected with the second active layer 320b of the second transistor 32b of the first pixel circuit 11b through the thirty-fourth via V34, and electrically connected with the sixth active layer 360b of the sixth transistor 36b of the first pixel circuit 11b through the fourteenth via V14.

In some examples, a shape of the twelfth connection electrode 412 may be substantially a strip structure extending along the second direction Y. One terminal of the twelfth connection electrode 412 may be electrically connected with the second active layer 320b of the second transistor 32b of the first pixel circuit 11b through the thirty-third via V33, and the other terminal may also be electrically connected with the first electrode 391b of the storage capacitor of the first pixel circuit 11b through the thirty-eighth via V38.

In some examples, a shape of the thirteenth connection electrode 413 may be substantially a rectangle. The thirteenth connection electrode 413 may be electrically connected with the fourth active layer 340b of the fourth transistor 34b of the first pixel circuit 11b through the twelfth via V12.

In some examples, a shape of the fourteenth connection electrode 414 may be substantially a polyline shape extending along the second direction Y. One terminal of the fourteenth connection electrode 414 may be electrically connected with the third active layer 330b of the third transistor 33b of the first pixel circuit 11b through the thirteenth via V13, and the other terminal may be electrically connected with the eighth active layer 380b of the first pixel circuit 11b through the ninety-seventh via V97.

In some examples, a shape of the fifteenth connection electrode 415 may be substantially a strip structure extending along the second direction Y. One terminal of the fifteenth connection electrode 415 may be electrically connected with an integrated structure of the fifth active layer 350b of the fifth transistor 35b of the first pixel circuit 11b and the fifth active layer 350c of the fifth transistor 35c of the first pixel circuit 11c through the fifteenth via V15, and the other terminal may be electrically connected with an integrated structure of the second electrode 392b of the storage capacitor of the first pixel circuit 11b and the second electrode 392c of the storage capacitor of the first pixel circuit 11c through the forty-third via V43.

In some examples, a shape of the sixteenth connection electrode 416 may be substantially a rectangle. The sixteenth connection electrode 416 may be electrically connected with the sixth active layer 360b of the sixth transistor 36b of the first pixel circuit 11b through the sixteenth via V16. The sixteenth connection electrode 416 and the thirty-fourth connection electrode 434 may be of an interconnected integrated structure. The thirty-fourth connection electrode 434 may be substantially a strip structure extending along the first direction X. One terminal of the thirty-fourth connection electrode 434 is connected with the sixteenth connection electrode 416, and the other terminal may be electrically connected with the seventh active layer 370b through the 101st via V101.

In some examples, a shape of the twenty-first connection electrode 421 may be substantially L-shaped. One terminal of the twenty-first connection electrode 421 may be electrically connected with the first active layer 310c through the ninety-fourth via V94, the other terminal may be electrically connected with the second active layer 320c of the second transistor 32c of the first pixel circuit 11c through the thirty-sixth via V36, and electrically connected with the sixth active layer 360c of the sixth transistor 36c of the first pixel circuit 11c through the twenty-fourth via V24.

In some examples, a shape of the twenty-second connection electrode 422 may be substantially a strip structure extending along the second direction Y. One terminal of the twenty-second connection electrode 422 may be electrically connected with the second active layer 320c of the second transistor 32c of the first pixel circuit 11c through the thirty-fifth via V35, and the other terminal may be electrically connected with the first electrode 391c of the storage capacitor of the first pixel circuit 11c through the thirty-ninth via V39.

In some examples, a shape of the twenty-third connection electrode 423 may be substantially a rectangle. The twenty-third connection electrode 423 may be electrically connected with the fourth active layer 340c of the fourth transistor 34c of the first pixel circuit 11c through the twenty-second via V22.

In some examples, a shape of the twenty-fourth connection electrode 424 may be substantially a polyline shape extending along the second direction Y. One terminal of the twenty-fourth connection electrode 424 may be electrically connected with the third active layer 330c of the third transistor 33c of the first pixel circuit 11c through the twenty-third via V23, and the other terminal may be electrically connected with the eighth active layer 380c of the eighth transistor 38c of the first pixel circuit 11c through the ninety-eighth via V98.

In some examples, a shape of the twenty-fifth connection electrode 425 may be substantially a strip structure extending along the first direction X. The twenty-fifth connection electrode 425 may be electrically connected with the second electrode 392c of the storage capacitor of the first pixel circuit 11c through the forty-fourth via V44.

In some examples, a shape of the twenty-sixth connection electrode 426 may be substantially a strip structure extending along the first direction X. The twenty-sixth connection electrode 426 may be electrically connected with the sixth active layer 360c of the sixth transistor 36c of the first pixel circuit 11c through the twenty-fifth via V25, and may also be electrically connected with the seventh active layer 370c through the ninety-ninth via V99.

In some examples, the thirty-first connection electrode 431 may be substantially dumbbell-shaped in shape. One terminal of the thirty-first connection electrode 431 may be electrically connected with an integrated structure of three first active layers through the ninety-first via V91, and the other terminal may be electrically connected with the first initial signal line INIT1(i) through the forty-fifth via V45.

In some examples, a shape of the thirty-second connection electrode 432 may be substantially a strip structure extending along the second direction Y. One terminal of the thirty-second connection electrode 432 may be electrically connected with an integrated structure of three eighth active layers through the ninety-sixth via V96, and the other terminal may be electrically connected with the third initial signal line INIT3(i) through the forty-eighth via V48.

In some examples, a shape of the thirty-third connection electrode 433 may be substantially L-shaped. One terminal of the thirty-third connection electrode 433 may be electrically connected with an integrated structure of three seventh active layers through the 102nd via V102, and the other terminal may be electrically connected with the second initial signal line INIT2(i) through the fiftieth via V50.

In some examples, shapes of the thirty-sixth connection electrode 436 and the thirty-seventh connection electrode 437 may be substantially rectangles. The thirty-sixth connection electrode 436 may be electrically connected with the third initial signal line INIT3(i) through the forty-seventh via V47, and the thirty-seventh connection electrode 437 may be electrically connected with the third initial signal line INIT3(i) through the forty-ninth via V49. In the example, it may be beneficial to uniformity of a film layer pattern by disposing the thirty-sixth connection electrode and the thirty-seventh connection electrode.

FIG. 29 is a schematic diagram of a circuit island region after a seventh insulation layer is formed in FIG. 21. In some examples, as shown in FIG. 29, the seventh insulation layer of the first display region may be provided with multiple vias, which may include, for example, a sixty-first via V61 to a sixty-eighth via V68. The seventh insulation layer and the sixth insulation layer within the sixty-first via V61 to the sixty-eighth via V68 may be removed, exposing part of a surface of the fourth conductive layer.

FIG. 30 is a schematic diagram of a fifth conductive layer in FIG. 21. In some examples, as shown in FIGs. 21 and 30, the fifth conductive layer of the first display region may at least include multiple data lines (e.g., including data lines DL(j), DL(j+1), DL(j+2), DL(j+3), DL(j+4), DL(j+5), DL(j+6), and DL(j+7)), multiple first anode connection electrodes (e.g., including first anode connection electrodes 451a, 451b, and 451c), multiple first shield electrodes (e.g., including first shield electrodes 511a, 511b, and 511c), and multiple second power supply connection lines (e.g., including second power supply connection lines 513a, 513b, and 513c).

In some examples, the second power supply connection lines 513a, 513b, and 513c may be polyline segments extending along the second direction Y. One terminal of the second power supply connection line 513a may be connected with an integrated structure of first shield electrodes 511a and 511b within one circuit island region, and the other terminal may be connected with a first shield electrode 511c within another circuit island region. One terminal of the second power supply connection line 513b may be connected with a first shield electrode 511c within one circuit island region, and the other terminal may be connected with a first shield electrode 511a within another circuit island region. One terminal of the second power supply connection line 513c may be connected with a first shield electrode 511c within one circuit island region, and the other terminal may be connected with a first shield electrode 511b within another circuit island region. A first shield electrode and a connected second power supply connection line may be of an interconnected integrated structure. In the example, transmission of a first voltage signal along the second direction Y may be achieved through a connection between a first shield electrode and a first power supply connection line, and transmission of a first voltage signal along the first direction X may be achieved through a second electrode of a storage capacitor of a first pixel circuit and a connection electrode.

In some examples, the first anode connection electrode 451a may be electrically connected with the sixth connection electrode 406 through the sixty-second via V62, thereby achieving an electrical connection with the sixth transistor of the first pixel circuit 11a. The first anode connection electrode 451b may be electrically connected with the sixteenth connection electrode 416 through the sixty-fifth via V65, thereby achieving an electrical connection with the sixth transistor of the first pixel circuit 11b. The first anode connection electrode 451c may be electrically connected with the twenty-sixth connection electrode 426 through the sixty-seventh via V67, thereby achieving an electrical connection with the sixth transistor of the first pixel circuit 11c.

FIG. 31 is a schematic diagram of a first display region after a sixth conductive layer is formed on a side of the fifth conductive layer of FIG. 21 away from the base substrate. **In** some examples, as shown in FIG. 31, the sixth conductive layer of the first display region may at least include multiple auxiliary electrodes (e.g., including auxiliary electrodes 461a, 461b, 461c, and 461d), multiple auxiliary connection strips connecting the multiple auxiliary electrodes, multiple second anode connection electrodes (e.g., including second anode connection electrodes 452a, 452b, 452c, and 452d), and multiple anode connection strips 453.

FIG. 32 is a schematic diagram of a positional relationship between a first pixel circuit of a circuit structure layer and an anode layer of a light emitting structure layer shown in FIG. 21. In some examples, as shown in FIG. 32, an orthographic projection of the anode 131a of the first light emitting element 13a on the base substrate and an orthographic projection of a connected first pixel circuit 11a on the base substrate may be at least partially overlapped. An orthographic projection of the anode 131c of the first light emitting element 13c on the base substrate is at least partially overlapped with an orthographic projection of a connected first pixel circuit 11c on the base substrate.

In some examples, an orthographic projection of the anode 131b of the first light emitting element 13b on the base substrate is at least partially overlapped with an orthographic projection of eighth transistors of three first pixel circuits within one circuit island region on the base substrate. For example, an orthographic projection of the anode 131b of the first light emitting element 13b on the base substrate is partially overlapped with an orthographic projection of an integrated structure of eighth active layers of three eighth transistors on the base substrate.

In some examples, an orthographic projection of the anode 131d of the first light emitting element 13d on the base substrate is at least partially overlapped with orthographic projections of seventh transistors of three first pixel circuits within one circuit island and first transistors of three first pixel circuits within another circuit island on the base substrate. An orthographic projection of the anode 131d of the first light emitting element 13d on the base substrate is at least partially overlapped with an orthographic projection of an integrated structure of seventh active layers of three first pixel circuits on the base substrate, and may also be at least partially overlapped with an orthographic projection of an integrated structure of first active layers of other three first pixel circuits on the base substrate. An orthographic projection of the anode 131d of the first light emitting element 13d on the base substrate is not overlapped with an orthographic projection of a transistor other than the second reset transistor (i.e., the seventh transistor) of a connected first pixel circuit, on the base substrate.

In the example, multiple reset transistors (including a first transistor, a seventh transistor, and an eighth transistor) of a first pixel circuit of the first display region are disassembled and reorganized, multiple first transistors and seventh transistors are disposed below an anode of a same first light emitting element emitting green light, and multiple eighth transistors are disposed below an anode of another first light emitting element emitting green light. Through disassembly and combination of reset transistors in the example, first pixel circuits within the first display region may be rationally arranged, so as to further increase a light transmittance of the first display region and improve performance of the display substrate under a condition of ensuring light emitting white balance.

For rest of description of the display substrate according to the embodiment, reference may be made to description of the previous embodiment, and repetition will not be made here.

FIG. 33 is another partial top view of a first display region according to at least one embodiment of the present disclosure. FIG. 33 is a partial top view of the first display region shown in FIG. 4B. A quantity and order of film layers of the display substrate of the example are the same as those of the foregoing embodiments. A preparation process of the display substrate of the example may be referred to description of the foregoing embodiments. Compared with the foregoing embodiments, in the example, a reset transistor (including a first transistor and a seventh transistor) of a third first pixel circuit of a circuit island region is disassembled. A structure of the display substrate of the example similar to that of the display substrate of the foregoing embodiment is omitted or briefly described, and reference may be made to the description of the foregoing embodiment.

FIG. 34A is a schematic diagram of a first display region after a first semiconductor layer is formed in FIG. 33. FIG. 34B is a schematic diagram of a circuit island region in FIG. 34A. In some examples, as shown in FIGs. 34A and 34B, the first semiconductor layer of the first display region may at least include active layers of multiple first type transistors of multiple first pixel circuits. A first active layer 310c of a first transistor and a seventh active layer 370c of a seventh transistor of a third first pixel circuit (i.e., the first pixel circuit 11c) within a circuit island region are disassembled and reorganized.

In some examples, the first active layer 310c and the seventh active layer 370c of the first pixel circuit 11c may be aligned in the second direction Y. The first active layer 310c and the seventh active layer 370c of the first pixel circuit 11c of a column of circuit island regions may be aligned in the second direction. The first active layer 310c of the first pixel circuit 11c of a row of circuit island regions and the seventh active layer 370c of the first pixel circuit 11c of an adjacent row of circuit island regions may be aligned in the first direction X. The first active layer 310c and the seventh active layer 370c may be located on a side of the sixth active layer 360c away from the third active layer 330c. A shape of the first active layer 310c may be substantially half of a shape of a Chinese character "几". A shape of the seventh active layer 370c may be substantially I-shaped.

In some examples, the third active layer 330a, the fourth active layer 340a, the fifth active layer 350a, the sixth active layer 360a, and the seventh active layer 370a of the first pixel circuit 11a, the third active layer 330b, the fourth active layer 340b, the fifth active layer 350b, the sixth active layer 360b, and the seventh active layer 370b of the first pixel circuit 11b, and the third active layer 330c, the fourth active layer 340c, the fifth active layer 350c, and the sixth active layer 360c of the first pixel circuit 11c may be of an interconnected integrated structure. Among them, the seventh active layer 370a of the first pixel circuit 11a and the seventh active layer 370b of the first pixel circuit 11b may be directly connected, and the fifth active layer 350b of the first pixel circuit 11b and the fifth active layer 350c of the first pixel circuit 11c may be directly connected. The first active layer 310a of the first pixel circuit 11a and the first active layer 310b of the first pixel circuit 11b may be of an interconnected integrated structure, and a shape of the integrated structure may be substantially a shape of a Chinese character "几". The eighth active layer 380b of the first pixel circuit 11b and the eighth active layer 380c of the first pixel circuit 11c may be of an interconnected integrated structure, and a shape of the integrated structure may be substantially U-shaped.

In some examples, a pattern of the first semiconductor layer of the first pixel circuits 11a and 11b within one circuit island region may be substantially symmetrical with respect to the first centerline O1. The third active layer 330b, the fourth active layer 340b, the fifth active layer 350b, the sixth active layer 360b, and the eighth active layer 380b of the first pixel circuit 11b may be substantially symmetrical with the third active layer 330c, the fourth active layer 340c, the fifth active layer 350c, the sixth active layer 360c, and the eighth active layer 380c of the first pixel circuit 11c with respect to the second centerline O2. As shown in FIG. 34A, patterns of first semiconductor layers of different circuit island regions may be independent of each other. A seventh active layer 370c of a first pixel circuit 11c of one circuit island region is adjacent to an integrated structure of first active layers of the first pixel circuits 11a and 11b of a circuit island region of a next row and an adjacent column , and a first active layer 310c of a first pixel circuit 11c of one circuit island region is adjacent to a seventh active layer 370b and an eighth active layer 380b of a circuit island region of a previous row and an adjacent column, for example, may be located between the seventh active layer 370b and the eighth active layer 380b.

FIG. 35A is a schematic diagram of a first display region after a first conductive layer is formed in FIG. 33. FIG. 35B is a schematic diagram of a circuit island region in FIG. 35A. In some examples, as shown in FIGs. 35A and 35B, the first conductive layer of the first display region may at least include multiple first scan lines (e.g., including first scan lines GL1(i) and GL1(i+1)), multiple light emitting control lines (e.g., including light emitting control lines EML(i) and EML(i+1)), multiple first reset control lines (e.g., including first reset control lines RST1(i) and RST1(i+1)), multiple second reset control lines (e.g., including second reset control lines RST2(i) and RST2(i+1)), and first electrodes of storage capacitors of multiple first pixel circuits (e.g., including first electrodes 391a, 391b, and 391c)). The light emitting control lines, the first reset control lines, the first scan lines, and the second reset control lines may be substantially in a polyline shape extending along the first direction X. Among them, the first reset control lines and the first scan lines are bent to a side away from the seventh active layer 370c, and the light emitting control lines and the second reset control lines are bent to a side away from the first active layer 310c, so that the first reset control lines, the first scan lines, the light emitting control lines, and the second reset control lines avoid a first light-transmitting region so as to ensure an area of the first light-transmitting region.

FIG. 36A is a schematic diagram of a first display region after a second conductive layer is formed in FIG. 33. FIG. 36B is a schematic diagram of a circuit island region in FIG. 36A. In some examples, as shown in FIGs. 36A and 36B, the second conductive layer of the first display region may at least include multiple second scan auxiliary lines (e.g., including second scan auxiliary lines GL2b(i) and GL2b(i+1)), second electrodes of storage capacitors of multiple first pixel circuits (e.g., including second electrodes 392a, 392b, and 392c). A shape of a second scan auxiliary line may be substantially a polyline shape extending along the first direction X. The second scan auxiliary line GL2b(i) may be bent toward a side away from the seventh active layer 370c and located on a side of the first scan line GL1(i) in an opposite direction of the second direction Y, so that the second scan auxiliary line avoids the first light-transmitting region.

FIG. 37A is a schematic diagram of a first display region after a second semiconductor layer is formed in FIG. 33. FIG. 37B is a schematic diagram of a circuit island region in FIG. 37A. In some examples, as shown in FIGs. 37A and 37B, the second semiconductor layer of the first display region may at least include active layers of second type transistors of multiple first pixel circuits (e.g., the second active layer 320a of the second transistor 32a of the first pixel circuit 11a, the second active layer 320b of the second transistor 32b of the first pixel circuit 11b, the second active layer 320c of the second transistor 32c of the first pixel circuit 11c). Within a circuit island region, a pattern of the second semiconductor layer of the first pixel circuits 11a and 11b may be substantially symmetrical about the first centerline O1, and a pattern of the second semiconductor layer of the first pixel circuits 11b and 11c may be substantially symmetrical about the second centerline O2.

FIG. 38A is a schematic diagram of a first display region after a third conductive layer is formed in FIG. 33. FIG. 38B is a schematic diagram of a circuit island region in FIG. 38A. In some examples, as shown in FIGs. 38A and 38B, the third conductive layer of the first display region may at least include multiple second scan lines (e.g., including second scan lines GL2(i) and GL2(i+1)), multiple first initial signal lines (e.g., including first initial signal lines INIT1(i) and INIT1(i+1)), multiple second initial signal lines (e.g., including second initial signal lines INIT2(i) and INIT2(i+1)), and multiple third initial signal lines (e.g., including third initial signal lines INIT3(i) and INIT3(i+1)). Shapes of the first initial signal lines, the second scan lines, the second initial signal lines, and the third initial signal lines may each be substantially a polyline shape extending along the first direction X. Orthographic projections of a first initial signal line and a first reset control line on the base substrate may be at least partially overlapped, orthographic projections of a second scan line and a second scan auxiliary line on the base substrate may be at least partially overlapped, orthographic projections of a third initial signal line and a light emitting control line on the base substrate may be at least partially overlapped, and orthographic projections of a second initial signal line and a second reset control line on the base substrate may be at least partially overlapped. In the example, wiring space may be saved by overlapping traces of different conductive layers, which is beneficial to improving a light transmittance of the first display region.

FIG. 39 is a schematic diagram of a circuit island region after a fifth insulation layer is formed in FIG. 33. In some examples, as shown in FIG. 39, the fifth insulation layer of the first display region may be provided with multiple vias, which may include, for example, a first via V1 to a sixteenth via V16, an eighteenth via V18 to a twenty-eighth via V28, and a thirty-first via V31 to a fifty-first via V51.

In some examples, the fifth insulation layer, the fourth insulation layer, the third insulation layer, the second insulation layer, and the first insulation layer within the first via V1 to the sixteenth via V16 and the eighteenth via V18 to the twenty-eighth via V28 may be removed, exposing part of a surface of the first semiconductor layer. The fifth insulation layer and the fourth insulation layer within the thirty-first via V3 to the thirty-sixth via V36 may be removed, exposing part of a surface of the second semiconductor layer. The fifth insulation layer, the fourth insulation layer, the third insulation layer, and the second insulation layer within the thirty-seventh via V37 to the thirty-ninth via V39 may be removed, exposing part of a surface of the first conductive layer. The fifth insulation layer, the fourth insulation layer, and the third insulation layer within the fortieth via V40 to the forty-fourth via V44 may be removed, exposing part of a surface of the second conductive layer. The fifth insulation layer within the forty-fifth via V45 to the fifty-first via V51 may be removed, exposing part of a surface of the third conductive layer.

FIG. 40A is a schematic diagram of a first display region after a fourth conductive layer is formed in FIG. 33. FIG. 40B is a schematic diagram of the fourth conductive layer in FIG. 40A. FIG. 40C is a schematic diagram of a circuit island region in FIG. 40A.

In some examples, as shown in FIGs. 40A to 40C, the fourth conductive layer of the first display region may at least include multiple connection electrodes (e.g., including a first connection electrode 401 to a sixteenth connection electrode 416, a twenty-second connection electrode 422 to a twenty-sixth connection electrode 426, and a thirty-eighth connection electrode 438 to a forty-first connection electrode 441).

In some examples, a shape of the first connection electrode 401 may be substantially a polyline shape extending along the second direction Y. One terminal of the first connection electrode 401 may be electrically connected with the first active layer 310a through the first via V1, the other terminal may be electrically connected with the second active layer 320a of the second transistor 32a of the first pixel circuit 11a through the thirty-second via V32, and electrically connected with the sixth active layer 360a of the sixth transistor 36a of the first pixel circuit 11a through the fourth via V4.

In some examples, a shape of the second connection electrode 402 may be substantially a strip structure extending along the second direction Y. One terminal of the second connection electrode 402 may be electrically connected with the second active layer 320a of the second transistor 32a of the first pixel circuit 11a through the thirty-first via V31, and the other terminal may also be electrically connected with the first electrode 391a of the storage capacitor of the first pixel circuit 11a through the thirty-seventh via V37.

In some examples, a shape of the third connection electrode 403 may be substantially a rectangle. The third connection electrode 403 may be electrically connected with the fourth active layer 340a of the fourth transistor 34a of the first pixel circuit 11a through the second via V2.

In some examples, a shape of the fourth connection electrode 404 may be substantially a polyline shape extending along the second direction Y. One terminal of the fourth connection electrode 404 may be electrically connected with the third active layer 330a of the third transistor 33a of the first pixel circuit 11a through the third via V3, and the other terminal may be electrically connected with the eighth active layer 380a of the eighth transistor 38a of the first pixel circuit 11a through the ninth via V9.

In some examples, a shape of the fifth connection electrode 405 may be substantially a strip structure extending along the second direction Y. One terminal of the fifth connection electrode 405 may be electrically connected with the fifth active layer 350a of the fifth transistor 35a of the first pixel circuit 11a through the fifth via V5, and the other terminal may be electrically connected with the second electrode 392a of the storage capacitor of the first pixel circuit 11a through the fortieth via V40.

In some examples, a shape of the sixth connection electrode 406 may be substantially a rectangle. The sixth connection electrode 406 may be electrically connected with the sixth active layer 360a of the sixth transistor 36a of the first pixel circuit 11a through the sixth via V6.

In some examples, a shape of the seventh connection electrode 407 may be substantially dumbbell-shaped. One terminal of the seventh connection electrode 407 may be electrically connected with an integrated structure of the seventh active layers 370a and 370b through the seventh via V7, and the other terminal may be electrically connected with the second initial signal line INIT2(i) through the fifty-first via V51.

In some examples, a shape of the eighth connection electrode 408 may be substantially L-shaped. One terminal of the eighth connection electrode 408 may be connected with the eighth active layer 380a through the eighth via V8, and the other terminal may be electrically connected with the third initial signal line INIT3(i) through the forty-seventh via V47.

In some examples, a shape of the ninth connection electrode 409 may be substantially a strip structure extending along the first direction X. One terminal of the ninth connection electrode 409 may be electrically connected with the second electrode 392a of the storage capacitor of the first pixel circuit 11a through the forty-first via V41, and the other terminal may be electrically connected with the second electrode 392b of the storage capacitor of the first pixel circuit 11b through the forty-second via V42.

In some examples, a shape of the tenth connection electrode 410 may be substantially dumbbell-shaped. One terminal of the tenth connection electrode 410 may be connected with an integrated structure of the first active layers 310a and 310b through the tenth via V10, and the other terminal may be electrically connected with the first initial signal line INIT1(i) through the forty-fifth via V45.

In some examples, a shape of the eleventh connection electrode 411 may be substantially a polyline shape extending along the second direction Y. One terminal of the eleventh connection electrode 411 may be electrically connected with the first active layer 310b of the first pixel circuit 11b through the eleventh via V11, the other terminal may be electrically connected with the second active layer 320b of the second transistor 32b of the first pixel circuit 11b through the thirty-fourth via V34, and electrically connected with the sixth active layer 360b of the sixth transistor 36b of the first pixel circuit 11b through the fourteenth via V14.

In some examples, a shape of the twelfth connection electrode 412 may be substantially a strip structure extending along the second direction Y. One terminal of the twelfth connection electrode 412 may be electrically connected with the second active layer 320b of the second transistor 32b of the first pixel circuit 11b through the thirty-third via V33, and the other terminal may also be electrically connected with the first electrode 391b of the storage capacitor of the first pixel circuit 11b through the thirty-eighth via V38.

In some examples, a shape of the thirteenth connection electrode 413 may be substantially a rectangle. The thirteenth connection electrode 413 may be electrically connected with the fourth active layer 340b of the fourth transistor 34b of the first pixel circuit 11b through the twelfth via V12.

In some examples, a shape of the fourteenth connection electrode 414 may be substantially a polyline shape extending along the second direction Y. One terminal of the fourteenth connection electrode 414 may be electrically connected with the third active layer 330b of the third transistor 33b of the first pixel circuit 11b through the thirteenth via V13, and the other terminal may be electrically connected with the eighth active layer 380b of the first pixel circuit 11b through the nineteenth via V19.

In some examples, a shape of the fifteenth connection electrode 415 may be substantially a strip structure extending along the second direction Y. One terminal of the fifteenth connection electrode 415 may be electrically connected with an integrated structure of the fifth active layer 350b of the fifth transistor 35b of the first pixel circuit 11b and the fifth active layer 350c of the fifth transistor 35c of the first pixel circuit 11c through the fifteenth via V15, and the other terminal may be electrically connected with an integrated structure of the second electrode 392b of the storage capacitor of the first pixel circuit 11b and the second electrode 392c of the storage capacitor of the first pixel circuit 11c through the forty-third via V43.

In some examples, a shape of the sixteenth connection electrode 416 may be substantially a rectangle. The sixteenth connection electrode 416 may be electrically connected with the sixth active layer 360b of the sixth transistor 36b of the first pixel circuit 11b through the sixteenth via V16.

In some examples, a shape of the twenty-second connection electrode 422 may be substantially a strip structure extending along the second direction Y. One terminal of the twenty-second connection electrode 422 may be electrically connected with the second active layer 320c of the second transistor 32c of the first pixel circuit 11c through the thirty-fifth via V35, and the other terminal may be electrically connected with the first electrode 391c of the storage capacitor of the first pixel circuit 11c through the thirty-ninth via V39.

In some examples, a shape of the twenty-third connection electrode 423 may be substantially a rectangle. The twenty-third connection electrode 423 may be electrically connected with the fourth active layer 340c of the fourth transistor 34c of the first pixel circuit 11c through the twenty-second via V22.

In some examples, a shape of the twenty-fourth connection electrode 424 may be substantially a polyline shape extending along the second direction Y. One terminal of the twenty-fourth connection electrode 424 may be electrically connected with the third active layer 330c of the third transistor 33c of the first pixel circuit 11c through the twenty-third via V23, and the other terminal may be electrically connected with the eighth active layer 380c of the eighth transistor 38c of the first pixel circuit 11c through the twenty-eighth via V28.

In some examples, a shape of the twenty-fifth connection electrode 425 may be substantially a strip structure extending along the first direction X. The twenty-fifth connection electrode 425 may be electrically connected with the second electrode 392c of the storage capacitor of the first pixel circuit 11c through the forty-fourth via V44.

In some examples, a shape of the twenty-sixth connection electrode 426 may be substantially a strip structure extending along the first direction X. The twenty-sixth connection electrode 426 may be electrically connected with the sixth active layer 360c of the sixth transistor 36c of the first pixel circuit 11c through the twenty-fifth via V25, and may also be electrically connected with the seventh active layer 370c through the twenty-sixth via V26.

In some examples, a shape of the thirty-eighth connection electrode 438 may be substantially U-shaped. One terminal of the thirty-eighth connection electrode 438 may be electrically connected with the eighth active layers 380b and 380c through the eighteenth via V18, another terminal may be electrically connected with the third initial signal line INIT3(i) through the forty-eighth via V48, and yet another terminal may be electrically connected with the third initial signal line INIT3(i) through the forty-ninth via V49.

In some examples, a shape of the thirty-ninth connection electrode 439 may be substantially dumbbell-shaped. One terminal of the thirty-ninth connection electrode 439 may be electrically connected with the first active layer 310c through the twentieth via V20, and the other terminal may be electrically connected with the first initial signal line INIT1(i) through the forty-sixth via V46.

In some examples, a shape of the fortieth connection electrode 440 may be substantially a polyline shape extending along the second direction Y. One terminal of the fortieth connection electrode 440 may be connected with the first active layer 310c through the twenty-first via V21, the other terminal may be electrically connected with the second active layer 320c of the second transistor 32c of the first pixel circuit 11c through the thirty-sixth via V36, and electrically connected with the sixth active layer 360c of the sixth transistor 36c of the first pixel circuit 11c through the twenty-fourth via V24.

In some examples, a shape of the forty-first connection electrode 441 may be substantially dumbbell-shaped. One terminal of the forty-first connection electrode 441 may be connected with the seventh active layer 370c through the twenty-seventh via V27, and the other terminal may be electrically connected with the second initial signal line INIT2(i) through the fiftieth via V50.

FIG. 41 is a schematic diagram of a circuit island region after a seventh insulation layer is formed in FIG. 33. In some examples, as shown in FIG. 41, the seventh insulation layer of the first display region may be provided with multiple vias, which may include, for example, a sixty-first via V61 to a sixty-eighth via V68. The seventh insulation layer and the sixth insulation layer within the sixty-first via V61 to the sixty-eighth via V68 may be removed, exposing part of a surface of the fourth conductive layer.

FIG. 42A is a schematic diagram of a first display region after a fifth conductive layer is formed in FIG. 33. FIG. 42B is a schematic diagram of the fifth conductive layer in FIG. 42A. FIG. 42C is a schematic diagram of a circuit island region in FIG. 42A.

In some examples, as shown in FIGs. 42A to 42C, the fifth conductive layer of the first display region may at least include multiple data lines (e.g., including data lines DL(j), DL(j+1), DL(j+2), DL(j+3), DL(j+4), DL(j+5), DL(j+6), and DL(j+7)), multiple first anode connection electrodes (e.g., including first anode connection electrodes 451a, 451b, and 451c), and multiple first shield electrodes (e.g., including first shield electrodes 511a, 511b, and 511c).

In some examples, the first anode connection electrodes 451a, 451b, and 451c may be substantially dumbbell-shaped. The first anode connection electrode 451a may be electrically connected with the sixth connection electrode 406 through the sixty-second via V62, thereby achieving an electrical connection with the sixth transistor of the first pixel circuit 11a. The first anode connection electrode 451b may be electrically connected with the sixteenth connection electrode 416 through the sixty-fifth via V65, thereby achieving an electrical connection with the sixth transistor of the first pixel circuit 11b. The first anode connection electrode 451c may be electrically connected with the twenty-sixth connection electrode 426 through the sixty-seventh via V67, thereby achieving an electrical connection with the sixth transistor of the first pixel circuit 11c.

In some examples, the first shield electrodes 511a and 511b may be of an interconnected integrated structure. The first shield electrodes 511a and 551b may be substantially symmetrical with respect to the first centerline O1. An orthographic projection of the first shield electrode 511a on the base substrate may cover an orthographic projection of the second connection electrode 402 on the base substrate, thereby achieving shielding of a first node of the first pixel circuit 11a; an orthographic projection of the first shield electrode 511b on the base substrate may cover an orthographic projection of the twelfth connection electrode 412 on the base substrate, shielding of a first node of the first pixel circuit 11b may be achieved; an orthographic projection of the first shield electrode 511c on the base substrate may cover an orthographic projection of the twenty-second connection electrode 422 on the base substrate, shielding of a first node of the first pixel circuit 11c may be achieved, thereby shielding an influence of a remaining signal on first nodes of the first pixel circuits 11a, 11b, and 11c.

In some examples, the multiple data lines may be substantially a polyline shape extending along the second direction Y. The data lines DL(j) and DL(j+1) may be adjacent, and the data lines DL(j+2) and DL(j+3) may be adjacent. The data line DL(j+1) may be electrically connected with the third connection electrode 403 through the sixty-first via V61 to achieve an electrical connection with the first electrode of the fourth transistor 34a of the first pixel circuit 11a. The data line DL(j+2) may be electrically connected with the thirteenth connection electrode 413 through the sixty-fourth via V64 to achieve an electrical connection with the first electrode of the fourth transistor 34b of the first pixel circuit 11b. The data line DL(j+3) may be electrically connected with the twenty-third connection electrode 423 through the sixty-sixth via V66 to achieve an electrical connection with the first electrode of the fourth transistor 34c of the first pixel circuit 11c.

In some examples, four data lines may be disposed penetrating through each circuit island region, and three of the four data lines may be electrically connected with three first pixel circuits in the circuit island region, respectively. The data lines DL(j), DL(j+2), DL(j+4), and DL(j+6) may be configured to provide a data signal to a first pixel circuit (e.g., first pixel circuit 11b) connected with a first light emitting element emitting light of a third color. The data lines DL(j), DL(j+2), DL(j+4), and DL(j+6) may be configured to provide data signals to multiple first pixel circuits disposed every other row. For example, the data lines DL(j) and DL(j+4) are not electrically connected with a first pixel circuit within a circuit island region of an i-th row, but are electrically connected with a first pixel circuit within a circuit island region of an (i+1)-th row; and the data lines DL(j+2) and DL(j+6) are electrically connected with the first pixel circuit within the circuit island region of the i-th row, but are not electrically connected with the first pixel circuit within the circuit island region of the (i+1)-th row. In the example, a data line providing a data signal to a first pixel circuit (for example, the first pixel circuit 11b) connected with a first light emitting element emitting light of a third color is electrically connected with multiple first pixel circuits disposed every other row to provide a data signal to multiple first pixel circuits disposed every other row. An arrangement mode of data lines in the example is beneficial to a trace arrangement.

FIG. 43 is a schematic diagram of a circuit island region after an eighth insulation layer is formed in FIG. 33. In some examples, as shown in FIG. 43, the eighth insulation layer of the first display region may be provided with multiple vias, for example, may include a seventy-first via V71 to a seventy-fifth via V75. The eighth insulation layer within the seventy-first via V71 to the seventy-fifth via V75 may be removed, exposing part of a surface of the fifth conductive layer.

FIG. 44A is a schematic diagram of a first display region after a sixth conductive layer is formed in FIG. 33. FIG. 44B is a schematic diagram of the sixth conductive layer in FIG. 44A. In some examples, as shown in FIGs. 44A and 44B, the sixth conductive layer of the first display region may at least include a third power supply connection line 463, multiple second anode connection electrodes (including, for example, second anode connection electrodes 452a, 452b, 452c, and 452d), and multiple anode connection strips 453.

In some examples, shapes of the second anode connection electrodes 452a and 452c may be substantially dumbbell-shaped, and shapes of the second anode connection electrodes 452b and 452d may both be substantially rectangles. The second anode connection electrode 452a may be electrically connected with the first anode connection electrode 451a through the seventy-first via V71 to achieve an electrical connection with the sixth transistor of the first pixel circuit 11a. The second anode connection electrode 452c may be electrically connected with the first anode connection electrode 451c through the seventy-third via V73 to achieve an electrical connection with the sixth transistor of the first pixel circuit 11c. The second anode connection electrode 452b may be electrically connected with the first anode connection electrode 451b through the seventy-second via V72 to achieve an electrical connection with the sixth transistor of the first pixel circuit 11b. The second anode connection electrode 452b may be electrically connected with the second anode connection electrode 452d through an anode connection strip 453. The second anode connection electrodes 452b and 452d and the anode connection strip 453 may be of an interconnected integrated structure. A second anode connection electrode 452d connected with a second anode connection electrode 452b of a circuit island region of an i-th row and an m-th column may be located between the circuit island region of the i-th row and the m-th column and a circuit island region of the i-th row and an (m+2)-th column, and be close to a circuit island region of an (i-1)-th row. The anode connection strip 453 may be substantially in an L-shaped polyline shape.

In some examples, the third power supply connection line 463 may be of a mesh structure, for example including an extension segment along the second direction Y, an extension segment whose extension direction crosses both the first direction X and the second direction Y. The third power supply connection line 463 may be electrically connected with an integrated structure of the first shield electrodes 511a and 511b through the seventy-fourth via V74, and may also be electrically connected with the first shield electrode 511c through the seventy-fifth via V75. In the example, mesh transmission of a first voltage signal within the first display region may be achieved through the third power supply connection line 463, and uniformity of the first voltage signal may be ensured.

FIG. 45 is a schematic diagram of lamination of a first semiconductor layer, a first conductive layer, a second conductive layer, a second semiconductor layer, a third conductive layer, and an anode layer in FIG. 33. In some examples, as shown in FIGs. 33 and 45, the anode layer of the first display region may at least include anodes of multiple first light emitting elements (e.g., including an anode 131a of the first light emitting element 13a, an anode 131b of the first light emitting element 13b, an anode 131c of the first light emitting element 13c, and an anode 131d of the first light emitting element 13d), and multiple third anode connection electrodes (e.g., including third anode connection electrodes 132a, 132b, 132c, and 132d).

In some examples, the anodes 131a, 131b, 131c, and 131d may be substantially circular or elliptical in shape. The third anode connection electrodes 132a, 132b, 132c, and 132d may substantially have a rectangular shape. The anode 131a and the third anode connection electrode 132a may be of an interconnected integrated structure. The third anode connection electrode 132a may be electrically connected with the second anode connection electrode 452a to achieve an electrical connection with the first pixel circuit 11a. The anode 131b and the third anode connection electrode 132b may be of an interconnected integrated structure. The third anode connection electrode 132b may be electrically connected with the second anode connection electrode 452b to achieve an electrical connection with the first pixel circuit 11b. The anode 131c and the third anode connection electrode 132c may be of an interconnected integrated structure. The third anode connection electrode 132c may be electrically connected with the second anode connection electrode 452c to achieve an electrical connection with the first pixel circuit 11c. The anode 131d and the third anode connection electrode 132d may be of an interconnected integrated structure. The third anode connection electrode 132d may be electrically connected with the second anode connection electrode 452d, and since the second anode connection electrodes 452d and 452b are of an integrated structure, an electrical connection between the third anode connection electrode 132d and the first pixel circuit 11b is achieved.

In some examples, orthographic projections of the first light emitting element 13d and a connected first pixel circuit 11b on the base substrate are not overlapped, and orthographic projections of the first light emitting element 13d and one first transistor on the base substrate are at least partially overlapped. Orthographic projections of the first light emitting element 13b and a connected first pixel circuit 11b on the base substrate may not be overlapped or may be partially overlapped, and orthographic projections of the first light emitting element 13b and one seventh transistor on the base substrate may be at least partially overlapped. Orthographic projections of the first light emitting element 13a and a connected first pixel circuit 11a on the base substrate are at least partially overlapped, and orthographic projections of the first light emitting element 13c and a connected first pixel circuit 11c on the base substrate are at least partially overlapped.

In some examples, as shown in FIGs. 33 and 45, the first transistor 31c of the first pixel circuit 11c may be located below one first light emitting element 13d, and the seventh transistor 37c of the first pixel circuit 11c may be located below one first light emitting element 13b. The first transistor 31c and the seventh transistor 37c of the first pixel circuit 11c are located below different first light emitting elements emitting green light. An orthographic projection of the anode 131b of the first light emitting element 13b on the base substrate may cover an orthographic projection of the first active layer 310c of the first transistor of the first pixel circuit 11c on the base substrate; an orthographic projection of the anode 131d of the first light emitting element 13d on the base substrate may cover an orthographic projection of the seventh active layer 370c of the seventh transistor of the first pixel circuit 11c on the base substrate.

In the display substrate of the example, a reset transistor of a third first pixel circuit within a circuit island region is disassembled and placed below different first light emitting elements, which may avoid that the reset transistor cannot be blocked by an anode of a light emitting element, which will affect a light transmittance of the first display region adversely. The example is beneficial for improving the light transmittance of the first display region. Compared with the previous two embodiments, the display substrate of the embodiment may obtain better light transmittance.

Rest of description of the display substrate of the example may be referred to description of the aforementioned embodiments, and thus will not be repeated here.

The aforementioned embodiments are illustrative only. Some features of the above embodiments may be combined with each other. The embodiment is not limited thereto.

In other examples, a reset transistor of a first first pixel circuit within a circuit island region may be disassembled, such as placing a first transistor of the first first pixel circuit below a first light emitting element emitting green light, and placing a seventh transistor of the first first pixel circuit below another first light emitting element emitting green light.

In other examples, reset transistors of two first pixel circuits within a circuit island region (e.g., a first first pixel circuit and a second first pixel circuit, or a first first pixel circuit and a third first pixel circuit, or a second first pixel circuit and a third first pixel circuit) may be disassembled and reorganized. For example, reorganized first transistors of two first pixel circuits are placed below one first light emitting element emitting green light, and reorganized seventh transistors of the two first pixel circuits are placed below the other first light emitting element emitting green light.

In other examples, a reset transistor of at least one first pixel circuit within a circuit island region may be disassembled (or disassembled and reorganized), and the disassembled or reorganized at least one reset transistor may be placed below a first light emitting element emitting red light, or below a first light emitting element emitting blue light, or, a portion of the reset transistor may be placed below the first light emitting element emitting red light, and another portion of the reset transistor may be placed below the first light emitting element emitting blue light.

In other examples, a reset transistor of at least one first pixel circuit within a circuit island region may be disassembled (or disassembled and reorganized), and disassembled or reorganized multiple reset transistors are placed below a same first light emitting element. For example, disassembled or reorganized reset transistors are placed below first light emitting elements emitting green light, and quantities of reset transistors placed below different first light emitting elements emitting green light may be different. For example, reset transistors are placed below both two first light emitting elements emitting green light electrically connected with a same first pixel circuit, and one reset transistor is placed below one first light emitting element, and two or three reset transistors are placed below the other first light emitting element.

In the display substrate provided by the embodiment, first pixel circuits are used for driving first light emitting elements in the first display region at least in one-drive-many mode, so that a quantity of the first pixel circuits in the first display region is less than that of the first light emitting elements, which is beneficial to improving the light transmittance of the first display region. Moreover, by adjusting a position of a reset transistor of a first pixel circuit in the first display region, it may be beneficial for an anode of a first light emitting element to block the first pixel circuit, thereby improving the light transmittance of the first display region.

An embodiment also provides a display substrate, which includes a base substrate, and multiple first pixel circuits and multiple first light emitting elements located in a first display region. At least one first pixel circuit among the multiple first pixel circuits is electrically connected with a first light emitting element, and at least one first pixel circuit is electrically connected with at least two first light emitting elements. The first pixel circuit includes at least one reset transistor; and orthographic projections of at least two first light emitting elements electrically connected with a same first pixel circuit on the base substrate are at least partially overlapped with orthographic projections of reset transistors of the multiple first pixel circuits on the base substrate.

In some exemplary implementation modes, an orthographic projection of an anode of each of the at least two first light emitting elements electrically connected with the same first pixel circuit on the base substrate contains an orthographic projection of an active layer of at least one reset transistor on the base substrate.

In some exemplary implementation modes, the first pixel circuit includes: a first reset transistor and a second reset transistor; an orthographic projection of one of two first light emitting elements electrically connected with the same first pixel circuit on the base substrate is at least partially overlapped with an orthographic projection of the first reset transistor on the base substrate; and an orthographic projection of the other one of the at least two first light emitting elements on the base substrate is at least partially overlapped with an orthographic projection of the second reset transistor on the base substrate.

In some exemplary implementation modes, an orthographic projection of a first light emitting element overlapped with the second reset transistor on the base substrate may not be overlapped with an orthographic projection of a first pixel circuit connected with the first light emitting element on the base substrate.

Relevant description of the display substrate of the embodiment may be referred to description of the aforementioned embodiments, and thus will not be repeated here.

FIG. 46 is a schematic diagram of a display apparatus according to at least one embodiment of the present disclosure. As shown in FIG. 46, an embodiment provides a display apparatus, which includes a display substrate 91 and a sensor 92 located on a light exit side of a light emitting structure layer away from the display substrate 91. The sensor 92 may be located on a side of a non-display surface of the display substrate 91. An orthographic projection of the sensor 92 on the display substrate 91 may be overlapped with a first display region A1.

In some examples, the display substrate 91 may be a flexible OLED display substrate, a QLED display substrate, a Micro-LED display substrate, or a Mini-LED display substrate. The display apparatus may be a product having an image (including a still image or a moving image, wherein the moving image may be a video) display function. For example, the display apparatus may be any product of: displays, televisions, billboards, digital photo frames, laser printers with display functions, telephones, mobile phones, picture screens, Personal Digital Assistants (PDAs), digital cameras, portable camcorders, viewfinders, navigators, vehicles, large-area walls, information inquiry devices (such as business inquiry devices in e-government, banks, hospitals, electric power and other departments), monitors, etc. As another example, the display apparatus may be any product of a micro-display, a Virtual Reality (VR) device or an Augmented Reality (AR) device including a micro-display.

The drawings in the present disclosure only involve structures involved in the present disclosure, and other structures may be referred to conventional designs. The embodiments of the present disclosure, i.e., features in the embodiments, may be combined with each other to obtain new embodiments if there is no conflict. It should be noted that the above embodiments or implementation modes are exemplary only and not restrictive. Therefore, the present disclosure is not limited to what is shown and described in detail herein. Various modifications, substitutions, or omissions may be made to a form and details of implementation without departing from the scope of the present disclosure.

**Claims**

1. A display substrate, comprising

   a base substrate comprising a first display region; and
   a plurality of first pixel circuits and a plurality of first light emitting elements that are located in the first display region; wherein at least one first pixel circuit among the plurality of first pixel circuits is electrically connected with at least two first light emitting elements;
   the at least one first pixel circuit comprises at least one reset transistor; and
   an orthographic projection of at least one first light emitting element among the plurality of first light emitting elements on the base substrate is at least partially overlapped with an orthographic projection of a reset transistor of the at least one first pixel circuit on the base substrate.

2. The display substrate according to claim 1, wherein the plurality of first light emitting elements comprise: a plurality of first light emitting elements emitting light of different colors;
   orthographic projections of a plurality of first light emitting elements emitting light of a same color on the base substrate are at least partially overlapped with orthographic projections of reset transistors of a plurality of first pixel circuits on the base substrate.

3. The display substrate according to claim 1 or 2, wherein an orthographic projection of an anode of the at least one first light emitting element on the base substrate contains an orthographic projection of an active layer of the at least one reset transistor on the base substrate.

4. The display substrate according to claim 2, wherein the at least one first pixel circuit comprises: a first reset transistor and a second reset transistor;
   an orthographic projection of the first reset transistor of the at least one first pixel circuit on the base substrate is at least partially overlapped with an orthographic projection of one first light emitting element on the base substrate, and an orthographic projection of the second reset transistor of the at least one first pixel circuit on the base substrate is at least partially overlapped with an orthographic projection of another first light emitting element emitting light of a same color on the base substrate.

5. The display substrate according to claim 4, wherein an orthographic projection of a first light emitting element overlapped with the second reset transistor on the base substrate is not overlapped with an orthographic projection of a first pixel circuit connected with the first light emitting element on the base substrate.

6. The display substrate according to any one of claims 1 to 5, wherein the plurality of first light emitting elements are divided into a plurality of light emitting units, each of which comprises: a first light emitting element emitting light of a first color, a first light emitting element emitting light of a second color, and two first light emitting elements emitting light of a third color;
   the first light emitting element emitting light of the first color is electrically connected with a first pixel circuit; the first light emitting element emitting light of the second color is electrically connected with a first pixel circuit; and the two first light emitting elements emitting light of the third color are electrically connected with a same first pixel circuit.

7. The display substrate according to claim 6, wherein the first light emitting element emitting light of the first color and the first light emitting element emitting light of the second color in the light emitting unit are arranged in a same row, the two first light emitting elements emitting light of the third color are arranged in a same row, and four first light emitting elements in the light emitting unit are arranged in different columns; and
the light of the first color is red light, the light of the second color is blue light, and the light of the third color is green light.

8. The display substrate according to claim 6 or 7, wherein the first display region comprises: a plurality of circuit island regions spaced apart from each other and arranged in an array, each circuit island region comprises: three first pixel circuits disposed in sequence along a first direction; two adjacent rows of circuit island regions are dislocated; and three first pixel circuits of the circuit island region are electrically connected with four first light emitting elements in a light emitting unit.

9. The display substrate according to claim 8, wherein any two adjacent first pixel circuits in the circuit island region are symmetrically disposed with respect to a centerline of the two adjacent first pixel circuits along the first direction.

10. The display substrate according to claim 8, wherein a data line connected with a first pixel circuit connected with a first light emitting element emitting light of the third color is configured to provide data signals to a plurality of first pixel circuits disposed every other row.

11. The display substrate according to claim 8, wherein the first pixel circuit connected with the two first light emitting elements emitting light of the third color in the light emitting unit is located between the first pixel circuit connected with the first light emitting element emitting light of the first color and the first pixel circuit connected with the first light emitting element emitting light of the second color.

12. The display substrate according to claim 8, wherein each first pixel circuit of the circuit island region comprises: a drive transistor, a first reset transistor, a second reset transistor, and a third reset transistor, wherein the first reset transistor is configured to reset a second electrode of the drive transistor, the second reset transistor is configured to reset an anode of a first light emitting element connected with the first pixel circuit, and the third reset transistor is configured to reset a first electrode of the drive transistor;
active layers of first reset transistors of three first pixel circuits of the circuit island region are of an interconnected integrated structure, active layers of second reset transistors of the three first pixel circuits are of an interconnected integrated structure, and active layers of third reset transistors of the three first pixel circuits are of an interconnected integrated structure.

13. The display substrate according to claim 12, wherein orthographic projections of the integrated structure of the active layers of the first reset transistors of the three first pixel circuits, the integrated structure of the active layers of the second reset transistors of the three first pixel circuits, and the integrated structure of the active layers of the third reset transistors of the three first pixel circuits of the circuit island region on the base substrate are at least partially overlapped with orthographic projections of different first light emitting elements emitting light of the third color on the base substrate.

14. The display substrate according to claim 12, wherein orthographic projections of an integrated structure of active layers of three second reset transistors of one circuit island region and an integrated structure of active layers of three first reset transistors of an adjacent circuit island region in a second direction on the base substrate are at least partially overlapped with an orthographic projection of a same first light emitting element emitting light of the third color on the base substrate; the first light emitting element emitting light of the third color is connected with a first pixel circuit of the circuit island region and orthographic projections of the first light emitting element emitting light of the third color and a transistor of the first pixel circuit other than the second reset transistor on the base substrate are not overlapped; the second direction intersects with the first direction.

15. The display substrate according to claim 8, wherein each first pixel circuit of the circuit island region at least comprises: a drive transistor, a first reset transistor, and a second reset transistor, wherein the first reset transistor is configured to reset a second electrode of the drive transistor, and the second reset transistor is configured to reset an anode of a first light emitting element connected with the first pixel circuit;

an active layer of a first reset transistor and an active layer of a second reset transistor of a third first pixel circuit along the first direction within the circuit island region are aligned in a second direction, wherein the second direction intersects with the first direction;
an orthographic projection of the active layer of the first reset transistor of the third first pixel circuit on the base substrate is at least partially overlapped with an orthographic projection of one first light emitting element emitting light of the third color on the base substrate, and an orthographic projection of the active layer of the second reset transistor of the third first pixel circuit on the base substrate is at least partially overlapped with an orthographic projection of the other first light emitting element emitting light of the third color on the base substrate.

16. The display substrate according to claim 15, wherein an orthographic projection of an anode of the one first light emitting element emitting light of the third color on the base substrate contains the orthographic projection of the active layer of the first reset transistor of the third first pixel circuit on the base substrate, and an orthographic projection of an anode of the other first light emitting element emitting light of the third color on the base substrate contains the orthographic projection of the active layer of the second reset transistor of the third first pixel circuit on the base substrate.

17. The display substrate according to any one of claims 1 to 16, wherein in a direction perpendicular to the display substrate, the display substrate comprises: a first semiconductor layer, a first conductive layer, a second conductive layer, a second semiconductor layer, a third conductive layer, a fourth conductive layer, a fifth conductive layer, and a sixth conductive layer disposed on the base substrate;
the sixth conductive layer at least comprises a plurality of auxiliary electrodes; and orthographic projections of the auxiliary electrodes on the base substrate contain an orthographic projection of a light emitting region of the first light emitting element on the base substrate.

18. The display substrate according to claim 17, wherein the plurality of auxiliary electrodes are connected through a plurality of auxiliary connection strips to form a mesh structure, and the mesh structure is connected with a first voltage signal.

19. A display apparatus, comprising: a display substrate according to any one of claims 1 to 18, and a sensor located on a non-display side of the display substrate, and an orthographic projection of the sensor on the display substrate is at least partially overlapped with a first display region of the display substrate.

20. A display substrate, comprising:

   a base substrate comprising a first display region;
   a plurality of first pixel circuits and a plurality of first light emitting elements that are located in the first display region;
   at least one first pixel circuit among the plurality of first pixel circuits is electrically connected with a first light emitting element, and at least one first pixel circuit is electrically connected with at least two first light emitting elements;
   the first pixel circuit comprises at least one reset transistor; and
   orthographic projections of at least two first light emitting elements electrically connected with a same first pixel circuit on the base substrate are at least partially overlapped with orthographic projections of reset transistors of the plurality of first pixel circuits on the base substrate.

21. The display substrate according to claim 20, wherein an orthographic projection of an anode of each of the at least two first light emitting elements electrically connected with the same first pixel circuit on the base substrate contains an orthographic projection of an active layer of at least one reset transistor on the base substrate.

22. The display substrate according to claim 20, wherein the first pixel circuit comprises: a first reset transistor and a second reset transistor;
an orthographic projection of one of two first light emitting elements electrically connected with a same first pixel circuit on the base substrate is at least partially overlapped with an orthographic projection of the first reset transistor on the base substrate; and an orthographic projection of the other one of the at least two first light emitting elements on the base substrate is at least partially overlapped with an orthographic projection of the second reset transistor on the base substrate.

23. The display substrate according to claim 22, wherein an orthographic projection of a first light emitting element overlapped with the second reset transistor on the base substrate is not overlapped with an orthographic projection of a first pixel circuit connected with the first light emitting element on the base substrate.

FIG. 1

FIG. 2

FIG. 3

FIG. 4A

FIG. 4B

FIG. 5

FIG. 6

FIG. 7A

FIG. 7B

FIG. 8A

FIG. 8B

FIG. 8C

FIG. 9A

FIG. 9B

FIG. 9C

FIG. 10A

FIG. 10B

FIG. 11A

FIG. 11B

FIG. 11C

FIG. 12

FIG. 13A

FIG. 13B

FIG. 13C

FIG. 14

FIG. 15A

FIG. 15B

FIG. 15C

FIG. 16

FIG. 17A

FIG. 17B

FIG. 18

FIG. 19A

FIG. 19B

FIG. 20

FIG. 21

FIG. 22A

FIG. 22B

FIG. 23A

FIG. 23B

RST1(i) GL1(i)

GL2b(i)

392b

392a

392c

EML(i)

393

RST2(i)
RST1(i+1)

GL1(i+1)

GL2b(i+1)

EML(i+1)

393

RST2(i+1)

**FIG. 24A**

O1          O2

11a          11b          11c

392b

GL2b(i)

392a

392c

393

**FIG. 24B**

FIG. 25A

FIG. 25B

INIT1(i)

GL2(i)

INIT3(i)

INIT2(i)

INIT1(i+1)

GL2(i+1)

INIT3(i+1)

INIT2(i+1)

Y
X

FIG. 26A

O1    O2

11a    11b    11c

INIT1(i)

32a    32b

GL2(i)

32c

INIT3(i)

INIT2(i)

Y
X

FIG. 26B

FIG. 27

FIG. 28A

FIG. 28B

FIG. 28C

FIG. 29

FIG. 30

FIG. 31

FIG. 32

FIG. 33

FIG. 34A

FIG. 34B

FIG. 35A

FIG. 35B

FIG. 36A

FIG. 36B

FIG. 37A

FIG. 37B

FIG. 38A

FIG. 38B

FIG. 39

FIG. 40A

FIG. 40B

FIG. 40C

FIG. 41

FIG. 42A

FIG. 42B

FIG. 42C

FIG. 43

FIG. 44A

FIG. 44B

132b
131b
132d
131d
131a
131c
131a
131b
131a
132a
132c
131d
131c
131a
131a
131b

Y

X

FIG. 45

A2
A1

91

92

FIG. 46

## INTERNATIONAL SEARCH REPORT

| International application No. |
|---|
| **PCT/CN2023/113177** |

### A. CLASSIFICATION OF SUBJECT MATTER

H10K59/121(2023.01)i

According to International Patent Classification (IPC) or to both national classification and IPC

### B. FIELDS SEARCHED

Minimum documentation searched (classification system followed by classification symbols)

IPC:H10K

Documentation searched other than minimum documentation to the extent that such documents are included in the fields searched

Electronic data base consulted during the international search (name of data base and, where practicable, search terms used)

CNTXT, DWPI, 中国期刊网全文数据库, CJFD: 显示, 像素, 复位, 晶体管, 交叠, 重叠, display, pixel, reset, TFT, transistor, overlap

### C. DOCUMENTS CONSIDERED TO BE RELEVANT

| Category* | Citation of document, with indication, where appropriate, of the relevant passages | Relevant to claim No. |
|---|---|---|
| X | CN 113763874 A (BOE TECHNOLOGY GROUP CO., LTD.) 07 December 2021 (2021-12-07) description, paragraphs [0051]-[0160], and figures 1-19 | 1-23 |
| X | CN 116508414 A (BOE TECHNOLOGY GROUP CO., LTD. et al.) 28 July 2023 (2023-07-28) description, paragraphs [0076]-[0238], and figures 1-15 | 1-19 |
| X | WO 2023092351 A1 (BOE TECHNOLOGY GROUP CO., LTD. et al.) 01 June 2023 (2023-06-01) description, pages 12-44, and figures 1-15 | 1-19 |
| A | CN 113327543 A (BOE TECHNOLOGY GROUP CO., LTD. et al.) 31 August 2021 (2021-08-31) entire document | 1-23 |
| A | CN 113437126 A (WUHAN TIANMA MICROELECTRONICS CO., LTD.) 24 September 2021 (2021-09-24) entire document | 1-23 |

☐ Further documents are listed in the continuation of Box C.    ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **18 December 2023** | **22 December 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
| --- |
| **PCT/CN2023/113177** |

| Patent document cited in search report | | | Publication date (day/month/year) | Patent family member(s) | Publication date (day/month/year) |
| --- | --- | --- | --- | --- | --- |
| CN | 113763874 | A | 07 December 2021 | None | |
| CN | 116508414 | A | 28 July 2023 | None | |
| WO | 2023092351 | A1 | 01 June 2023 | None | |
| CN | 113327543 | A | 31 August 2021 | None | |
| CN | 113437126 | A | 24 September 2021 | None | |

Form PCT/ISA/210 (patent family annex) (July 2022)